(19) Europäisches Patentamt
European Patent Office
Office européen des brevets

(11) **EP 4 474 841 A1**

(12) **EUROPEAN PATENT APPLICATION**
published in accordance with Art. 153(4) EPC

(43) Date of publication:
**11.12.2024 Bulletin 2024/50**

(51) International Patent Classification (IPC):
*G01R 31/392* (2019.01)       *G01R 31/379* (2019.01)
*H01M 10/48* (2006.01)        *H02J 7/00* (2006.01)

(21) Application number: **23749619.5**

(22) Date of filing: **25.01.2023**

(52) Cooperative Patent Classification (CPC):
**G01R 31/379; G01R 31/392; H01M 10/48; H02J 7/00;** Y02E 60/10

(86) International application number:
**PCT/JP2023/002259**

(87) International publication number:
**WO 2023/149303 (10.08.2023 Gazette 2023/32)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **03.02.2022 JP 2022015640**

(71) Applicants:
• **FURUKAWA ELECTRIC CO., LTD.**
**Tokyo 100-8322 (JP)**
• **The Furukawa Battery Co., Ltd.**
**Yokohama-shi, Kanagawa-ken 240-0006 (JP)**

(72) Inventors:
• **KUTSUMA Ayaka**
**Tokyo 100-8322 (JP)**
• **NAKAMURA Hideto**
**Tokyo 100-8322 (JP)**
• **TANIMURA Yudai**
**Tokyo 100-8322 (JP)**
• **SATO Toshiyuki**
**Yokohama-shi, Kanagawa 240-0006 (JP)**
• **YOSHIDA Hideaki**
**Nikko-shi, Tochigi 321-2336 (JP)**

(74) Representative: **Grünecker Patent- und Rechtsanwälte PartG mbB Leopoldstraße 4 80802 München (DE)**

(54) **LEAD-ACID STORAGE BATTERY SYSTEM, AND LEAD-ACID STORAGE BATTERY LIFE ESTIMATION METHOD**

(57)    Provided are a lead-acid battery system and a lead-acid battery life estimation method capable of accurately estimating a remaining life of a lead-acid battery by calculating a capacity turnover value during operation (CT value during operation) in consideration of at least one of an upper limit state of charge (SOC) or an upper limit voltage. A capacity turnover value calculation unit (138), (237), or (337) of the lead-acid battery system (S) calculates the CT value during operation by using at least one of an upper-limit-SOC-based correction coefficient $K_{HSOC}$ calculated based on the upper limit SOC which is an SOC having the largest value when the lead-acid battery (B) is charged, and an upper-limit-voltage-based correction coefficient $K_{HV}$ calculated based on the upper limit voltage which is the highest voltage when the lead-acid battery (B) is charged.

FIG. 5

EP 4 474 841 A1

## Description

Technical Field

The present invention relates to a lead-acid battery system and a lead-acid battery life estimation method for estimating a remaining life of a lead-acid battery.

Background Art

In recent years, power generation facilities using natural energy such as sunlight and wind power have increased. In such a power generation facility, the amount of power generated cannot be controlled, and thus a storage battery is used to level the power load. That is, when the amount of power generation is larger than the amount of consumption, the difference is charged into storage batteries, and when the amount of power generation is smaller than the amount of consumption, the difference is discharged from the storage batteries.

Examples of such storage batteries include lead-acid batteries and lithium-ion secondary batteries. These storage batteries for power storage are installed in houses, offices, and sites of factories, electric power companies, and the like. The storage batteries are assumed to be used in units of several years to 10 years from the start of operation.

When long-term use is assumed as described above, it is necessary to periodically perform maintenance and management (maintenance) after the start of operation. This is because in a case of various storage batteries as described above, it is known that deterioration progresses with use and available battery capacity decreases. These storage batteries are not replaced immediately when their capacity is depleted after a single discharge unlike primary batteries, but are repeatedly used. Thus, it is required to appropriately grasp the state of installed storage batteries.

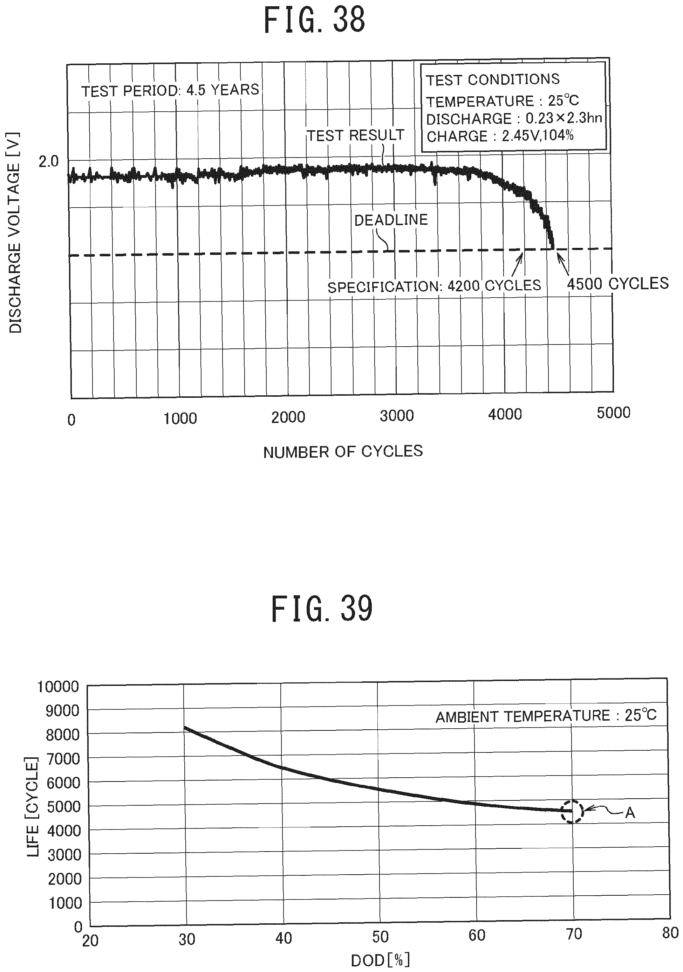

Here, an example of a cycle characteristic of a general lead-acid battery will be described. As illustrated in FIG. 38, a decrease in capacity of the lead-acid battery due to deterioration occurs, for example, from around 3900 cycles with respect to 4500 cycles of life, and there is a possibility that a characteristic change is not observed until the end of the life of the lead-acid battery.

A main factor of the decrease in capacity of the lead-acid battery is a decrease in adhesion between a positive electrode grid and an active material. From the viewpoint of energy density, in a bipolar lead-acid battery that has attracted attention in recent years, there is a possibility that a further rapid decrease in capacity may occur toward the end of life.

In view of the possibility that a characteristic change (capacity decrease) is not observed until the end of the life of the lead-acid battery as described above, it has been hitherto performed to estimate the life of the lead-acid battery from a capacity turnover value (CT value), which is an index related to the number of discharges.

Here, the capacity turnover value is a value obtained by dividing the total discharge capacity by a rated capacity of the storage battery, and is used as a life index of the storage battery. In a cycle charge/discharge lead-acid battery, the number of discharges (cycle life) from the beginning to the end of life is obtained under certain conditions, and the capacity turnover value from the beginning to the end of life can be calculated. FIG. 39 illustrates an example of a relationship between a DOD representing a depth of discharge and the life of the storage battery. In a case where a lead-acid battery having a rated capacity of 1000 Ah as indicated by an arrow A is dischargeable for 4500 cycles with a DOD of 70%, the capacity turnover value from the beginning to the end of life is total discharge capacity (1000 Ah $\times$ 70% $\times$ 4500 cycles)/rated capacity (1000 Ah) = 3150 (times).

Therefore, the remaining life of the lead-acid battery can be estimated by comparing the capacity turnover value from the beginning to the end of life with the capacity turnover value during operation.

On the other hand, as a conventional lead-acid battery life prediction method, for example, a method described in PTL 1 is known.

The lead-acid battery life prediction method described in PTL 1 integrates a charged electricity amount from a charge current value of a lead-acid battery, and predicts a life of the lead-acid battery from the integrated value. In the lead-acid battery life prediction method described in PTL 1, a relationship between a charging battery voltage and a battery temperature and a charging current is measured in advance using a standard lead-acid battery, a charging battery voltage and a battery temperature of a target lead-acid battery are detected, and a charge current value is determined based on the detected values and the above-described relationship.

Citation List

Patent Literature

PTL 1: JP H2-288074 A

Summary of Invention

Technical Problem

However, in the conventional lead-acid battery life prediction method described in PTL 1, in prediction of a life of a lead-acid battery, a charged electricity amount is integrated from a charge current value of the lead-acid battery, and the life of the lead-acid battery is predicted from the integrated value, and a remaining life of the lead-acid battery is not estimated by comparing the above-described capacity turnover value from the beginning to the end of life and the capacity turnover value during operation. Therefore, it is difficult to accurately estimate the remaining life of the lead-acid battery.

Meanwhile, at the time of charging the lead-acid battery, a voltage rapidly increases in a high state-of-charge (SOC) region (for example, the SOC is 97% or more), and corrosion of a positive electrode and softening of an active material due to electrolyte loss proceed. Therefore, in order to calculate the capacity turnover value during operation, in a case where the SOC of the lead-acid battery is in the high SOC region, it is desirable to consider the SOC, particularly an upper limit SOC (an SOC having the largest value when the lead-acid battery is charged). Here, the SOC means the state of charge, and is obtained by dividing the sum of the rated capacity of the lead-acid battery and the total charge amount and the total discharge amount from completion of an equalization charge to a corresponding time point by the rated capacity, assuming that the SOC when the equalization charge is completed is 100%. The SOC can be expressed by the following Formula (1).

[Mathematical Formula 1]

$$SOC = \frac{(\text{Rated capacity} + \text{Total charge amount} + \text{Total discharge amount})}{\text{Rated capacity}} \times 100 \qquad \cdots (1)$$

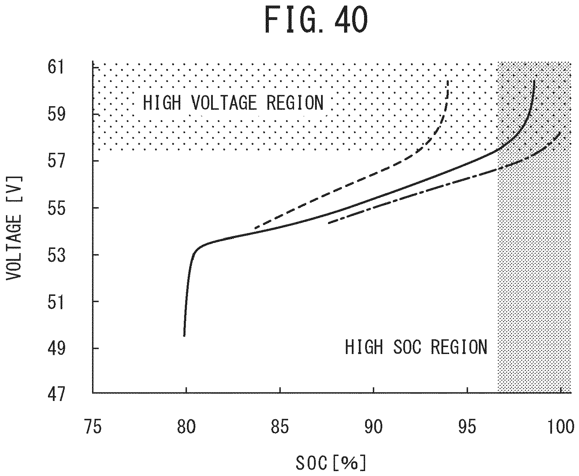

In addition, in some states of the lead-acid battery, a rapid increase in voltage may occur at the time of charging the lead-acid battery even outside the high SOC region (a broken line in FIG. 40), and when the rapid increase in voltage occurs, the corrosion of the positive electrode and the softening of the active material progress. On the other hand, an increase in voltage may not occur even in the high SOC region (a line with alternating long and short dashes in FIG. 40). Therefore, in order to calculate the capacity turnover value during operation, it is desirable to consider a magnitude of the voltage when the lead-acid battery is charged, particularly, an upper limit voltage (the highest voltage when the lead-acid battery is charged).

Therefore, an object of the present invention is to provide a lead-acid battery system and a lead-acid battery life estimation method capable of accurately estimating a remaining life of a lead-acid battery by calculating a capacity turnover value during operation in consideration of at least one of an upper limit SOC or an upper limit voltage.

Solution to Problem

A lead-acid battery system according to an aspect of the present invention is a lead-acid battery system configured to estimate a remaining life of a lead-acid battery by comparing a capacity turnover value from a beginning to an end of life with a capacity turnover value during operation, the lead-acid battery system including: a capacity turnover value calculation unit configured to calculate the capacity turnover value during operation, in which the capacity turnover value calculation unit calculates the capacity turnover value during operation by using at least one of an upper-limit-state-of-charge (SOC)-based correction coefficient calculated based on an upper limit SOC calculated by an upper limit SOC calculation unit configured to calculate the upper limit SOC which is an SOC having a largest value when the lead-acid battery is charged, or an upper-limit-voltage-based correction coefficient calculated based on an upper limit voltage calculated by an upper limit voltage calculation unit configured to calculate the upper limit voltage which is a highest voltage when the lead-acid battery is charged.

A lead-acid battery life estimation method according to another aspect of the present invention is a lead-acid battery life estimation method in which a remaining life of a lead-acid battery is estimated by comparing a capacity turnover value from a beginning to an end of life with a capacity turnover value during operation, the lead-acid battery life estimation method including: a capacity turnover value calculation step of calculating the capacity turnover value during operation, in which in the capacity turnover value calculation step, the capacity turnover value during operation is calculated by using at least one of an upper-limit-state-of-charge (SOC)-based correction coefficient calculated based on an upper limit SOC calculated in an upper limit SOC calculation step of calculating the upper limit SOC which is an SOC having a largest value when the lead-acid battery is charged, or an upper-limit-voltage-based correction coefficient calculated based on an upper limit voltage calculated in an upper limit voltage calculation step of calculating the upper limit voltage which is a highest voltage when the lead-acid battery is charged.

Advantageous Effects of Invention

In the lead-acid battery system according to the present invention, the capacity turnover value calculation unit calculates the capacity turnover value during operation by using at least one of the upper-limit-SOC-based correction coefficient calculated based on the upper limit SOC calculated by the upper limit SOC calculation unit configured to calculate the upper limit SOC which is the SOC having the largest value when the lead-acid battery is charged or the upper-limit-voltage-based correction coefficient based on the upper limit voltage calculated by the upper limit voltage calculation unit configured to calculate the upper limit voltage which is the highest voltage when the lead-acid battery is charged. As a result, the capacity turnover value during operation can be calculated in consideration of at least one of the upper limit SOC or the upper limit voltage, the progress of corrosion of a positive electrode and softening of an active material due to electrolyte loss can be considered, and the lead-acid battery system capable of accurately estimating the remaining life of the lead-acid battery can be provided.

In the lead-acid battery system according to the present invention, the upper limit SOC calculation unit calculates the SOC at the start of the discharge of the lead-acid battery to be subjected to calculation of the capacity turnover value during operation as the upper limit SOC, and the capacity turnover value calculation unit calculates the upper-limit-SOC-based correction coefficient based on the upper limit SOC calculated by the upper limit SOC calculation unit. As a result, the upper limit SOC can be determined and calculated at the start of the discharge of the lead-acid battery to be subjected to calculation of the capacity turnover value during operation, and the upper-limit-SOC-based correction coefficient can be appropriately calculated based on the calculated upper limit SOC.

In the lead-acid battery system according to the present invention, the upper limit SOC calculation unit calculates, as the upper limit SOC, an SOC at an end of a next charge after an end of a discharge of the lead-acid battery to be subjected to calculation of the capacity turnover value during operation, and the capacity turnover value calculation unit calculates the upper-limit-SOC-based correction coefficient based on the upper limit SOC calculated by the upper limit SOC calculation unit. As a result, the upper limit SOC can be determined and calculated at the end of the next charge after the end of the discharge of the lead-acid battery to be subjected to calculation of the capacity turnover value during operation, and the upper-limit-SOC-based correction coefficient can be appropriately calculated based on the calculated upper limit SOC.

In the lead-acid battery system according to the present invention, the upper limit voltage calculation unit calculates, as the upper limit voltage, a peak voltage at an end of a charge immediately before a discharge of the lead-acid battery to be subjected to calculation of the capacity turnover value during operation, and the capacity turnover value calculation unit calculates the upper-limit-voltage-based correction coefficient based on the upper limit voltage calculated by the upper limit voltage calculation unit. As a result, the upper limit voltage can be calculated by calculating the peak voltage at the end of the charge immediately before the discharge of the lead-acid battery to be subjected to calculation of the capacity turnover value during operation, and the upper-limit-voltage-based correction coefficient can be appropriately calculated based on the calculated upper limit voltage.

In the lead-acid battery system according to the present invention, the upper limit voltage calculation unit calculates, as the upper limit voltage, a peak voltage at an end of a next charge after an end of a discharge of the lead-acid battery to be subjected to calculation of the capacity turnover value during operation, and the capacity turnover value calculation unit calculates the upper-limit-voltage-based correction coefficient based on the upper limit voltage calculated by the upper limit voltage calculation unit. As a result, the upper limit voltage can be calculated by calculating the peak voltage at the end of the next charge after the end of the discharge of the lead-acid battery to be subjected to calculation of the capacity turnover value during operation, and the upper-limit-voltage-based correction coefficient can be appropriately calculated based on the calculated upper limit voltage.

In the lead-acid battery system of the present invention, the lead-acid battery is a bipolar lead-acid battery. Accordingly, it is possible to provide the lead-acid battery system capable of accurately estimating the remaining life of the bipolar lead-acid battery.

In the lead-acid battery life estimation method according to the present invention, in the capacity turnover value calculation step, the capacity turnover value during operation is calculated by using at least one of the upper-limit-SOC-based correction coefficient calculated based on the upper limit SOC calculated in the upper limit SOC calculation step of calculating the upper limit SOC which is the SOC having the largest value when the lead-acid battery is charged or the upper-limit-voltage-based correction coefficient based on the upper limit voltage calculated in the upper limit voltage calculation step of calculating the upper limit voltage which is the highest voltage when the lead-acid battery is charged. As a result, the capacity turnover value during operation can be calculated in consideration of at least one of the upper limit SOC or the upper limit voltage, the progress of corrosion of a positive electrode and softening of an active material due to electrolyte loss can be considered, and the lead-acid battery life estimation method capable of accurately estimating the remaining life of the lead-acid battery can be provided.

In the lead-acid battery lift estimation method according to the present invention, in the upper limit SOC calculation step, the SOC at the start of the discharge of the lead-acid battery to be subjected to calculation of the capacity turnover value during operation is calculated as the upper limit SOC, and in the capacity turnover value calculation step, the upper-limit-SOC-based correction coefficient is calculated based on the upper limit SOC calculated in the upper limit SOC calculation step. As a result, the upper limit SOC can be determined and calculated at the start of the discharge of the lead-acid battery to be subjected to calculation of the capacity turnover value during operation, and the upper-limit-SOC-based correction coefficient can be appropriately calculated based on the calculated upper limit SOC.

In the lead-acid battery life estimation method according to the present invention, in the upper limit SOC calculation step, an SOC at an end of a next charge after an end of a discharge of the lead-acid battery to be subjected to calculation of the capacity turnover value during operation is calculated as the upper limit SOC, and in the capacity turnover value calculation step, the upper-limit-SOC-based correction coefficient is calculated based on the upper limit SOC calculated by the upper limit SOC calculation unit. As a result, the upper limit SOC can be determined and calculated at the end of the next charge after the end of the discharge of the lead-acid battery to be subjected to calculation of the capacity turnover value during operation, and the upper-limit-SOC-based correction coefficient can be appropriately calculated based on the calculated upper limit SOC.

In the lead-acid battery life estimation method according to the present invention, in the upper limit voltage calculation step, a peak voltage at an end of a charge immediately before a discharge of the lead-acid battery to be subjected to calculation of the capacity turnover value during operation is calculated as the upper limit voltage, and in the capacity turnover value calculation step, the upper-limit-voltage-based correction coefficient is calculated based on the upper limit voltage calculated in the upper limit voltage calculation step. As a result, the upper limit voltage can be calculated by calculating the peak voltage at the end of the charge immediately before the discharge of the lead-acid battery to be subjected to calculation of the capacity turnover value during operation, and the upper-limit-voltage-based correction coefficient can be appropriately calculated based on the calculated upper limit voltage.

In the lead-acid battery life estimation method according to the present invention, in the upper limit voltage calculation step, a peak voltage at an end of a next charge after an end of a discharge of the lead-acid battery to be subjected to calculation of the capacity turnover value during operation is calculated as the upper limit voltage, and in the capacity turnover value calculation step, the upper-limit-voltage-based correction coefficient is calculated based on the upper limit voltage calculated in the upper limit voltage calculation step. As a result, the upper limit voltage can be calculated by calculating the peak voltage at the end of the next charge after the end of the discharge of the lead-acid battery to be subjected to calculation of the capacity turnover value during operation, and the upper-limit-voltage-based correction coefficient can be appropriately calculated based on the calculated upper limit voltage.

In the lead-acid battery life estimation method of the present invention, the lead-acid battery is a bipolar lead-acid battery. Accordingly, it is possible to provide the lead-acid battery life estimation method capable of accurately estimating the remaining life of the bipolar lead-acid battery.

Brief Description of Drawings

FIG. 1 is a block diagram illustrating an overall configuration of lead-acid battery systems according to first to sixth embodiments of the present invention;

FIG. 2 is a block diagram illustrating an internal configuration of battery management units (BMUs) included in the lead-acid battery systems according to the first to sixth embodiments of the present invention illustrated in FIG. 1;

FIG. 3 is a diagram for describing start and end timings of processing in a state determination unit and calculation of a state of charge (SOC) at the start of a discharge of a lead-acid battery to be subjected to calculation of a capacity turnover value during operation as an upper limit SOC in the lead-acid battery systems according to the first to third embodiments of the present invention;

FIG. 4 is a diagram for describing start and end timings of processing in the state determination unit and calculation of a peak voltage at the end of a charge immediately before the discharge of the lead-acid battery to be subjected to calculation of the capacity turnover value during operation as an upper limit voltage in the lead-acid battery systems according to the first to third embodiments of the present invention;

FIG. 5 is a block diagram illustrating internal configurations of a recording unit and the state determination unit included in the BMU illustrated in FIG. 2 in the lead-acid battery system according to the first embodiment of the present invention;

FIG. 6 is a graph illustrating a relationship between a voltage during the charge and an elapsed time from the end of current application for describing a peak voltage during the charge;

FIG. 7 is a block diagram illustrating an internal configuration of a capacity turnover value calculation unit included in the state determination unit illustrated in FIG. 5;

FIG. 8 is a flowchart illustrating a flow of processing in the state determination unit illustrated in FIG. 4;

FIG. 9 is a flowchart illustrating a flow of processing of step S9 (capacity turnover value calculation step) in the flowchart illustrated in FIG. 8;

FIG. 10 is a graph illustrating a relationship between the upper limit SOC and an upper-limit-SOC-based correction coefficient;

FIG. 11 is a graph illustrating a relationship between the upper limit voltage and an upper-limit-voltage-based correction coefficient;

FIG. 12 is a block diagram illustrating internal configurations of a recording unit and the state determination unit included in the BMU illustrated in FIG. 2 in the lead-acid battery system according to the second embodiment of the present invention;

FIG. 13 is a block diagram illustrating an internal configuration of a capacity turnover value calculation unit included in the state determination unit illustrated in FIG. 12;

FIG. 14 is a flowchart illustrating a flow of processing in the state determination unit illustrated in FIG. 12;

FIG. 15 is a flowchart illustrating a flow of processing of step S108 (capacity turnover value calculation step) in the flowchart illustrated in FIG. 14;

FIG. 16 is a block diagram illustrating internal configurations of a recording unit and the state determination unit included in the BMU illustrated in FIG. 2 in the lead-acid battery system according to the third embodiment of the present invention;

FIG. 17 is a block diagram illustrating an internal configuration of a capacity turnover value calculation unit included in the state determination unit illustrated in FIG. 16;

FIG. 18 is a flowchart illustrating a flow of processing in the state determination unit illustrated in FIG. 16;

FIG. 19 is a flowchart illustrating a flow of processing of step S208 (capacity turnover value calculation step) in the flowchart illustrated in FIG. 18;

FIG. 20 is a diagram for describing start and end timings of processing in a state determination unit and calculation of an SOC at the end of the next charge after the end of a discharge of a lead-acid battery to be subjected to calculation of a capacity turnover value during operation as an upper limit SOC in the lead-acid battery systems according to the fourth to sixth embodiments of the present invention;

FIG. 21 is a diagram for describing start and end timings of processing in the state determination unit and calculation of a peak voltage at the end of the next charge after the end of the discharge of the lead-acid battery to be subjected to calculation of the capacity turnover value during operation as an upper limit voltage in the lead-acid battery systems according to the fourth to sixth embodiments of the present invention;

FIG. 22 is a block diagram illustrating internal configurations of a recording unit and the state determination unit included in the BMU illustrated in FIG. 2 in the lead-acid battery system according to the fourth embodiment of the present invention;

FIG. 23 is a block diagram illustrating an internal configuration of a capacity turnover value calculation unit included in the state determination unit illustrated in FIG. 22;

FIG. 24 is a flowchart illustrating a flow of processing in the state determination unit illustrated in FIG. 22;

FIG. 25 is a flowchart illustrating a flow of processing of step S413 (capacity turnover value calculation step) in the flowchart illustrated in FIG. 24;

FIG. 26 is a block diagram illustrating internal configurations of a recording unit and the state determination unit included in the BMU illustrated in FIG. 2 in the lead-acid battery system according to the fifth embodiment of the present invention;

FIG. 27 is a block diagram illustrating an internal configuration of a capacity turnover value calculation unit included in the state determination unit illustrated in FIG. 26;

FIG. 28 is a flowchart illustrating a flow of processing in the state determination unit illustrated in FIG. 26;

FIG. 29 is a flowchart illustrating a flow of processing of step S512 (capacity turnover value calculation step) in the flowchart illustrated in FIG. 28;

FIG. 30 is a block diagram illustrating internal configurations of a recording unit and the state determination unit included in the BMU illustrated in FIG. 2 in the lead-acid battery system according to the sixth embodiment of the present invention;

FIG. 31 is a block diagram illustrating an internal configuration of a capacity turnover value calculation unit included in the state determination unit illustrated in FIG. 30;

FIG. 32 is a flowchart illustrating a flow of processing in the state determination unit illustrated in FIG. 30;

FIG. 33 is a flowchart illustrating a flow of processing of step S612 (capacity turnover value calculation step) in the flowchart illustrated in FIG. 32;

FIG. 34 is a diagram for describing another calculation method in a case of calculating an SOC at the start of the discharge of the lead-acid battery to be subjected to calculation of the capacity turnover value during operation as the upper limit SOC;

FIG. 35 is a diagram for describing still another calculation method in a case of calculating the SOC at the start of the discharge of the lead-acid battery to be subjected to calculation of the capacity turnover value during operation as the upper limit SOC;

FIG. 36 is a diagram for describing another calculation method in a case of calculating the SOC at the end of the next charge after the end of the discharge of the lead-acid battery to be subjected to calculation of the capacity turnover value during operation as the upper limit SOC;

FIG. 37 is a diagram for describing still another calculation method in a case of calculating the SOC at the end of the next charge after the end of the discharge of the lead-acid battery to be subjected to calculation of the capacity turnover value during operation as the upper limit SOC;

FIG. 38 is a graph for describing an example of a cycle characteristic of a general lead-acid battery;

FIG. 39 is a graph illustrating an example of a relationship between a DOD representing a depth of discharge and a life of a storage battery; and

FIG. 40 is a graph illustrating an example of a charge curve at the time of a constant voltage charging test.

Description of Embodiments

Hereinafter, an embodiment of the present invention will be described in detail with reference to the drawings. Note that the embodiment described below illustrates an example of the present invention. In addition, various changes or improvements can be added to the present embodiment, and a mode to which such changes or improvements are added can also be included in the present invention. The embodiment and modifications thereof are included in the scope and gist of the invention, and are included in the scope of the invention described in the claims and its equivalents.

(First Embodiment)

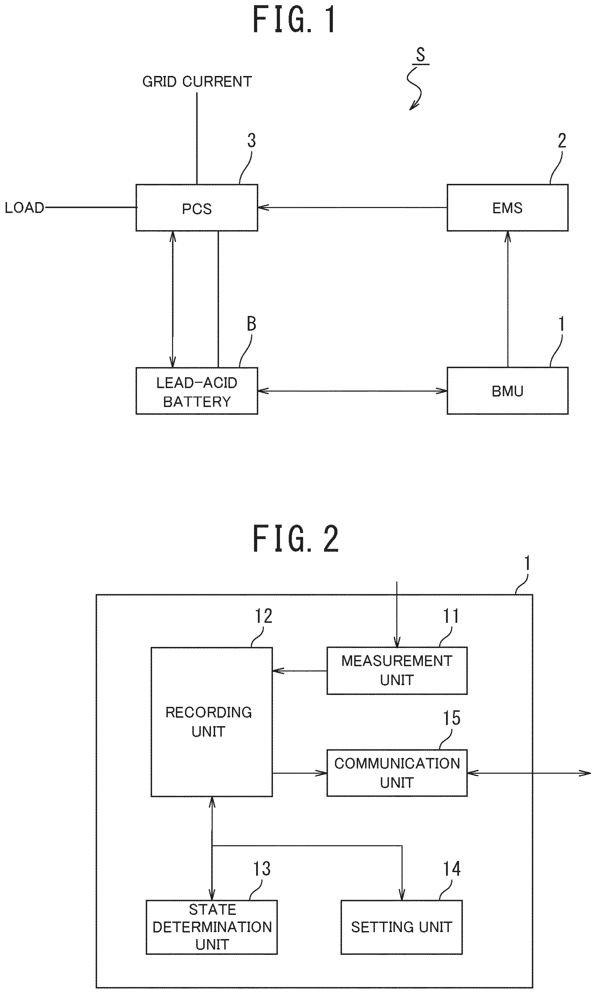

FIG. 1 illustrates an overall configuration of lead-acid battery systems according to the first embodiment of the present invention and the second to sixth embodiments described below.

A lead-acid battery system S illustrated in FIG. 1 is a system that stores, in a lead-acid battery B, a grid current generated by various power plants such as thermal power plants or from renewable energy such as wind power generation and transmitted, and transmits the power stored in the lead-acid battery B to a load such as a home, an office, or a factory as necessary. The lead-acid battery system S includes a BMU 1, an EMS 2, and a PCS 3 in addition to the lead-acid battery B.

The BMU 1 is a battery management unit and is a device that manages a voltage of each of cells included in the lead-acid battery B, a temperature of the entire lead-acid battery B, and the like. Thus, the BMU 1 can grasp a state of the lead-acid battery B via a sensor that is provided in the lead-acid battery B and acquires various types of information.

In addition, the BMU 1 estimates a remaining life of the lead-acid battery B by comparing a capacity turnover value from the beginning to the end of life with a capacity turnover value during operation. Therefore, the BMU 1 includes a life estimation program necessary for the estimation.

Note that a function of the BMU 1 is not limited to the function described here, and may include other functions such as managing the balance of voltages in the respective cells, for example.

The BMU 1 is a computer system having an arithmetic processing function, and can implement each function on software by executing various dedicated computer programs stored in advance in hardware. In addition, the BMU 1 may be installed near the lead-acid battery B, or may be configured to be managed on a cloud or managed remotely. A detailed configuration of the BMU 1 will be described later.

The EMS 2 is a so-called energy management system, and is a system that grasps, manages, and optimizes a use state of power energy. In addition, the PCS 3 is a power conditioning system, and serves a role of converting a direct current generated from a grid current or the like into an alternating current and adjusting the alternating current to an output to the load or a stable output suitable for storage in the lead-acid battery B.

The lead-acid battery B is a secondary battery using lead as an electrode. As the lead-acid battery B, a bipolar lead-acid battery is preferably applied, but any structure may be used, and the number of installations, an installation method, and the like are not limited, and any setting can be used. In the lead-acid battery B, information acquired from various sensors to be described later (sensor information) is transmitted to the BMU 1, but a transmission/reception device or the like for transmitting the acquired sensor information to the BMU 1 and receiving, for example, a command from the PCS 3 is provided.

The lead-acid battery B includes various sensors (not illustrated in FIG. 1) for acquiring corresponding operation history information. The various sensors are sensors that acquire information indicating an operation history or state of the lead-acid battery B such as a current, a voltage, or a temperature. These sensors may be provided for each unit or for each individual lead-acid battery B.

In the lead-acid battery system S according to the first embodiment and the second to sixth embodiments described below, the direct current from the grid current from the power plant such as a thermal power plant or renewable energy is converted into the alternating current in the PCS 3, and output to the load or storage in the lead-acid battery B is performed.

As will be described later, the BMU 1 estimates the remaining life of the lead-acid battery B, grasps a charge rate, the degree of deterioration, and the like of the lead-acid battery B, and issues an operation command to the EMS 2 according to the state of the lead-acid battery B. This operation command is further transmitted to the PCS 3 to appropriately issue a command for charging or discharging the lead-acid battery B and perform the above-described output to the load and the like.

As illustrated in FIG. 1, the BMU 1, the EMS 2, the PCS 3, and the lead-acid battery B are exemplified as four constituent elements of the lead-acid battery system S, but the constituent elements of the lead-acid battery system S are not limited thereto. It is also possible to impart the functions of the EMS 2 and the PCS 3 to the BMU 1, and in this case, the lead-acid battery system S is constituted by the BMU 1 and the lead-acid battery B.

Next, the BMU 1 will be described in more detail. FIG. 2 is a block diagram illustrating an internal configuration of the BMUs included in the lead-acid battery systems S according to the first embodiment of the present invention and the second to sixth embodiments described below.

The BMU 1 includes a measurement unit 11, a recording unit 12, a state determination unit 13, a setting unit 14, and a communication unit 15.

The measurement unit 11 receives information regarding a measured value such as a current, a voltage, or a temperature measured via the above-described various sensors provided in the lead-acid battery B. Note that the measurement unit 11 may be set to continuously receive the above-described information, or may receive the above-described information between two time points arbitrarily set in advance. Alternatively, the measurement unit 11 may be set to periodically receive the information.

The recording unit 12 records information regarding the measured value received from the various sensors by the measurement unit 11, information exchanged with the EMS 2, information necessary for calculating the capacity turnover value during operation and the capacity turnover value from the beginning to the end of life (for example, a rated capacity or the like of the lead-acid battery B), a result of processing executed by the state determination unit 13 (the remaining life of the lead-acid battery B and the capacity turnover value during operation calculated by state determination unit 13), and the like. In addition, the total charge amount and the total discharge amount of the lead-acid battery B from the beginning of operation to a corresponding time point are constantly calculated based on a current value when the lead-acid battery B is charged and discharged, the current value being received from a current sensor by the measurement unit 11, and the total charge amount and the total discharge amount of the lead-acid battery B from the beginning of operation to the corresponding time point are constantly recorded in the recording unit 12.

The state determination unit 13 determines the state of the lead-acid battery B, specifically, estimates the remaining life of the lead-acid battery B by comparing the capacity turnover value from the beginning to the end of life and the capacity turnover value during operation. Here, as described above, the capacity turnover value is a value obtained by dividing a total discharge capacity by a rated capacity of a storage battery, and is used as a life index of the storage battery. The capacity turnover value from the beginning to the end of life is obtained by dividing the total discharge capacity from the beginning to the end of life by the rated capacity of the storage battery. For example, in FIG. 39, when a lead-acid battery having a rated capacity of 1000 Ah as indicated by an arrow A is dischargeable for 4500 cycles with a DOD of 70%, the capacity turnover value from the beginning to the end of life (hereinafter, referred to as a CT value from the beginning to the end of life) is total discharge capacity (1000 Ah $\times$ 70% $\times$ 4500 cycles)/rated capacity (1000 Ah) = 3150 (times). In addition, the capacity turnover value during operation is calculated by a method described below.

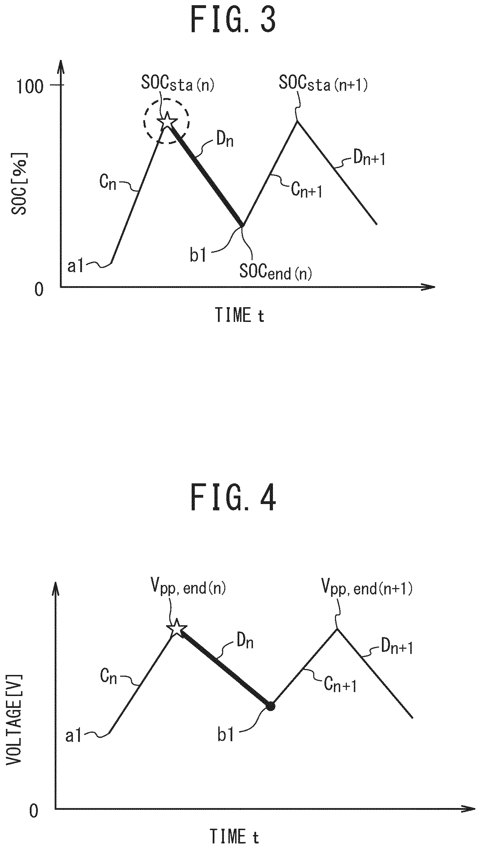

The processing in the state determination unit 13 is executed as needed in normal operation, for example. For example, in the first embodiment, as illustrated in FIGS. 3 and 4, the processing in the state determination unit 13 is executed from a time point a1 at the time of the n-th charge Cn of the lead-acid battery B to a time point b1 after the end of the n-th discharge Dn, and the processing is repeated at the time of charging and discharging.

The setting unit 14 sets, for example, a first threshold, a second threshold, and the like of a current value used for charge/discharge determination, which are used when the state determination unit 13 determines the state of the lead-acid battery B, specifically, estimates the remaining life of the lead-acid battery B, and transmits the set information to the recording unit 12. In setting the thresholds, an input unit and a display unit (not illustrated in FIG. 2) are used.

The communication unit 15 transmits the result of the processing in the state determination unit 13 recorded in the recording unit 12 to the EMS 2.

The BMU 1 is a computer system having an arithmetic processing function as described above and has a configuration in which a central processing unit (CPU), a read only memory (ROM), a random access memory (RAM), and an input/output interface are connected via a bus. In addition, the input unit and the display unit used by a person who manages the lead-acid battery system S are connected to the input/output interface, and each unit illustrated in FIG. 2 described above is connected to the input/output interface.

The CPU reads and executes a boot program for activating the BMU 1 from the ROM based on an input signal from the input unit, and reads various operating systems stored in the recording unit 12. The CPU may control the lead-acid battery B or the like based on an input signal from another external device (not illustrated in FIG. 2) via the input unit or the input/output interface.

Further, the CPU is a processing device that reads a program and data stored in the RAM, the recording unit 12, or the like and loads the program and the data into the RAM, and implements a series of processing such as calculation and processing of data necessary for estimating the remaining life of the lead-acid battery B based on a command of the program read from the RAM.

The input unit is implemented by an input device such as a touch panel to which a person who manages the lead-acid battery system S inputs various operations, and an input signal is created based on the operation of the manager and transmitted to the CPU via the bus.

The display unit is, for example, a liquid crystal display. The display unit receives an output signal from the CPU via the bus and displays a processing result of the CPU.

In a case where the BMU 1 itself is operated by remote control, for example, the input unit and the display unit do not have to be provided inside the BMU 1. The BMU 1 may have functions other than the above-described units.

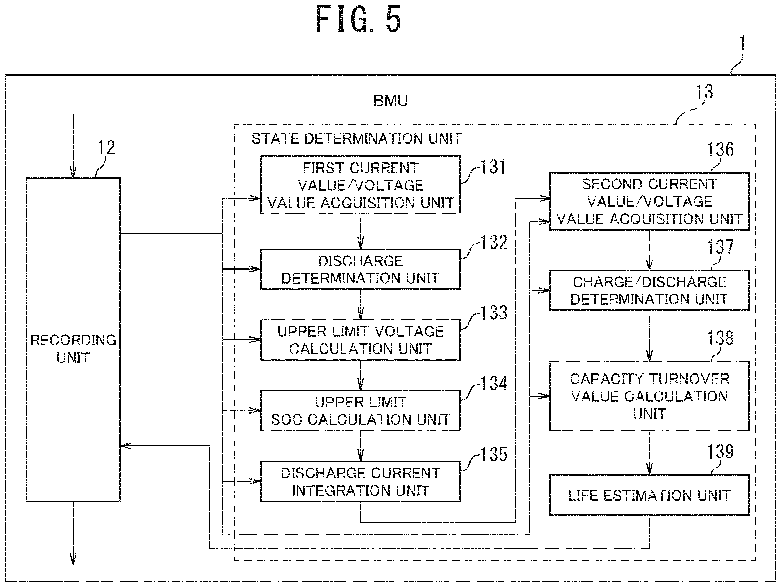

Next, internal configurations of the recording unit 12 and the state determination unit 13 will be described in more detail below. FIG. 5 is a block diagram illustrating the internal configurations of the recording unit 12 and the state determination unit 13 included in the BMU 1 illustrated in FIG. 2 in the lead-acid battery system S according to the first embodiment of the present invention.

The recording unit 12 is implemented by, for example, a semiconductor or a magnetic disk. The recording unit 12 records information regarding the measured value received from the various sensors by the measurement unit 11, such as information regarding a current value and a voltage value when the lead-acid battery B is charged or discharged, or information regarding the temperature of the lead-acid battery B, information exchanged with the EMS 2, information necessary for calculating the capacity turnover value during operation and the capacity turnover value from the beginning to the end of life (for example, the rated capacity or the like of the lead-acid battery B), a result of processing executed by the state determination unit 13 (the remaining life of the lead-acid battery B and the capacity turnover value during operation calculated by state determination unit 13), and the like. In addition, the total charge amount and the total discharge amount (negative value) from completion of an equalization charge of the lead-acid battery B to the corresponding time point are constantly calculated based on the current value when the lead-acid battery B is charged and discharged, the current value being received from the current sensor by the measurement unit 11, and the total charge amount and the total discharge amount (negative value) from the completion of the equalization charge to the corresponding time point are constantly recorded in the recording unit 12.

As will be described later, the state determination unit 13 of the first embodiment calculates the capacity turnover value during operation by using both an upper-limit-SOC-based correction coefficient $K_{HSOC}$ calculated based on a calculated upper limit state of charge (SOC), which is an SOC having the largest value when the lead-acid battery B is charged, and an upper-limit-voltage-based correction coefficient $K_{HV}$ calculated based on a calculated upper limit voltage, which is the highest voltage when the lead-acid battery B is charged.

Then, as illustrated in FIG. 3, the state determination unit 13 of the first embodiment calculates $SOC_{sta(n)}$ at the start of the discharge (n-th discharge Dn) of the lead-acid battery B to be subjected to calculation of the capacity turnover value during operation as the upper limit SOC.

In addition, as illustrated in FIG. 4, the state determination unit 13 of the first embodiment calculates a peak voltage $V_{pp,end(n)}$ at the end of the charge (n-th charge Cn) immediately before the discharge (n-th discharge Dn) of the lead-acid battery B to be subjected to calculation of the capacity turnover value during operation as the upper limit voltage.

Therefore, as illustrated in FIG. 5, the state determination unit 13 includes a first current value/voltage value acquisition unit 131, a discharge determination unit 132, an upper limit voltage calculation unit 133, an upper limit SOC calculation unit 134, a discharge current integration unit 135, a second current value/voltage value acquisition unit 136, a charge/discharge determination unit 137, a capacity turnover value calculation unit 138, and a life estimation unit 139 in order to estimate the remaining life of the lead-acid battery B.

The first current value/voltage value acquisition unit 131 acquires, from the recording unit 12, information regarding the current value of the lead-acid battery B and information regarding a voltage value $V_{meas}$ input to the recording unit 12 via the measurement unit 11 from the start to the end of the processing in the state determination unit 13.

In addition, the discharge determination unit 132 determines whether or not the lead-acid battery B is in the discharge (n-th discharge Dn) state based on the current value of the lead-acid battery B acquired by the first current value/voltage value acquisition unit 131. Specifically, in a case where the current value of the lead-acid battery B acquired by the first current value/voltage value acquisition unit 131 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n-th charge Cn) state). Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by the setting unit 14 and recorded in the recording unit 12, and the discharge determination unit 132 acquires information regarding the first threshold from the recording unit 12.

The upper limit voltage calculation unit 133 calculates the upper limit voltage which is the highest voltage when the lead-acid battery B is charged. More specifically, in a case where the determination result of the discharge determination unit 132 indicates that the lead-acid battery B is not in the discharge (n-th discharge Dn) state (the stop state or the charge (n-th charge Cn) state), it is determined whether or not the voltage value ($V_{meas}$) acquired by the first current value/voltage value acquisition unit 131 exceeds a voltage already set as a peak voltage $V_{pp}$ acquired from the recording unit 12. In a case where the voltage value ($V_{meas}$) exceeds the peak voltage $V_{pp}$, the voltage value ($V_{meas}$) is newly set as the peak voltage $V_{pp}$, and in a case where the voltage value ($V_{meas}$) does not exceed the peak voltage $V_{pp}$, the voltage already set as the peak voltage $V_{pp}$ is set as the peak voltage $V_{pp}$. This setting is repeated until it is determined that the current value acquired by the first current value/voltage value acquisition unit 131 indicates the discharge state, and the finally set peak voltage $V_{pp}$ is calculated as the peak voltage $V_{pp}$. That is, the upper limit voltage calculation unit 133 calculates the peak voltage $V_{pp,end(n)}$ at the end of the charge (n-th charge Cn) immediately before the discharge (n-th discharge Dn) of the lead-acid battery B to be subjected to calculation of the capacity turnover value during operation (see FIG. 4), and sets the calculated peak voltage $V_{pp,end(n)}$ as the upper limit voltage.

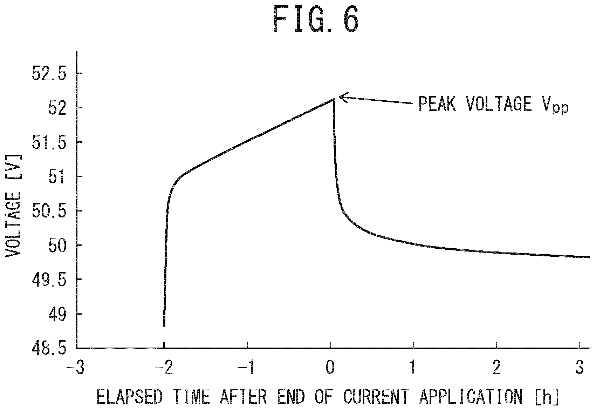

Here, the reason why the peak voltage $V_{pp,end(n)}$ is set as the upper limit voltage is that the peak voltage during the charge is set as the upper limit voltage because the voltage rapidly decreases when the charge current is not applied as illustrated in FIG. 6.

The upper limit SOC calculation unit 134 calculates the upper limit SOC, which is the SOC having the largest value when the lead-acid battery B is charged. More specifically, in a case where the determination result of the discharge determination unit 132 indicates that the lead-acid battery B is in the discharge (n-th discharge Dn) state, the upper limit SOC calculation unit 134 calculates $SOC_{sta(n)}$ at the start of the discharge (n-th discharge Dn) of the lead-acid battery B to be subjected to calculation of the capacity turnover value during operation as the upper limit SOC (see FIG. 3). Here, the upper limit SOC calculation unit 134 acquires, from the recording unit 12, the rated capacity of the lead-acid battery B, the total charge amount of the lead-acid battery B from the completion of the equalization charge to a start time point of the n-th discharge Dn recorded in the recording unit 12 at the start of the n-th discharge Dn, and the total discharge amount (negative value) of the lead-acid battery B from the completion of the equalization charge to the start time point of the n-th discharge Dn recorded in the recording unit 12 at the start of the n-th discharge Dn, and calculates $SOC_{sta(n)}$ by the following Formula (2) similar to Formula (1) described above.

[Mathematical Formula 2]

$$SOC_{sta(n)} = \frac{(\text{Rated capacity} + \text{Total charge amount} + \text{Total discharge amount})}{\text{Rated capacity}} \times 100 \quad \cdots (2)$$

In a case where it is determined by the discharge determination unit 132 that the lead-acid battery B is in the discharge (n-th discharge Dn) state, the discharge current integration unit 135 integrates discharge current values from the start of the discharge of the lead-acid battery B, and calculates an integrated discharge capacity value from the start of the discharge of the lead-acid battery B.

In addition, the second current value/voltage value acquisition unit 136 acquires, from the recording unit 12, information regarding the current value and the voltage value of the lead-acid battery B input to the recording unit 12 via the measurement unit 11 from the start to the end of the processing in the state determination unit 13.

In addition, the charge/discharge determination unit 137 determines whether the lead-acid battery B is in a discharge state, the stop state, or the charge state based on the current value of the lead-acid battery B acquired by the second current value/voltage value acquisition unit 136.

Here, in a case where the current value of the lead-acid battery B acquired by the second current value/voltage value acquisition unit 136 is smaller than the first threshold (the current value < the first threshold), the charge/discharge determination unit 137 determines that the lead-acid battery B is in the discharge (n-th discharge Dn) state,

in a case where the first threshold ≤ the current value ≤ the second threshold, the charge/discharge determination unit 137 determines that the lead-acid battery B is in the stop state, and

in a case where the current value > the second threshold, the charge/discharge determination unit 137 determines that the lead-acid battery B is in the charge (n+1-th charge Cn+1) state.

The first threshold is the same value as the above-described first threshold, and the second threshold is a positive current value near 0 amperes.

Next, in a case where the determination result of the charge/discharge determination unit 137 indicates that the lead-acid battery B is in the charge (n+1-th charge Cn+1) state, the capacity turnover value calculation unit 138 calculates the capacity turnover value during operation (hereinafter, referred to as a CT value during operation).

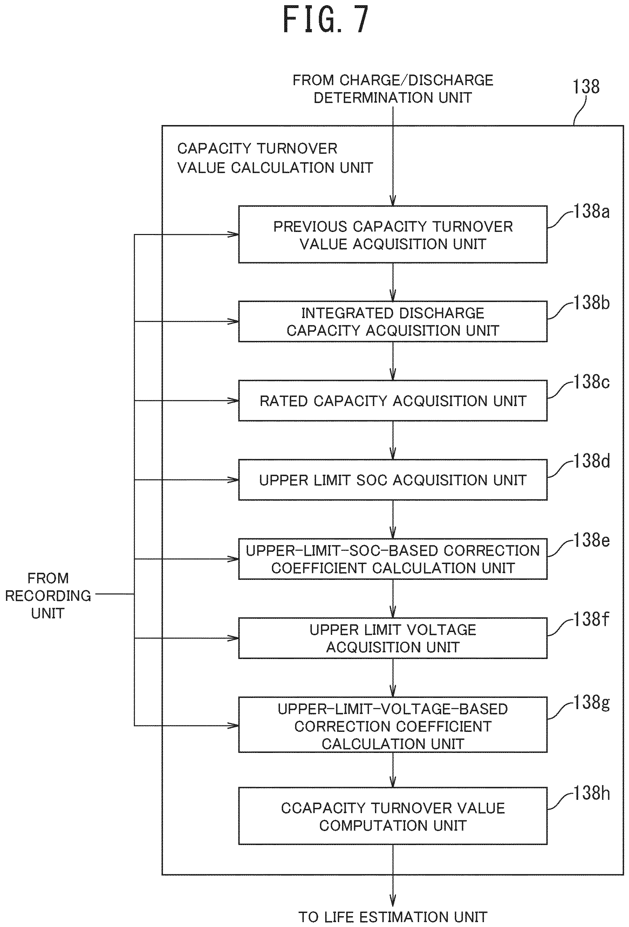

An internal configuration of the capacity turnover value calculation unit 138 will be described in more detail below. FIG. 7 is a block diagram illustrating an internal configuration of the capacity turnover value calculation unit 138 included in the state determination unit 13 illustrated in FIG. 5.

The capacity turnover value calculation unit 138 includes a previous capacity turnover value acquisition unit 138a, an integrated discharge capacity acquisition unit 138b, a rated capacity acquisition unit 138c, an upper limit SOC acquisition unit 138d, an upper-limit-SOC-based correction coefficient calculation unit 138e, an upper limit voltage acquisition unit 138f, an upper-limit-voltage-based correction coefficient calculation unit 138g, and a capacity turnover value computation unit 138h.

In a case where it is determined by the charge/discharge determination unit 137 that the lead-acid battery B is in the charge (n+1-th charge Cn+1) state, the previous capacity turnover value acquisition unit 138a acquires, from the recording unit 12, a capacity turnover value before the start of the processing in the state determination unit 13 (before the time point a1 in FIG. 3) (hereinafter, referred to as a previous CT value). The previous CT value is a CT value during operation calculated by the capacity turnover value calculation unit 138 at the time of the previous processing in the state determination unit 13, and already input from the capacity turnover value calculation unit 138 to the recording unit 12.

In addition, the integrated discharge capacity acquisition unit 138b acquires information regarding the integrated discharge capacity value from the start of the discharge of the lead-acid battery B calculated by the discharge current integration unit 135.

Further, the rated capacity acquisition unit 138c acquires information regarding the rated capacity (Ah) of the lead-acid battery B from the recording unit 12.

The upper limit SOC acquisition unit 138d acquires information regarding the upper limit SOC calculated by the upper limit SOC calculation unit 134.

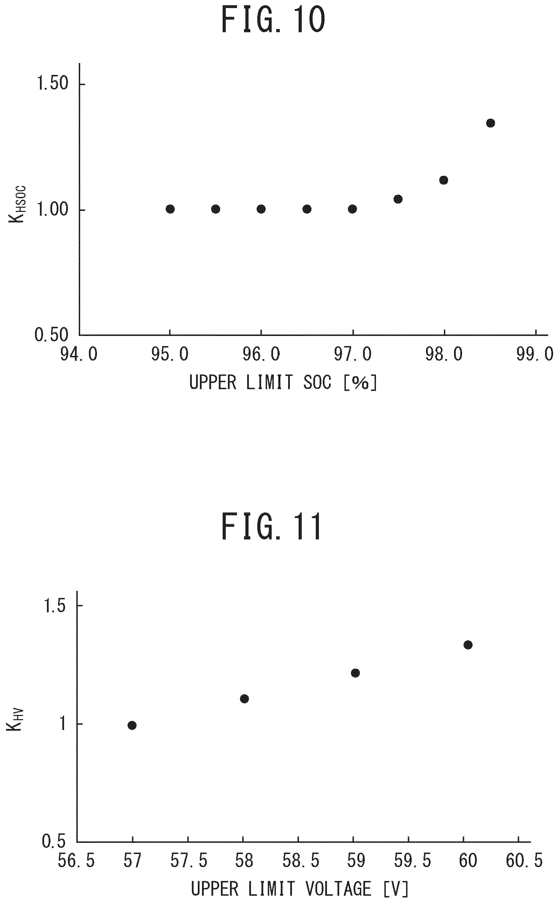

The upper-limit-SOC-based correction coefficient calculation unit 138e calculates the upper-limit-SOC-based correction coefficient $K_{HSOC}$ by using the upper limit SOC acquired by the upper limit SOC acquisition unit 138d. The upper-limit-SOC-based correction coefficient $K_{HSOC}$ is calculated with reference to a graph illustrating a relationship between the upper limit SOC and the upper-limit-SOC-based correction coefficient $K_{HSOC}$ illustrated in FIG. 10. In FIG. 10, the upper-limit-SOC-based correction coefficient $K_{HSOC}$ between the respective numerical values is calculated by creating an approximation curve from values of two adjacent points.

The upper limit voltage acquisition unit 138f acquires information regarding the upper limit voltage calculated by the upper limit voltage calculation unit 133.

The upper-limit-voltage-based correction coefficient calculation unit 138g calculates the upper-limit-voltage-based correction coefficient $K_{HV}$ by using the upper limit voltage acquired by the upper limit voltage acquisition unit 138f. The upper-limit-voltage-based correction coefficient $K_{HV}$ is calculated with reference to a graph illustrating a relationship between the upper limit voltage and the upper-limit-voltage-based correction coefficient $K_{HV}$ illustrated in FIG. 11. Here, in FIG. 11, the upper-limit-voltage-based correction coefficient $K_{HV}$ between the respective numerical values is calculated by creating an approximation curve from values of two adjacent points. However, in a case where the upper limit voltage is 57 V or less, the upper-limit-voltage-based correction coefficient $K_{HV} = 1$, which is constant.

Further, the capacity turnover value computation unit 138h calculates the CT value during operation by the following Formula (3) using the previous CT value acquired by the previous capacity turnover value acquisition unit 138a, the integrated discharge capacity from the start of the discharge of the lead-acid battery B acquired by the integrated discharge capacity acquisition unit 138b, the rated capacity (Ah) of the lead-acid battery B acquired by the rated capacity acquisition unit 138c, the upper-limit-SOC-based correction coefficient $K_{HSOC}$ calculated by the upper-limit-SOC-based correction coefficient calculation unit 138e, and the upper-limit-voltage-based correction coefficient $_{HV}$ calculated by the upper-limit-voltage-based correction coefficient calculation unit 138g.

[Mathematical Formula 3]

$$\text{CT value during operation} =$$

$$\text{Previous CT value} + \frac{\text{Integrated discharge capacity}}{\text{Rated capacity(Ah)}} \times K_{HSOC} \times K_{HV} \qquad \cdots (3)$$

Then, the life estimation unit 139 estimates the remaining life of the lead-acid battery B by comparing the CT value from the beginning to the end of life acquired from the recording unit 12 with the CT value during operation calculated by the capacity turnover value calculation unit 138. That is, the life estimation unit 139 estimates the remaining life of the lead-acid battery B from a CT value obtained by subtracting the CT value during operation from the CT value from the beginning to the end of life.

Then, the life estimation unit 139 records an estimation result of the life estimation unit 139 including the CT value during operation in the recording unit 12. The life estimation unit 139 sets the peak voltage $V_{pp}$ calculated by the upper limit voltage calculation unit 133 to 0 and records the peak voltage $V_{pp}$ in the recording unit 12.

As described above, in the lead-acid battery system S according to the first embodiment, the capacity turnover value calculation unit 138 calculates the CT value during operation by using both the upper-limit-SOC-based correction coefficient $K_{HSOC}$ calculated based on the upper limit SOC calculated by the upper limit SOC calculation unit 134 that calculates the upper limit SOC, which is the SOC having the largest value when the lead-acid battery B is charged, and the upper-limit-voltage-based correction coefficient $K_{HV}$ calculated based on the upper limit voltage calculated by the upper limit voltage calculation unit 133 that calculates the upper limit voltage, which is the highest voltage when the lead-acid battery B is charged. As a result, the CT value during operation can be calculated in consideration of both the upper limit SOC and the upper limit voltage, the progress of corrosion of a positive electrode and softening of an active material due to electrolyte loss can be considered, and the lead-acid battery system S capable of accurately estimating the remaining life of the lead-acid battery can be provided.

In the lead-acid battery system S according to the first embodiment, the upper limit SOC calculation unit 134 calculates $SOC_{sta(n)}$ at the start of the discharge (n-th discharge Dn) of the lead-acid battery B to be subjected to calculation of the CT value during operation as the upper limit SOC, and the capacity turnover value calculation unit 138 calculates the upper-limit-SOC-based correction coefficient $K_{HSOC}$ based on the upper limit SOC calculated by the upper limit SOC calculation unit 134. As a result, the upper limit SOC can be determined and calculated at the start of the discharge (n-th discharge Dn) of the lead-acid battery B to be subjected to calculation of the CT value during operation, and the upper-limit-SOC-based correction coefficient $K_{HSOC}$ can be appropriately calculated based on the calculated upper limit SOC.

In the lead-acid battery system S according to the first embodiment, the upper limit voltage calculation unit 133 calculates the peak voltage $V_{pp,end(n)}$ at the end of the charge (n-th charge Cn) immediately before the discharge (n-th discharge Dn) of the lead-acid battery B to be subjected to calculation of the CT value during operation as the upper limit voltage, and the capacity turnover value calculation unit 138 calculates the upper-limit-voltage-based correction coefficient $K_{HV}$ based on the upper limit voltage calculated by the upper limit voltage calculation unit 133. As a result, the upper limit voltage can be calculated by calculating the peak voltage $V_{pp,end(n)}$ at the end of the charge (n-th charge Cn) immediately before the discharge (n-th discharge Dn) of the lead-acid battery B to be subjected to calculation of the CT value during operation, and the upper-limit-voltage-based correction coefficient $K_{HV}$ can be appropriately calculated based on the calculated upper limit voltage.

In the lead-acid battery system S according to the first embodiment, in a case where the lead-acid battery B is a bipolar lead-acid battery, it is possible to provide the lead-acid battery system S capable of accurately estimating the remaining life of the bipolar lead-acid battery.

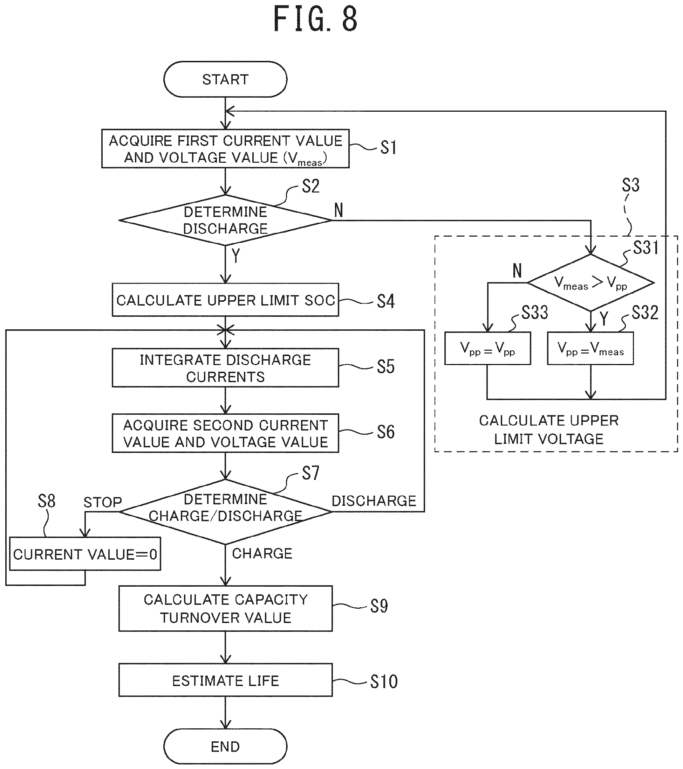

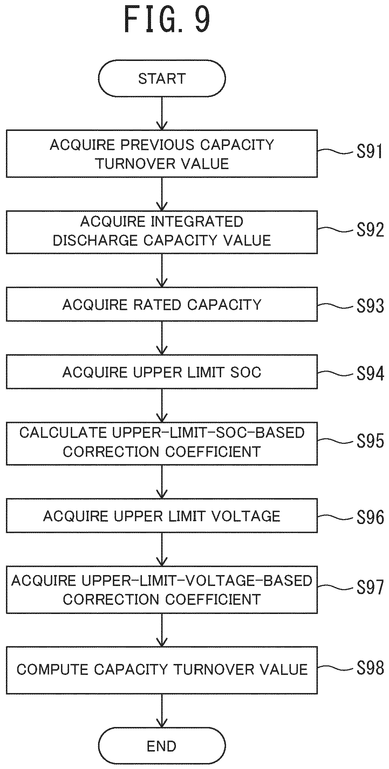

Next, a lead-acid battery life estimation method according to the first embodiment will be described with reference to a flowchart illustrating a flow of processing in the state determination unit illustrated in FIG. 8 and a flowchart illustrating a flow of processing of step S9 (capacity turnover value calculation step) in the flowchart of FIG. 8 illustrated in FIG. 9.

The state determination unit 13 starts the processing from the time point a1 in FIGS. 3 and 4. First, as illustrated in FIG. 8, in step S1, the first current value/voltage value acquisition unit 131 of the state determination unit 13 acquires, from the recording unit 12, information regarding the current value and the voltage value ($V_{meas}$) of the lead-acid battery B input to the recording unit 12 via the measurement unit 11 from the start to the end (the time point b1 in FIGS. 3 and 4) of the processing in the state determination unit 13 (first current value/voltage value acquisition step).

Next, in step S2, the discharge determination unit 132 determines whether or not the lead-acid battery B is in the discharge (n-th discharge Dn) state based on the current value of the lead-acid battery B acquired in step S1 (discharge determination step). Specifically, in a case where the current value of the lead-acid battery B acquired in step S1 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by the setting unit 14 and recorded in the recording unit 12, and the discharge determination unit 132 acquires information regarding the first threshold from the recording unit 12.

In a case where it is determined in step S2 that the lead-acid battery B is not in the discharge (n-th discharge Dn) state (the stop state or the charge (n-th charge Cn) state), the processing proceeds to step S3, and in a case where it is determined in step S2 that the lead-acid battery B is in the discharge (n-th discharge Dn) state, the processing proceeds to step S4.

Then, in step S3, the upper limit voltage calculation unit 133 calculates the upper limit voltage which is the highest voltage when the lead-acid battery B is charged (upper limit voltage calculation step). More specifically, in step S31, it is determined whether or not the voltage value ($V_{meas}$) acquired in step S1 exceeds the voltage already set as the peak voltage $V_{pp}$ acquired from the recording unit 12. In a case where the voltage value ($V_{meas}$) exceeds the peak voltage $V_{pp}$, the voltage value ($V_{meas}$) is newly set as the peak voltage $V_{pp}$ in step S32. In a case where the voltage value ($V_{meas}$) does not exceed the peak voltage $V_{pp}$, the voltage value already set as the peak voltage $V_{pp}$ in step S33 is set as the peak voltage $V_{pp}$. Then, this setting is repeated until it is determined that the current value acquired in step S1 indicates the discharge state in step S2, and the finally set peak voltage $V_{pp}$ is calculated as the peak voltage $V_{pp}$. That is, in step S3, the upper limit voltage calculation unit 133 calculates the peak voltage $V_{pp,end(n)}$ at the end of the charge (n-th charge Cn) immediately before the discharge (n-th discharge Dn) of the lead-acid battery B to be subjected to calculation of the capacity turnover value during operation (see FIG. 4), and sets the calculated peak voltage $V_{pp,end(n)}$ as the upper limit voltage.

In step S4, the upper limit SOC calculation unit 134 calculates the upper limit SOC, which is the SOC having the largest value when the lead-acid battery B is charged (upper limit SOC calculation step). Specifically, the upper limit SOC calculation unit 134 calculates $SOC_{sta(n)}$ at the start of the discharge (n-th discharge Dn) of the lead-acid battery B to be subjected to calculation of the capacity turnover value during operation, and sets the calculated $SOC_{sta(n)}$ as the upper limit SOC (see FIG. 3). Here, the upper limit SOC calculation unit 134 acquires, from the recording unit 12, the rated capacity of the storage battery B, the total charge amount of the lead-acid battery B from the completion of the equalization charge to a start time point of the n-th discharge Dn recorded in the recording unit 12 at the start of the n-th discharge Dn, and the total discharge amount (negative value) of the lead-acid battery B from the completion of the equalization charge to the start time point of the n-th discharge Dn recorded in the recording unit 12 at the start of the n-th discharge Dn, and calculates $SOC_{sta(n)}$ by Formula (2) described above.

Next, in step S5, the discharge current integration unit 135 integrates the discharge current values from the start of the discharge of the lead-acid battery B, and calculates the integrated discharge capacity value from the start of the discharge of the lead-acid battery B (integrated discharge capacity value calculation step).

Next, in step S6, the second current value/voltage value acquisition unit 136 acquires, from the recording unit 12, information regarding the current value and the voltage value of the lead-acid battery B input to the recording unit 12 via the measurement unit 11 from the start to the end of the processing in the state determination unit 13 (second current value/voltage value acquisition step).

Next, in step S7, the charge/discharge determination unit 137 determines whether the lead-acid battery B is in the discharge state, the stop state, or the charge state based on the current value of the lead-acid battery B acquired in step S6 (charge/discharge determination step).

Here, in a case where the current value of the lead-acid battery B acquired in step S6 is smaller than the first threshold (the current value < the first threshold), the charge/discharge determination unit 137 determines that the lead-acid battery B is in the discharge (n-th discharge Dn) state,

in a case where the first threshold ≤ the current value ≤ the second threshold, the charge/discharge determination unit 137 determines that the lead-acid battery B is in the stop state, and
in a case where the current value > the second threshold, the charge/discharge determination unit 137 determines that the lead-acid battery B is in the charge (n+1-th charge Cn+1) state.

The first threshold is the same value as the above-described first threshold, and the second threshold is a positive current value near 0 amperes.

In a case where the determination result in step S7 indicates the stop state, the current value is set to 0 in step S8, and the processing returns to step S5.

In addition, in a case where the determination result in step S7 indicates the discharge state, the processing returns to step S5.

In addition, in a case where the determination result in step S7 indicates the charge (n+1-th charge Cn+1) state, the processing proceeds to step S9.

In step S9, the capacity turnover value calculation unit 138 calculates the CT value during operation (capacity turnover value calculation step).

A detailed flow of processing in the capacity turnover value calculation unit 138 in step S9 will be described with reference to FIG. 9. FIG. 9 is a flowchart illustrating a flow of processing of step S9 (capacity turnover value calculation step) in the flowchart illustrated in FIG. 8.

First, in step S91, the previous capacity turnover value acquisition unit 138a acquires the CT value before the start of the processing in the state determination unit 13 (before the time point a1 in FIG. 3) from the recording unit 12 (previous CT value acquisition step). The previous CT value is a CT value during operation calculated in step S9 at the time of the previous processing in the state determination unit 13, and already input from the capacity turnover value calculation unit 138 to the recording unit 12.

Next, in step S92, the integrated discharge capacity acquisition unit 138b acquires information regarding the integrated discharge capacity value from the start of the discharge of the lead-acid battery B calculated in step S5 (integrated discharge capacity value acquisition step).

Next, in step S93, the rated capacity acquisition unit 138c acquires information regarding the rated capacity (Ah) of the lead-acid battery B from the recording unit 12 (rated capacity acquisition step).

In step S94, the upper limit SOC acquisition unit 138d acquires information regarding the upper limit SOC calculated in step S4 (upper limit SOC acquisition step).

Next, in step S95, the upper-limit-SOC-based correction coefficient calculation unit 138e calculates the upper-limit-SOC-based correction coefficient $K_{HSOC}$ by using the upper limit SOC acquired in step S94 (upper-limit-SOC-based correction coefficient calculation step). As described above, the upper-limit-SOC-based correction coefficient $K_{HSOC}$ is calculated with reference to a graph illustrating a relationship between the upper limit SOC and the upper-limit-SOC-based correction coefficient $K_{HSOC}$ illustrated in FIG. 10. In FIG. 10, the upper-limit-SOC-based correction coefficient $K_{HSOC}$ between the respective numerical values is calculated by creating an approximation curve from values of two adjacent points.

Next, in step S96, the upper limit voltage acquisition unit 138f acquires information regarding the upper limit voltage calculated in step S3 (upper limit voltage acquisition step).

Next, in step S97, the upper-limit-voltage-based correction coefficient calculation unit 138g calculates the upper-limit-voltage-based correction coefficient $K_{HV}$ by using the upper limit voltage acquired in step S96 (upper-limit-voltage-based correction coefficient calculation step). As described above, the upper-limit-voltage-based correction coefficient $K_{HV}$ is calculated with reference to a graph illustrating a relationship between the upper limit voltage and the upper-limit-voltage-based correction coefficient $K_{HV}$ illustrated in FIG. 11. Here, in FIG. 11, the upper-limit-voltage-based correction coefficient $K_{HV}$ between the respective numerical values is calculated by creating an approximation curve from values of two adjacent points. However, in a case where the upper limit voltage is 57 V or less, the upper-limit-voltage-based correction coefficient $K_{HV} = 1$, which is constant.

In step S98, the capacity turnover value computation unit 138h calculates the CT value during operation by Formula (3) described above using the previous CT value acquired in step S91, the integrated discharge capacity from the start of the discharge of the lead-acid battery B acquired in step S92, the rated capacity (Ah) of the lead-acid battery B acquired in step S93, the upper-limit-SOC-based correction coefficient $K_{HSOC}$ calculated in step S95, and the upper-limit-voltage-based correction coefficient $K_{HV}$ calculated in step S97 (capacity turnover value computation step).

As a result, the processing in the capacity turnover value calculation unit 138 in step S9 ends.

In step S10, the life estimation unit 139 of the state determination unit 13 estimates the remaining life of the lead-acid battery B by comparing the CT value from the beginning to the end of life acquired from the recording unit 12 with the CT value during operation calculated in step S9. That is, the life estimation unit 139 estimates the remaining life of the lead-acid battery B from a CT value obtained by subtracting the CT value during operation from the CT value from the beginning to the end of life (life estimation step).

Then, the life estimation unit 139 records an estimation result of the life estimation unit 139 including the CT value during operation in the recording unit 12. The life estimation unit 139 sets the peak voltage $V_{pp}$ calculated in step S3 to 0 and records the peak voltage $V_{pp}$ in the recording unit 12.

Accordingly, the processing in the state determination unit 13 ends.

As described above, in the lead-acid battery life estimation method according to the first embodiment, in the capacity turnover value calculation step (step S9), the CT value during operation is calculated using both the upper-limit-SOC-based correction coefficient $K_{HSOC}$ calculated based on the upper limit SOC calculated in the upper limit SOC calculation step (step S4) of calculating the upper limit SOC, which is the SOC having the largest value when the lead-acid battery B is charged, and the upper-limit-voltage-based correction coefficient $K_{HV}$ calculated based on the upper limit voltage calculated in the upper limit voltage calculation step (step S3) of calculating the upper limit voltage, which is the highest voltage when the lead-acid battery B is charged. As a result, the CT value during operation can be calculated in consideration of both the upper limit SOC and the upper limit voltage, the progress of corrosion of a positive electrode and softening of an active material due to electrolyte loss can be considered, and the lead-acid battery life estimation method capable of accurately estimating the remaining life of the lead-acid battery can be provided.

In the lead-acid battery life estimation method according to the first embodiment, in the upper limit SOC calculation step (step S4), $SOC_{sta(n)}$ at the start of the discharge (n-th discharge Dn) of the lead-acid battery B to be subjected to calculation of the CT value during operation is calculated as the upper limit SOC, and in the capacity turnover value calculation step (step S9), the upper-limit-SOC-based correction coefficient $K_{HSOC}$ is calculated based on the upper limit SOC calculated in the upper limit SOC calculation step (step S4). As a result, the upper limit SOC can be determined and calculated at the start of the discharge (n-th discharge Dn) of the lead-acid battery B to be subjected to calculation of the CT value during operation, and the upper-limit-SOC-based correction coefficient $K_{HSOC}$ can be appropriately calculated based on the calculated upper limit SOC.

In the lead-acid battery life estimation method according to the first embodiment, in the upper limit voltage calculation step (step S3), the peak voltage $V_{pp,end(n)}$ at the end of the charge (n-th charge Cn) immediately before the discharge (n-th discharge Dn) of the lead-acid battery B to be subjected to calculation of the CT value during operation is

14

calculated as the upper limit voltage, and in the capacity turnover value calculation step (step S9), the upper-limit-voltage-based correction coefficient $K_{HV}$ is calculated based on the upper limit voltage calculated in the upper limit voltage calculation step (step S3). As a result, the upper limit voltage can be calculated by calculating the peak voltage $V_{pp,end(n)}$ at the end of the charge (n-th charge Cn) immediately before the discharge (n-th discharge Dn) of the lead-acid battery B to be subjected to calculation of the CT value during operation, and the upper-limit-voltage-based correction coefficient $K_{HV}$ can be appropriately calculated based on the calculated upper limit voltage.

In the lead-acid battery life estimation method according to the first embodiment, in a case where the lead-acid battery B is a bipolar lead-acid battery, it is possible to provide a lead-acid battery life estimation method capable of accurately estimating the remaining life of the bipolar lead-acid battery.

(Second Embodiment)

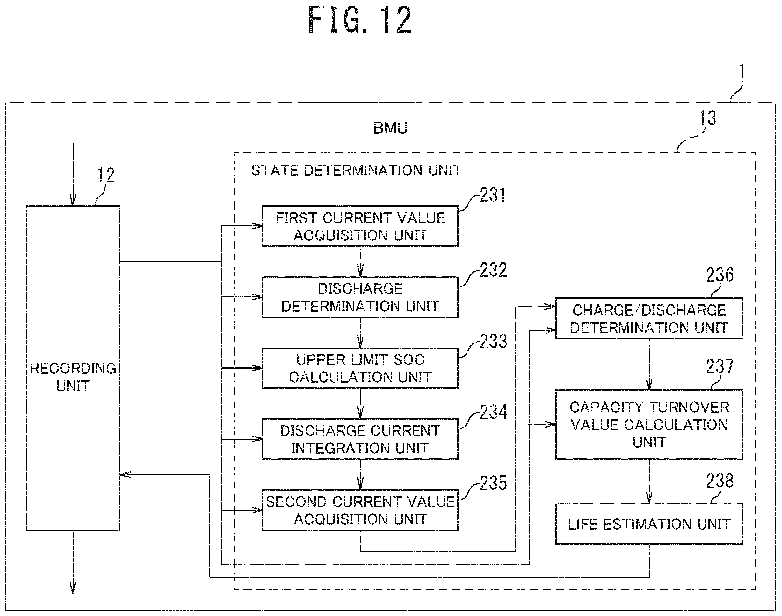

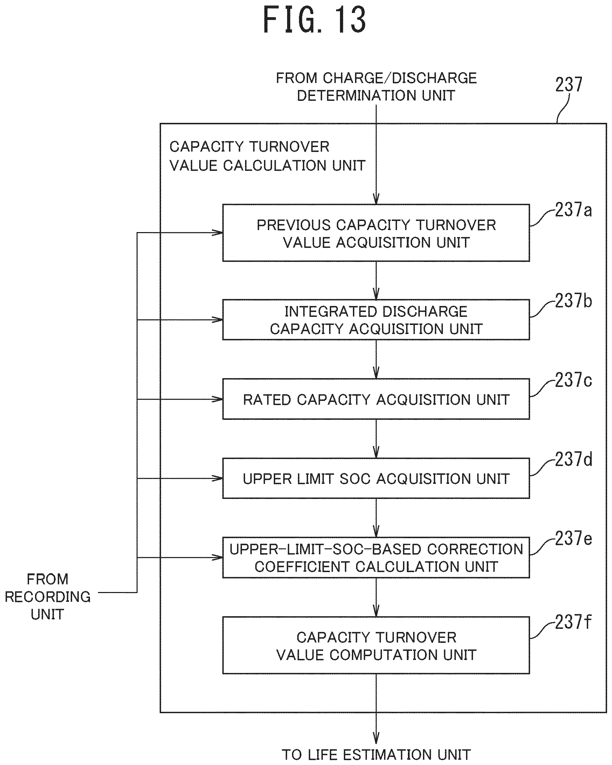

Next, the lead-acid battery system according to the second embodiment of the present invention will be described with reference to FIGS. 12 and 13. FIG. 12 is a block diagram illustrating internal configurations of a recording unit and a state determination unit included in the BMU illustrated in FIG. 2 in the lead-acid battery system according to the second embodiment of the present invention. FIG. 13 is a block diagram illustrating an internal configuration of a capacity turnover value calculation unit included in the state determination unit illustrated in FIG. 12.

The lead-acid battery system S according to the second embodiment has the same basic configuration as the lead-acid battery system S according to the first embodiment, and is different from the lead-acid battery system S according to the first embodiment in a configuration of the state determination unit 13.

The state determination unit 13 in the lead-acid battery system S according to the first embodiment calculates a capacity turnover value during operation by using both an upper-limit-SOC-based correction coefficient $K_{HSOC}$ calculated based on a calculated upper limit SOC, which is an SOC having the largest value when a lead-acid battery B is charged, and an upper-limit-voltage-based correction coefficient $K_{HV}$ calculated based on a calculated upper limit voltage, which is the highest voltage when the lead-acid battery B is charged.

On the other hand, the state determination unit 13 in the lead-acid battery system S according to the second embodiment is different in that the capacity turnover value during operation is calculated using only the upper-limit-SOC-based correction coefficient $K_{HSOC}$ out of the upper-limit-SOC-based correction coefficient $K_{HSOC}$ and the upper-limit-voltage-based correction coefficient $K_{HV}$.

As illustrated in FIG. 3, similarly to the state determination unit 13 of the first embodiment, the state determination unit 13 of the second embodiment calculates $SOC_{sta(n)}$ at the start of a discharge (n-th discharge Dn) of the lead-acid battery B to be subjected to calculation of the capacity turnover value during operation as the upper limit SOC.

As illustrated in FIG. 3, the processing in the state determination unit 13 in the lead-acid battery system S according to the second embodiment is executed from a time point a1 at the time of the n-th charge Cn of the lead-acid battery B to a time point b1 after the end of the n-th discharge Dn, and the processing is repeated at the time of charging and discharging.

Therefore, as illustrated in FIG. 12, the state determination unit 13 of the second embodiment includes a first current value acquisition unit 231, a discharge determination unit 232, an upper limit SOC calculation unit 233, a discharge current integration unit 234, a second current value acquisition unit 235, a charge/discharge determination unit 236, a capacity turnover value calculation unit 237, and a life estimation unit 238 in order to estimate the remaining life of the lead-acid battery B.

The first current value acquisition unit 231 acquires, from the recording unit 12, information regarding a current value of the lead-acid battery B input to the recording unit 12 via a measurement unit 11 from the start to the end of the processing in the state determination unit 13.

In addition, the discharge determination unit 232 determines whether or not the lead-acid battery B is in a discharge (n-th discharge Dn) state based on the current value of the lead-acid battery B acquired by the first current value acquisition unit 231. Specifically, in a case where the current value of the lead-acid battery B acquired by the first current value acquisition unit 231 is smaller than a first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n-th charge Cn) state). Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by the setting unit 14 and recorded in the recording unit 12, and the discharge determination unit 132 acquires information regarding the first threshold from the recording unit 12.

The upper limit SOC calculation unit 233 calculates the upper limit SOC, which is the SOC having the largest value when the lead-acid battery B is charged. More specifically, in a case where the determination result of the discharge determination unit 232 indicates that the lead-acid battery B is in the discharge (n-th discharge Dn) state, the upper limit SOC calculation unit 233 calculates $SOC_{sta(n)}$ at the start of the discharge (n-th discharge Dn) of the lead-acid battery B to be subjected to calculation of the capacity turnover value during operation as the upper limit SOC (see FIG. 3). Here, the upper limit SOC calculation unit 233 acquires, from the recording unit 12, the rated capacity of the lead-acid battery B, the total charge amount of the lead-acid battery B from completion of an equalization charge to a start time point of the n-th discharge Dn recorded in the recording unit 12 at the start of the n-th discharge Dn, and the total discharge amount (negative value) of the lead-acid battery B from the completion of the equalization charge to the start time point of the n-th discharge Dn recorded in the recording unit 12 at the start of the n-th discharge Dn, and calculates $SOC_{sta(n)}$ by Formula (2) described above.

In a case where it is determined by the discharge determination unit 232 that the lead-acid battery B is in the discharge (n-th discharge Dn) state, the discharge current integration unit 234 integrates discharge current values from the start of the discharge of the lead-acid battery B, and calculates an integrated discharge capacity value from the start of the discharge of the lead-acid battery B.

In addition, the second current value acquisition unit 235 acquires, from the recording unit 12, information regarding the current value and a voltage value of the lead-acid battery B input to the recording unit 12 via the measurement unit 11 from the start to the end of the processing in the state determination unit 13.

In addition, the charge/discharge determination unit 236 determines whether the lead-acid battery B is in a discharge state, the stop state, or the charge state based on the current value of the lead-acid battery B acquired by the second current value acquisition unit 235.

Here, in a case where the current value of the lead-acid battery B acquired by the second current value acquisition unit 235 is smaller than the first threshold (the current value < the first threshold), the charge/discharge determination unit 236 determines that the lead-acid battery B is in the discharge (n-th discharge Dn) state,

in a case where the first threshold ≤ the current value ≤ a second threshold, the charge/discharge determination unit 236 determines that the lead-acid battery B is in the stop state, and
in a case where the current value > the second threshold, the charge/discharge determination unit 236 determines that the lead-acid battery B is in the charge (n+1-th charge Cn+1) state.

The first threshold and the second threshold are values similar to those described above.

Next, in a case where the determination result of the charge/discharge determination unit 236 indicates that the lead-acid battery B is in the charge (n+1-th charge Cn+1) state, the capacity turnover value calculation unit 237 calculates the capacity turnover value during operation (hereinafter, referred to as a CT value during operation).

The internal configuration of the capacity turnover value calculation unit 237 will be described in more detail. As illustrated in FIG. 13, the capacity turnover value calculation unit 237 includes a previous capacity turnover value acquisition unit 237a, an integrated discharge capacity acquisition unit 237b, a rated capacity acquisition unit 237c, an upper limit SOC acquisition unit 237d, an upper-limit-SOC-based correction coefficient calculation unit 237e, and a capacity turnover value computation unit 237f.

In a case where it is determined by the charge/discharge determination unit 236 that the lead-acid battery B is in the charge (n+1-th charge Cn+1) state, the previous capacity turnover value acquisition unit 237a acquires, from the recording unit 12, a capacity turnover value before the start of the processing in the state determination unit 13 (before the time point a1 in FIG. 3) (hereinafter, referred to as a previous CT value). The previous CT value is a CT value during operation calculated by the capacity turnover value calculation unit 138 at the time of the previous processing in the state determination unit 13, and already input from the capacity turnover value calculation unit 237 to the recording unit 12.

In addition, the integrated discharge capacity acquisition unit 237b acquires information regarding the integrated discharge capacity value from the start of the discharge of the lead-acid battery B calculated by the discharge current integration unit 234.

Further, the rated capacity acquisition unit 237c acquires information regarding the rated capacity (Ah) of the lead-acid battery B from the recording unit 12.

The upper limit SOC acquisition unit 237d acquires information regarding the upper limit SOC calculated by the upper limit SOC calculation unit 233.

The upper-limit-SOC-based correction coefficient calculation unit 237e calculates the upper-limit-SOC-based correction coefficient $K_{HSOC}$ by using the upper limit SOC acquired by the upper limit SOC acquisition unit 237d. The upper-limit-SOC-based correction coefficient $K_{HSOC}$ is calculated with reference to a graph illustrating a relationship between the upper limit SOC and the upper-limit-SOC-based correction coefficient $K_{HSOC}$ illustrated in FIG. 10. In FIG. 10, the upper-limit-SOC-based correction coefficient $K_{HSOC}$ between the respective numerical values is calculated by creating an approximation curve from values of two adjacent points.

Further, the capacity turnover value computation unit 237f calculates the CT value during operation by the following Formula (4) using the previous CT value acquired by the previous capacity turnover value acquisition unit 237a, the integrated discharge capacity from the start of the discharge of the lead-acid battery B acquired by the integrated discharge capacity acquisition unit 237b, the rated capacity (Ah) of the lead-acid battery B acquired by the rated capacity acquisition unit 237c, and the upper-limit-SOC-based correction coefficient $K_{HSOC}$ calculated by the upper-limit-SOC-based correction coefficient calculation unit 237e.

[Mathematical Formula 4]

$$\text{CT value during operation} = \text{Previous CT value} + \frac{\text{Integrated discharge capacity}}{\text{Rated capacity(Ah)}} \times K_{HSOC} \quad \cdots (4)$$

Then, the life estimation unit 238 estimates the remaining life of the lead-acid battery B by comparing the CT value from the beginning to the end of life acquired from the recording unit 12 with the CT value during operation calculated by the capacity turnover value calculation unit 237. That is, the life estimation unit 238 estimates the remaining life of the lead-acid battery B from a CT value obtained by subtracting the CT value during operation from the CT value from the beginning to the end of life.

Then, the life estimation unit 238 records an estimation result of the life estimation unit 238 including the CT value during operation in the recording unit 12.

As described above, in the lead-acid battery system S according to the second embodiment, the capacity turnover value calculation unit 237 calculates the CT value during operation by using the upper-limit-SOC-based correction coefficient $K_{HSOC}$ calculated based on the upper limit SOC calculated by the upper limit SOC calculation unit 134 that calculates the upper limit SOC, which is the SOC having the largest value when the lead-acid battery B is charged. As a result, the CT value during operation can be calculated in consideration of the upper limit SOC, the progress of corrosion of a positive electrode and softening of an active material due to electrolyte loss can be considered, and the lead-acid battery system S capable of accurately estimating the remaining life of the lead-acid battery can be provided.

In the lead-acid battery system S according to the second embodiment, the upper limit SOC calculation unit 233 calculates $SOC_{sta(n)}$ at the start of the discharge (n-th discharge Dn) of the lead-acid battery B to be subjected to calculation of the CT value during operation as the upper limit SOC, and the capacity turnover value calculation unit 138 calculates the upper-limit-SOC-based correction coefficient $K_{HSOC}$ based on the upper limit SOC calculated by the upper limit SOC calculation unit 134. As a result, the upper limit SOC can be determined and calculated at the start of the discharge (n-th discharge Dn) of the lead-acid battery B to be subjected to calculation of the CT value during operation, and the upper-limit-SOC-based correction coefficient $K_{HSOC}$ can be appropriately calculated based on the calculated upper limit SOC.

In the lead-acid battery system S according to the second embodiment, in a case where the lead-acid battery B is a bipolar lead-acid battery, it is possible to provide the lead-acid battery system S capable of accurately estimating the remaining life of the bipolar lead-acid battery.

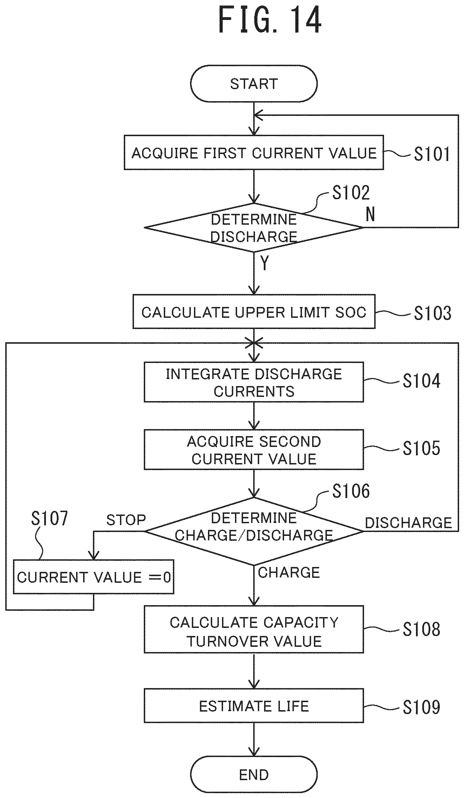

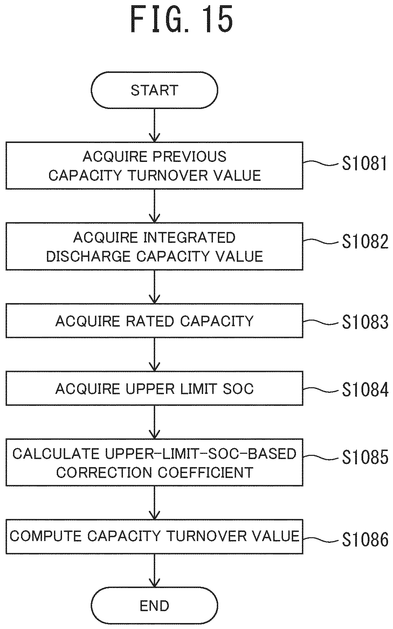

Next, a lead-acid battery life estimation method according to the second embodiment will be described with reference to a flowchart illustrating a flow of processing in the state determination unit illustrated in FIG. 14 and a flowchart illustrating a flow of processing of step S108 (capacity turnover value calculation step) in the flowchart of FIG. 14 illustrated in FIG. 15.

The state determination unit 13 starts the processing from the time point a1 in FIG. 3. First, as illustrated in FIG. 14, in step S101, the first current value acquisition unit 231 of the state determination unit 13 acquires, from the recording unit 12, information regarding the current value of the lead-acid battery B input to the recording unit 12 via the measurement unit 11 from the start to the end (the time point b1 in FIG. 3) of the processing in the state determination unit 13 (first current value acquisition step).

Next, in step S102, the discharge determination unit 232 determines whether or not the lead-acid battery B is in the discharge (n-th discharge Dn) state based on the current value of the lead-acid battery B acquired in step S101 (discharge determination step). Specifically, in a case where the current value of the lead-acid battery B acquired in step S101 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by the setting unit 14 and recorded in the recording unit 12, and the discharge determination unit 132 acquires information regarding the first threshold from the recording unit 12.

In a case where it is determined in step S102 that the lead-acid battery B is not in the discharge (n-th discharge Dn) state (the stop state or the charge (n-th charge Cn) state), the processing returns to step S101, and in a case where it is determined in step S102 that the lead-acid battery B is in the discharge (n-th discharge Dn) state, the processing proceeds to step S103.

In step S103, the upper limit SOC calculation unit 233 calculates the upper limit SOC, which is the SOC having the largest value when the lead-acid battery B is charged (upper limit SOC calculation step). Specifically, the upper limit SOC calculation unit 233 calculates $SOC_{sta(n)}$ at the start of the discharge (n-th discharge Dn) of the lead-acid battery B to be subjected to calculation of the capacity turnover value during operation, and sets the calculated $SOC_{sta(n)}$ as the upper limit SOC (see FIG. 3). Here, the upper limit SOC calculation unit 233 acquires, from the recording unit 12, the rated capacity of the lead-acid battery B, the total charge amount of the lead-acid battery B from completion of an equalization charge to a start time point of the n-th discharge Dn recorded in the recording unit 12 at the start of the n-th discharge Dn, and the total discharge amount (negative value) of the lead-acid battery B from the completion of the equalization charge to the start time point of the n-th discharge Dn recorded in the recording unit 12 at the start of the n-th discharge Dn, and calculates $SOC_{sta(n)}$ by Formula (2) described above.

Next, in step S104, the discharge current integration unit 234 integrates the discharge current values from the start of the discharge of the lead-acid battery B, and calculates the integrated discharge capacity value from the start of the discharge of the lead-acid battery B (integrated discharge capacity value calculation step).

Next, in step S105, the second current value acquisition unit 235 acquires, from the recording unit 12, information regarding the current value and the voltage value of the lead-acid battery B input to the recording unit 12 via the measurement unit 11 from the start to the end of the processing in the state determination unit 13 (second current value acquisition step).

Next, in step S106, the charge/discharge determination unit 236 determines whether the lead-acid battery B is in the discharge state, the stop state, or the charge state based on the current value of the lead-acid battery B acquired in step S105 (charge/discharge determination step).

Here, in a case where the current value of the lead-acid battery B acquired in step S105 is smaller than the first threshold (the current value < the first threshold), the charge/discharge determination unit 236 determines that the lead-acid battery B is in the discharge (n-th discharge Dn) state,

in a case where the first threshold ≤ the current value ≤ the second threshold, the charge/discharge determination unit 236 determines that the lead-acid battery B is in the stop state, and
in a case where the current value > the second threshold, the charge/discharge determination unit 236 determines that the lead-acid battery B is in the charge (n+1-th charge Cn+1) state.

The first threshold is the same value as the above-described first threshold, and the second threshold is a positive current value near 0 amperes.

In a case where the determination result in step S106 indicates the stop state, the current value is set to 0 in step S107, and the processing returns to step S104. In addition, in a case where the determination result in step S106 indicates the discharge state, the processing returns to step S104.

In addition, in a case where the determination result in step S106 indicates the charge (n+1-th charge Cn+1) state, the processing proceeds to step S108.

In step S108, the capacity turnover value calculation unit 237 calculates the CT value during operation (capacity turnover value calculation step).

A detailed flow of processing in the capacity turnover value calculation unit 237 in step S108 will be described with reference to FIG. 15. FIG. 15 is a flowchart illustrating a flow of processing of step S108 (capacity turnover value calculation step) in the flowchart illustrated in FIG. 14.

First, in step S1081, the previous capacity turnover value acquisition unit 237a acquires the CT value before the start of the processing in the state determination unit 13 (before the time point a1 in FIG. 3) from the recording unit 12 (previous CT value acquisition step). The previous CT value is a CT value during operation calculated in step S9 at the time of the previous processing in the state determination unit 13, and already input from the capacity turnover value calculation unit 237 to the recording unit 12.

Next, in step S1082, the integrated discharge capacity acquisition unit 237b acquires information regarding the integrated discharge capacity value from the start of the discharge of the lead-acid battery B calculated in step S104 (integrated discharge capacity value acquisition step).

Next, in step S1083, the rated capacity acquisition unit 237c acquires information regarding the rated capacity (Ah) of the lead-acid battery B from the recording unit 12 (rated capacity acquisition step).

In step S1084, the upper limit SOC acquisition unit 237d acquires information regarding the upper limit SOC calculated in step S103 (upper limit SOC acquisition step).

Next, in step S1085, the upper-limit-SOC-based correction coefficient calculation unit 237e calculates the upper-limit-SOC-based correction coefficient $K_{HSOC}$ by using the upper limit SOC acquired in step S1084 (upper-limit-SOC-based correction coefficient calculation step). As described above, the upper-limit-SOC-based correction coefficient

$K_{HSOC}$ is calculated with reference to a graph illustrating a relationship between the upper limit SOC and the upper-limit-SOC-based correction coefficient $K_{HSOC}$ illustrated in FIG. 10. In FIG. 10, the upper-limit-SOC-based correction coefficient $K_{HSOC}$ between the respective numerical values is calculated by creating an approximation curve from values of two adjacent points.

In step S1086, the capacity turnover value computation unit 237f calculates the CT value during operation by Formula (4) using the previous CT value acquired in step 1081, the integrated discharge capacity from the start of the discharge of the lead-acid battery B acquired in step S1082, the rated capacity (Ah) of the lead-acid battery B acquired in step S1083, and the upper-limit-SOC-based correction coefficient $K_{HSOC}$ calculated in step S1085 (capacity turnover value computation step).

As a result, the processing in the capacity turnover value calculation unit 237 in step S108 ends.

In step S109, the life estimation unit 238 of the state determination unit 13 estimates the remaining life of the lead-acid battery B by comparing the CT value from the beginning to the end of life acquired from the recording unit 12 with the CT value during operation calculated in step S108 (life estimation step). That is, the life estimation unit 238 estimates the remaining life of the lead-acid battery B from a CT value obtained by subtracting the CT value during operation from the CT value from the beginning to the end of life.

Then, the life estimation unit 238 records an estimation result of the life estimation unit 238 including the CT value during operation in the recording unit 12.

Accordingly, the processing in the state determination unit 13 ends.

As described above, in the lead-acid battery life estimation method according to the second embodiment, in the capacity turnover value calculation step (step S108), the CT value during operation is calculated using the upper-limit-SOC-based correction coefficient $K_{HSOC}$ calculated based on the upper limit SOC calculated in the upper limit SOC calculation step (step S103) of calculating the upper limit SOC, which is the SOC having the largest value when the lead-acid battery B is charged. As a result, the CT value during operation can be calculated in consideration of the upper limit SOC, the progress of corrosion of a positive electrode and softening of an active material due to electrolyte loss can be considered, and the lead-acid battery life estimation method capable of accurately estimating the remaining life of the lead-acid battery can be provided.

In the lead-acid battery life estimation method according to the second embodiment, in the upper limit SOC calculation step (step S103), $SOC_{sta(n)}$ at the start of the discharge (n-th discharge Dn) of the lead-acid battery B to be subjected to calculation of the CT value during operation is calculated as the upper limit SOC, and in the capacity turnover value calculation step (step S108), the upper-limit-SOC-based correction coefficient $K_{HSOC}$ is calculated based on the upper limit SOC calculated in the upper limit SOC calculation step (step S103). As a result, the upper limit SOC can be determined and calculated at the start of the discharge (n-th discharge Dn) of the lead-acid battery B to be subjected to calculation of the CT value during operation, and the upper-limit-SOC-based correction coefficient $K_{HSOC}$ can be appropriately calculated based on the calculated upper limit SOC.

In the lead-acid battery life estimation method according to the second embodiment, in a case where the lead-acid battery B is a bipolar lead-acid battery, it is possible to provide a lead-acid battery life estimation method capable of accurately estimating the remaining life of the bipolar lead-acid battery.

(Third Embodiment)

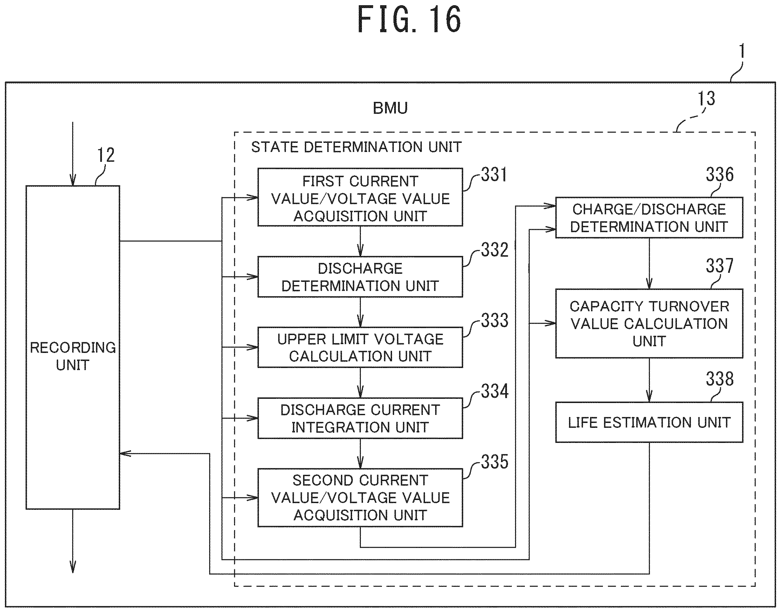

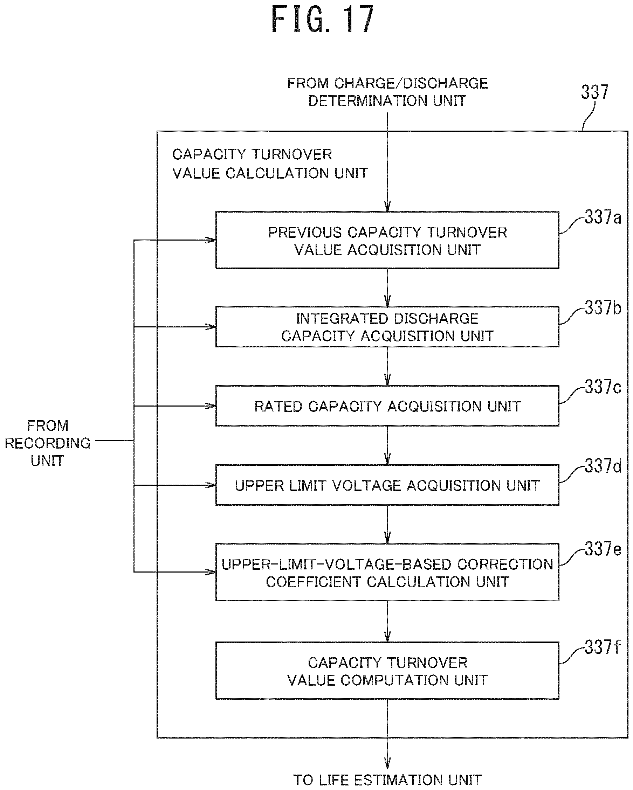

Next, the lead-acid battery system according to the third embodiment of the present invention will be described with reference to FIGS. 16 and 17. FIG. 16 is a block diagram illustrating internal configurations of a recording unit and a state determination unit included in the BMU illustrated in FIG. 2 in the lead-acid battery system according to the third embodiment of the present invention. FIG. 17 is a block diagram illustrating an internal configuration of a capacity turnover value calculation unit included in the state determination unit illustrated in FIG. 16.

The lead-acid battery system S according to the third embodiment has the same basic configuration as the lead-acid battery system S according to the first embodiment, and is different from the lead-acid battery system S according to the first embodiment in a configuration of a state determination unit 13.

The state determination unit 13 in the lead-acid battery system S according to the first embodiment calculates a capacity turnover value during operation by using both an upper-limit-SOC-based correction coefficient $K_{HSOC}$ calculated based on a calculated upper limit SOC, which is an SOC having the largest value when a lead-acid battery B is charged, and an upper-limit-voltage-based correction coefficient $K_{HV}$ calculated based on a calculated upper limit voltage, which is the highest voltage when the lead-acid battery B is charged.

On the other hand, the state determination unit 13 in the lead-acid battery system S according to the third embodiment is different in that the capacity turnover value during operation is calculated using only the upper-limit-voltage-based correction coefficient $K_{HV}$ out of the upper-limit-SOC-based correction coefficient $K_{HSOC}$ and the upper-limit-voltage-based correction coefficient $K_{HV}$.

Further, similarly to the state determination unit 13 of the first embodiment, as illustrated in FIG. 4, the state determination unit 13 of the third embodiment calculates a peak voltage $V_{pp,end(n)}$ at the end of a charge (n-th charge Cn) immediately before a discharge (n-th discharge Dn) of the lead-acid battery B to be subjected to calculation of the capacity turnover value during operation as the upper limit voltage.

As illustrated in FIG. 4, the processing in the state determination unit 13 in the lead-acid battery system S according to the third embodiment is executed from a time point a1 at the time of the n-th charge Cn of the lead-acid battery B to a time point b1 after the end of the n-th discharge Dn, and the processing is repeated at the time of charging and discharging.

Therefore, as illustrated in FIG. 16, the state determination unit 13 of the third embodiment includes a first current value/voltage value acquisition unit 331, a discharge determination unit 332, an upper limit voltage calculation unit 333, a discharge current integration unit 334, a second current value/voltage value acquisition unit 335, a charge/discharge determination unit 336, a capacity turnover value calculation unit 337, and a life estimation unit 338 in order to estimate the remaining life of the lead-acid battery B.

The first current value/voltage value acquisition unit 331 acquires, from a recording unit 12, information regarding a current value of the lead-acid battery B and information regarding a voltage value $V_{meas}$ input to the recording unit 12 via the measurement unit 11 from the start to the end of the processing in the state determination unit 13.

In addition, the discharge determination unit 332 determines whether or not the lead-acid battery B is in the discharge (n-th discharge Dn) state based on the current value of the lead-acid battery B acquired by the first current value/voltage value acquisition unit 331. Specifically, in a case where the current value of the lead-acid battery B acquired by the first current value/voltage value acquisition unit 331 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n-th charge Cn) state). Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by a setting unit 14 and recorded in the recording unit 12, and the discharge determination unit 332 acquires information regarding the first threshold from the recording unit 12.

The upper limit voltage calculation unit 333 calculates the upper limit voltage which is the highest voltage when the lead-acid battery B is charged. More specifically, in a case where the determination result of the discharge determination unit 332 indicates that the lead-acid battery B is not in the discharge (n-th discharge Dn) state (the stop state or the charge (n-th charge Cn) state), it is determined whether or not the voltage value ($V_{meas}$) acquired by the first current value/voltage value acquisition unit 331 exceeds a voltage already set as a peak voltage $V_{pp}$ acquired from the recording unit 12. In a case where the voltage value ($V_{meas}$) exceeds the peak voltage $V_{pp}$, the voltage value ($V_{meas}$) is newly set as the peak voltage $V_{pp}$, and in a case where the voltage value ($V_{meas}$) does not exceed the peak voltage $V_{pp}$, the voltage already set as the peak voltage $V_{pp}$ is set as the peak voltage $V_{pp}$. This setting is repeated until it is determined that the current value acquired by the first current value/voltage value acquisition unit 331 indicates the discharge state, and the finally set peak voltage $V_{pp}$ is calculated as the peak voltage $V_{pp}$. That is, the upper limit voltage calculation unit 333 calculates the peak voltage $V_{pp,end(n)}$ at the end of the charge (n-th charge Cn) immediately before the discharge (n-th discharge Dn) of the lead-acid battery B to be subjected to calculation of the capacity turnover value during operation (see FIG. 4), and sets the calculated peak voltage $V_{pp,end(n)}$ as the upper limit voltage.

In a case where it is determined by the discharge determination unit 332 that the lead-acid battery B is in the discharge (n-th discharge Dn) state, the discharge current integration unit 334 integrates discharge current values from the start of the discharge of the lead-acid battery B, and calculates an integrated discharge capacity value from the start of the discharge of the lead-acid battery B.

In addition, the second current value/voltage value acquisition unit 335 acquires, from the recording unit 12, information regarding the current value and the voltage value of the lead-acid battery B input to the recording unit 12 via the measurement unit 11 from the start to the end of the processing in the state determination unit 13.

In addition, the charge/discharge determination unit 336 determines whether the lead-acid battery B is in a discharge state, the stop state, or the charge state based on the current value of the lead-acid battery B acquired by the second current value/voltage value acquisition unit 335.

Here, in a case where the current value of the lead-acid battery B acquired by the second current value/voltage value acquisition unit 335 is smaller than the first threshold (the current value < the first threshold), the charge/discharge determination unit 336 determines that the lead-acid battery B is in the discharge (n-th discharge Dn) state,

in a case where the first threshold ≤ the current value ≤ the second threshold, the charge/discharge determination unit 336 determines that the lead-acid battery B is in the stop state, and

in a case where the current value > the second threshold, the charge/discharge determination unit 336 determines that the lead-acid battery B is in the charge (n+1-th charge Cn+1) state.

The first threshold is the same value as the above-described first threshold, and the second threshold is a positive current value near 0 amperes.

Next, in a case where the determination result of the charge/discharge determination unit 336 indicates that the lead-acid battery B is in the charge (n+1-th charge Cn+1) state, the capacity turnover value calculation unit 337 calculates the capacity turnover value during operation (hereinafter, referred to as a CT value during operation).

As illustrated in FIG. 17, the capacity turnover value calculation unit 337 includes a previous capacity turnover value acquisition unit 337a, an integrated discharge capacity acquisition unit 337b, a rated capacity acquisition unit 337c, an upper limit voltage acquisition unit 337d, an upper-limit-voltage-based correction coefficient calculation unit 337e, and a capacity turnover value computation unit 337f.

In a case where it is determined by the charge/discharge determination unit 336 that the lead-acid battery B is in the charge (n+1-th charge Cn+1) state, the previous capacity turnover value acquisition unit 337a acquires, from the recording unit 12, a capacity turnover value before the start of the processing in the state determination unit 13 (before the time point a1 in FIG. 3) (hereinafter, referred to as a previous CT value). The previous CT value is a CT value during operation calculated by the capacity turnover value calculation unit 337 at the time of the previous processing in the state determination unit 13, and already input from the capacity turnover value calculation unit 337 to the recording unit 12.

In addition, the integrated discharge capacity acquisition unit 337b acquires information regarding the integrated discharge capacity value from the start of the discharge of the lead-acid battery B calculated by the discharge current integration unit 334.

Further, the rated capacity acquisition unit 337c acquires information regarding the rated capacity (Ah) of the lead-acid battery B from the recording unit 12.

The upper limit voltage acquisition unit 337d acquires information regarding the upper limit voltage calculated by the upper limit voltage calculation unit 333.

The upper-limit-voltage-based correction coefficient calculation unit 337e calculates the upper-limit-voltage-based correction coefficient $K_{HV}$ by using the upper limit voltage acquired by the upper limit voltage acquisition unit 337d. The upper-limit-voltage-based correction coefficient $K_{HV}$ is calculated with reference to a graph illustrating a relationship between the upper limit voltage and the upper-limit-voltage-based correction coefficient $K_{HV}$ illustrated in FIG. 11. Here, in FIG. 11, the upper-limit-voltage-based correction coefficient $K_{HV}$ between the respective numerical values is calculated by creating an approximation curve from values of two adjacent points. However, in a case where the upper limit voltage is 57 V or less, the upper-limit-voltage-based correction coefficient $K_{HV} = 1$, which is constant.

Further, the capacity turnover value computation unit 337f calculates the CT value during operation by the following Formula (5) using the previous CT value acquired by the previous capacity turnover value acquisition unit 337a, the integrated discharge capacity from the start of the discharge of the lead-acid battery B acquired by the integrated discharge capacity acquisition unit 337b, the rated capacity (Ah) of the lead-acid battery B acquired by the rated capacity acquisition unit 337c, and the upper-limit-voltage-based correction coefficient $_{HV}$ based on the upper limit voltage calculated by the upper-limit-voltage-based correction coefficient calculation unit 337e.

[Mathematical Formula 5]

$$\text{CT value during operation} = \text{Previous CT value} + \frac{\text{Integrated discharge capacity}}{\text{Rated capacity(Ah)}} \times K_{HV} \quad \cdots (5)$$

Then, the life estimation unit 338 estimates the remaining life of the lead-acid battery B by comparing the CT value from the beginning to the end of life acquired from the recording unit 12 with the CT value during operation calculated by the capacity turnover value calculation unit 337. That is, the life estimation unit 338 estimates the remaining life of the lead-acid battery B from a CT value obtained by subtracting the CT value during operation from the CT value from the beginning to the end of life.

Then, the life estimation unit 338 records an estimation result of the life estimation unit 338 including the CT value during operation in the recording unit 12. The life estimation unit 338 sets the peak voltage $V_{pp}$ calculated by the upper limit voltage calculation unit 333 to 0 and records the peak voltage $V_{pp}$ in the recording unit 12.

As described above, in the lead-acid battery system S according to the third embodiment, the capacity turnover value calculation unit 337 calculates the CT value during operation by using the upper-limit-voltage-based correction coefficient $K_{HV}$ calculated based on the upper limit voltage calculated by the upper limit voltage calculation unit 133 that calculates the upper limit voltage which is the highest voltage when the lead-acid battery B is charged. As a result, the CT value during operation can be calculated in consideration of the upper limit voltage, the progress of corrosion of a positive electrode and softening of an active material due to electrolyte loss can be considered, and the lead-acid battery system S capable of accurately estimating the remaining life of the lead-acid battery can be provided.

In the lead-acid battery system S according to the third embodiment, the upper limit voltage calculation unit 333 calculates the peak voltage $V_{pp,end(n)}$ at the end of the charge (n-th charge Cn) immediately before the discharge (n-th discharge Dn) of the lead-acid battery B to be subjected to calculation of the CT value during operation as the upper limit voltage, and the capacity turnover value calculation unit 337 calculates the upper-limit-voltage-based correction coefficient $K_{HV}$ based on the upper limit voltage calculated by the upper limit voltage calculation unit 333. As a result, the upper limit voltage can be calculated by calculating the peak voltage $V_{pp}$, at the end of the charge (n-th charge Cn) immediately before the discharge (n-th discharge Dn) of the lead-acid battery B to be subjected to calculation of the CT value during operation, and the upper-limit-voltage-based correction coefficient $K_{HV}$ can be appropriately calculated based on the calculated upper limit voltage.

In the lead-acid battery system S according to the third embodiment, in a case where the lead-acid battery B is a bipolar lead-acid battery, it is possible to provide the lead-acid battery system S capable of accurately estimating the remaining life of the bipolar lead-acid battery.

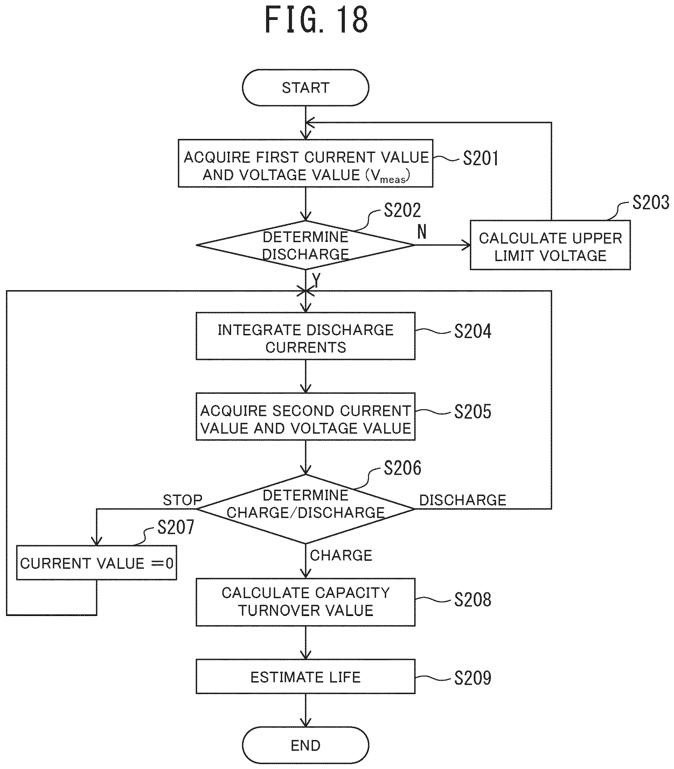

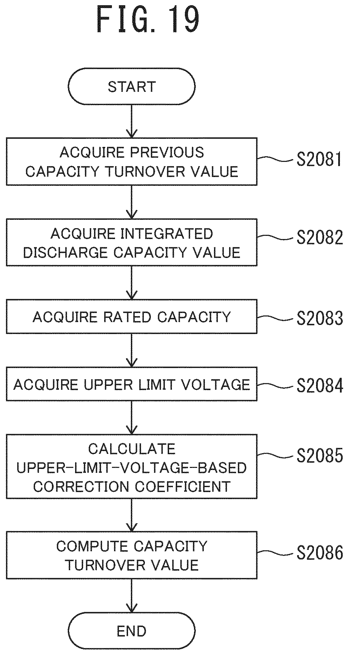

Next, a lead-acid battery life estimation method according to the third embodiment will be described with reference to a flowchart illustrating a flow of processing in the state determination unit illustrated in FIG. 18 and a flowchart illustrating a flow of processing of step S208 (capacity turnover value calculation step) in the flowchart of FIG. 18 illustrated in FIG. 19.

The state determination unit 13 starts the processing from the time point a1 in FIG. 4. First, as illustrated in FIG. 18, in step S201, the first current value/voltage value acquisition unit 331 of the state determination unit 13 acquires, from the recording unit 12, information regarding the current value and the voltage value ($V_{meas}$) of the lead-acid battery B input to the recording unit 12 via the measurement unit 11 from the start to the end (the time point b1 in FIG. 4) of the processing in the state determination unit 13 (first current value/voltage value acquisition step).

Next, in step S202, the discharge determination unit 332 determines whether or not the lead-acid battery B is in the discharge (n-th discharge Dn) state based on the current value of the lead-acid battery B acquired in step S201 (discharge determination step). Specifically, in a case where the current value of the lead-acid battery B acquired in step S201 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by the setting unit 14 and recorded in the recording unit 12, and the discharge determination unit 132 acquires information regarding the first threshold from the recording unit 12.

In a case where it is determined in step S202 that the lead-acid battery B is not in the discharge (n-th discharge Dn) state (the stop state or the charge (n-th charge Cn) state), the processing proceeds to step S203, and in a case where it is determined in step S202 that the lead-acid battery B is in the discharge (n-th discharge Dn) state, the processing proceeds to step S204.

Then, in step S203, the upper limit voltage calculation unit 333 calculates the upper limit voltage which is the highest voltage when the lead-acid battery B is charged (upper limit voltage calculation step). More specifically, it is determined whether or not the voltage value ($V_{meas}$) acquired in step S201 exceeds the voltage already set as the peak voltage $V_{pp}$ acquired from the recording unit 12. In a case where the voltage value ($V_{meas}$) exceeds the peak voltage $V_{pp}$, the voltage value ($V_{meas}$) is newly set as the peak voltage $V_{pp}$. In a case where the voltage value ($V_{meas}$) does not exceed the peak voltage $V_{pp}$, the voltage value already set as the peak voltage $V_{pp}$ is set as the peak voltage $V_{pp}$. Then, this setting is repeated until it is determined that the current value acquired in step S201 indicates the discharge state in step S202, and the finally set peak voltage $V_{pp}$ is calculated as the peak voltage $V_{pp}$. That is, in step S203, the upper limit voltage calculation unit 333 calculates the peak voltage $V_{pp,end(n)}$ at the end of the charge (n-th charge Cn) immediately before the discharge (n-th discharge Dn) of the lead-acid battery B to be subjected to calculation of the capacity turnover value during operation (see FIG. 4), and sets the calculated peak voltage $V_{pp,end(n)}$ as the upper limit voltage.

Next, in step S204, the discharge current integration unit 334 integrates the discharge current values from the start of the discharge of the lead-acid battery B, and calculates the integrated discharge capacity value from the start of the discharge of the lead-acid battery B (integrated discharge capacity value calculation step).

Next, in step S205, the second current value/voltage value acquisition unit 335 acquires, from the recording unit 12, information regarding the current value and the voltage value of the lead-acid battery B input to the recording unit 12 via the measurement unit 11 from the start to the end of the processing in the state determination unit 13 (second current value/voltage value acquisition step).

Next, in step S206, the charge/discharge determination unit 336 determines whether the lead-acid battery B is in the discharge state, the stop state, or the charge state based on the current value of the lead-acid battery B acquired in step S205 (charge/discharge determination step).

Here, in a case where the current value of the lead-acid battery B acquired in step S205 is smaller than the first threshold (the current value < the first threshold), the charge/discharge determination unit 336 determines that the lead-acid battery B is in the discharge (n-th discharge Dn) state,

in a case where the first threshold ≤ the current value ≤ the second threshold, the charge/discharge determination unit 336 determines that the lead-acid battery B is in the stop state, and
in a case where the current value > the second threshold, the charge/discharge determination unit 336 determines that the lead-acid battery B is in the charge (n+1-th charge Cn+1) state.

The first threshold and the second threshold are the same as the first threshold and the second threshold described above.

In a case where the determination result in step S206 indicates the stop state, the current value is set to 0 in step S207, and the processing returns to step S204.

In addition, in a case where the determination result in step 206 indicates the discharge state, the processing returns to step S204.

In addition, in a case where the determination result in step S206 indicates the charge (n+1-th charge Cn+1) state, the processing proceeds to step S208.

In step S208, the capacity turnover value calculation unit 337 calculates the CT value during operation (capacity turnover value calculation step).

A detailed flow of processing in the capacity turnover value calculation unit 337 in step S208 will be described with reference to FIG. 19. FIG. 19 is a flowchart illustrating a flow of processing of step S208 (capacity turnover value calculation step) in the flowchart illustrated in FIG. 18.

First, in step S2081, the previous capacity turnover value acquisition unit 337a acquires the CT value before the start of the processing in the state determination unit 13 (before the time point a1 in FIG. 3) from the recording unit 12 (previous CT value acquisition step). The previous CT value is a CT value during operation calculated in step S208 at the time of the previous processing in the state determination unit 13, and already input from the capacity turnover value calculation unit 337 to the recording unit 12.

Next, in step S2082, the integrated discharge capacity acquisition unit 337b acquires information regarding the integrated discharge capacity value from the start of the discharge of the lead-acid battery B calculated in step S204 (integrated discharge capacity value acquisition step).

Next, in step S2083, the rated capacity acquisition unit 337c acquires information regarding the rated capacity (Ah) of the lead-acid battery B from the recording unit 12 (rated capacity acquisition step).

Next, in step S2084, the upper limit voltage acquisition unit 337d acquires information regarding the upper limit voltage calculated in step S203 (upper limit voltage acquisition step).

Next, in step S2085, the upper-limit-voltage-based correction coefficient calculation unit 337e calculates the upper-limit-voltage-based correction coefficient $K_{HV}$ by using the upper limit voltage acquired in step S2084 (upper-limit-voltage-based correction coefficient calculation step). As described above, the upper-limit-voltage-based correction coefficient $K_{HV}$ is calculated with reference to a graph illustrating a relationship between the upper limit voltage and the upper-limit-voltage-based correction coefficient $K_{HV}$ illustrated in FIG. 11. Here, in FIG. 11, the upper-limit-voltage-based correction coefficient $K_{HV}$ between the respective numerical values is calculated by creating an approximation curve from values of two adjacent points. However, in a case where the upper limit voltage is 57 V or less, the upper-limit-voltage-based correction coefficient $K_{HV} = 1$, which is constant.

Then, in step S2086, the capacity turnover value computation unit 337f calculates the CT value during operation by Formula (5) using the previous CT value acquired in step S2081, the integrated discharge capacity from the start of the discharge of the lead-acid battery B acquired in step S2082, the rated capacity (Ah) of the lead-acid battery B acquired in step S2083, and the upper-limit-voltage-based correction coefficient $_{HV}$ calculated in step S2085 (capacity turnover value computation step).

As a result, the processing in the capacity turnover value calculation unit 337 in step S208 ends.

In step S209, the life estimation unit 338 of the state determination unit 13 estimates the remaining life of the lead-acid battery B by comparing the CT value from the beginning to the end of life acquired from the recording unit 12 with the CT value during operation calculated in step S208. That is, the life estimation unit 338 estimates the remaining life of the lead-acid battery B from a CT value obtained by subtracting the CT value during operation from the CT value from the beginning to the end of life (life estimation step).

Then, the life estimation unit 338 records an estimation result of the life estimation unit 338 including the CT value during operation in the recording unit 12. The life estimation unit 338 sets the peak voltage $V_{pp}$ calculated in step S203 to 0 and records the peak voltage $V_{pp}$ in the recording unit 12.

Accordingly, the processing in the state determination unit 13 ends.

As described above, in the lead-acid battery life estimation method according to the third embodiment, in the capacity turnover value calculation step (step S208), the CT value during operation is calculated using the upper-limit-voltage-based correction coefficient $K_{HV}$ calculated based on the upper limit voltage calculated in the upper limit voltage calculation step (step S203) of calculating the upper limit voltage which is the highest voltage when the lead-acid battery B is charged. As a result, the CT value during operation can be calculated in consideration of the upper limit voltage, the progress of corrosion of a positive electrode and softening of an active material due to electrolyte loss can be considered, and the lead-acid battery life estimation method capable of accurately estimating the remaining life of the lead-acid battery can be provided.

In the lead-acid battery life estimation method according to the third embodiment, in the upper limit voltage calculation step (step S203), the peak voltage $V_{pp,end(n)}$ at the end of the charge (n-th charge Cn) immediately before the discharge (n-th discharge Dn) of the lead-acid battery B to be subjected to calculation of the CT value during operation is calculated as the upper limit voltage, and in the capacity turnover value calculation step (step S208), the upper-limit-voltage-based correction coefficient $K_{HV}$ is calculated based on the upper limit voltage calculated in the upper limit voltage calculation step (step S203). As a result, the upper limit voltage can be calculated by calculating the peak voltage $V_{pp,end(n)}$ at the end of the charge (n-th charge Cn) immediately before the discharge (n-th discharge Dn) of the lead-acid battery B to be subjected to calculation of the CT value during operation, and the upper-limit-voltage-based correction coefficient $K_{HV}$ can be appropriately calculated based on the calculated upper limit voltage.

In the lead-acid battery life estimation method according to the third embodiment, in a case where the lead-acid battery B is a bipolar lead-acid battery, it is possible to provide a lead-acid battery life estimation method capable of accurately estimating the remaining life of the bipolar lead-acid battery.

(Fourth Embodiment)

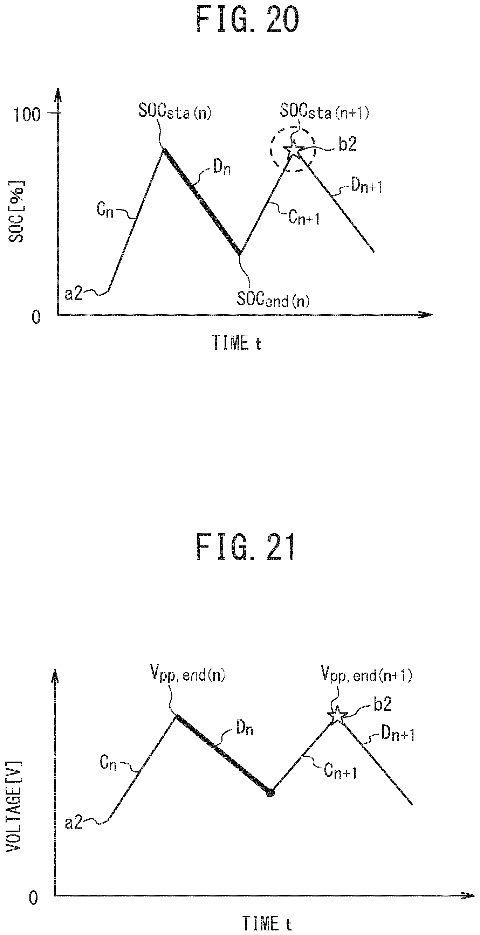

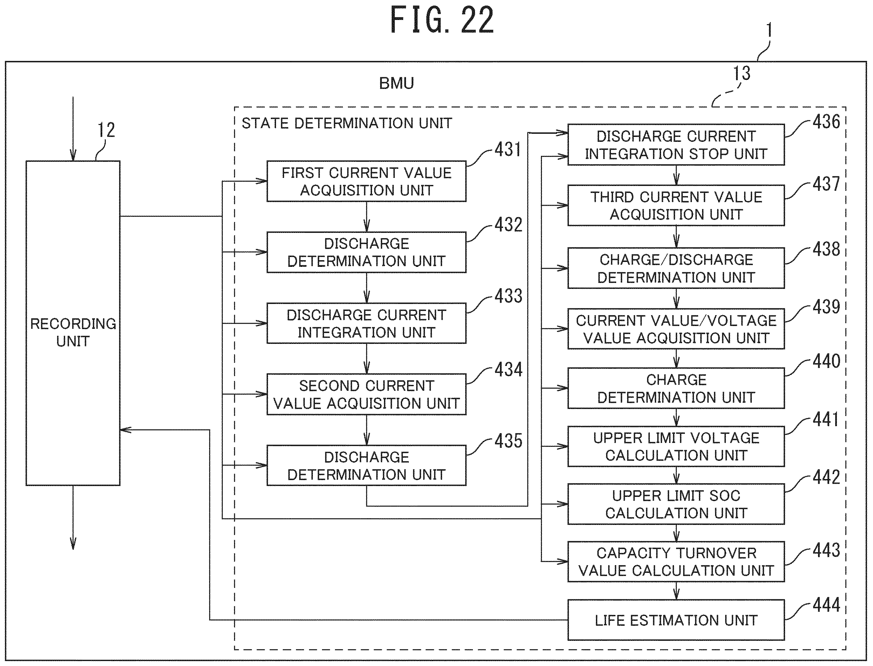

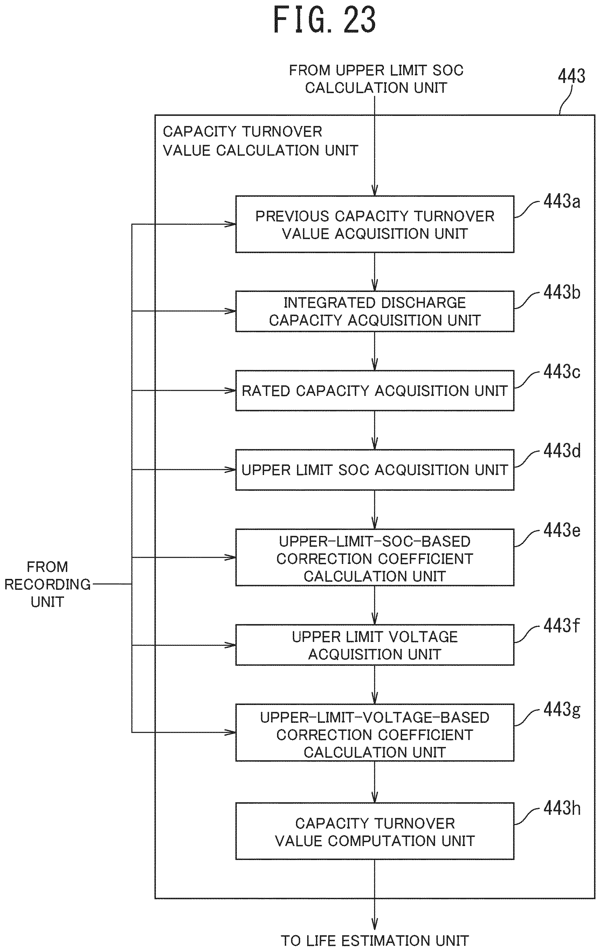

Next, the lead-acid battery system according to the fourth embodiment of the present invention will be described with reference to FIGS. 20 to 23. FIG. 20 is a diagram for describing start and end timings of processing in a state determination unit and calculation of an SOC at the end of the next charge after the end of a discharge of a lead-acid battery to be subjected to calculation of a capacity turnover value during operation as an upper limit SOC in the lead-acid battery systems according to the fourth to sixth embodiments of the present invention. FIG. 21 is a diagram for describing start and end timings of processing in the state determination unit and calculation of a peak voltage at the end of the next charge after the end of the discharge of the lead-acid battery to be subjected to calculation of the capacity turnover value during operation as an upper limit voltage in the lead-acid battery systems according to the fourth to sixth embodiments of the present invention. FIG. 22 is a block diagram illustrating internal configurations of a recording unit and the state determination unit included in the BMU illustrated in FIG. 2 in the lead-acid battery system according to the fourth embodiment of the present invention. FIG. 23 is a block diagram illustrating an internal configuration of a capacity turnover value calculation unit included in the state determination unit illustrated in FIG. 22.

The lead-acid battery system S according to the fourth embodiment has the same basic configuration as the lead-acid battery system S according to the first embodiment, and is different from the lead-acid battery system S according to the first embodiment in a configuration of a state determination unit 13.

Similarly to the state determination unit 13 of the first embodiment, the state determination unit 13 of the fourth embodiment calculates the capacity turnover value during operation by using both an upper-limit-SOC-based correction coefficient $K_{HSOC}$ calculated based on a calculated upper limit state of charge (SOC), which is an SOC having the largest value when a lead-acid battery B is charged, and an upper-limit-voltage-based correction coefficient $K_{HV}$ calculated based on a calculated upper limit voltage, which is the highest voltage when the lead-acid battery B is charged.

However, unlike the state determination unit 13 of the first embodiment, as illustrated in FIG. 20, the state determination unit 13 of the fourth embodiment calculates $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC.

In addition, unlike the state determination unit 13 of the first embodiment, as illustrated in FIG. 21, the state determination unit 13 of the fourth embodiment calculates a peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation as the upper limit voltage.

As illustrated in FIGS. 20 and 21, the processing in the state determination unit 13 in the lead-acid battery system S according to the fourth embodiment is executed from a time point a2 at the time of the n-th charge Cn of the lead-acid battery B to a time point b2 after the end of the n+1-th charge Cn+1, and the processing is repeated at the time of charging and discharging.

Therefore, as illustrated in FIG. 22, the state determination unit 13 of the fourth embodiment includes a first current value acquisition unit 431, a discharge determination unit 432, a discharge current integration unit 433, a second current value acquisition unit 434, a discharge determination unit 435, a discharge current integration stop unit 436, a third current value acquisition unit 437, a charge/discharge determination unit 438, a current value/voltage value acquisition unit 439, a charge determination unit 440, an upper limit voltage calculation unit 441, an upper limit SOC calculation unit 442, a capacity turnover value calculation unit 443, and a life estimation unit 444 in order to estimate the remaining life of the lead-acid battery B.

The first current value acquisition unit 431 acquires, from a recording unit 12, information regarding a current value of the lead-acid battery B input to the recording unit 12 via a measurement unit 11 from the start to the end of the processing in the state determination unit 13.

In addition, the discharge determination unit 432 determines whether or not the lead-acid battery B is in a discharge (n-th discharge Dn) state based on the current value of the lead-acid battery B acquired by the first current value acquisition unit 431. Specifically, in a case where the current value of the lead-acid battery B acquired by the first current value acquisition unit 431 is smaller than a first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n-th charge Cn) state). Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by a setting unit 14 and recorded in the recording unit 12, and the discharge determination unit 432 acquires information regarding the first threshold from the recording unit 12.

In a case where it is determined by the discharge determination unit 432 that the lead-acid battery B is in the discharge (n-th discharge Dn) state, the discharge current integration unit 433 integrates discharge current values from the start of the discharge of the lead-acid battery B, and calculates an integrated discharge capacity value from the start of the discharge of the lead-acid battery B.

The second current value acquisition unit 434 acquires, from the recording unit 12, information regarding the current value of the lead-acid battery B input to the recording unit 12 via the measurement unit 11 from the start to the end of the processing in the state determination unit 13.

In addition, the discharge determination unit 435 determines whether or not the lead-acid battery B is in a discharge (n-th discharge Dn) state based on the current value of the lead-acid battery B acquired by the second current value acquisition unit 434. Specifically, in a case where the current value of the lead-acid battery B acquired by the second current value acquisition unit 434 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n+1-th charge Cn+1) state). The first threshold is a value similar to the first threshold described above. The first threshold for the discharge determination is set by a setting unit 14 and recorded in the recording unit 12, and the discharge determination unit 435 acquires information regarding the first threshold from the recording unit 12.

In a case where it is determined by the discharge determination unit 435 that the lead-acid battery B is not in the discharge (n-th discharge Dn) state (the stop state or the charge (n+1-th charge Cn+1) state), the discharge current integration stop unit 436 stops integration of the discharge current values integrated by discharge current integration unit 433, and calculates the integrated discharge capacity value again.

The third current value acquisition unit 437 acquires, from the recording unit 12, information regarding the current value of the lead-acid battery B input to the recording unit 12 via the measurement unit 11 from the start to the end of the processing in the state determination unit 13.

In addition, the charge/discharge determination unit 438 determines whether the lead-acid battery B is in a discharge state, the stop state, or the charge state based on the current value of the lead-acid battery B acquired by the third current value acquisition unit 437.

Here, in a case where the current value of the lead-acid battery B acquired by the third current value acquisition unit 437 is smaller than the first threshold (the current value < the first threshold), the charge/discharge determination unit 438 determines that the lead-acid battery B is in the discharge (n-th discharge Dn) state,

in a case where the first threshold ≤ the current value ≤ a second threshold, the charge/discharge determination unit 438 determines that the lead-acid battery B is in the stop state, and

in a case where the current value > the second threshold, the charge/discharge determination unit 438 determines that the lead-acid battery B is in the charge (n+1-th charge Cn+1) state.

The first threshold is the same value as the above-described first threshold, and the second threshold is a positive current value near 0 amperes.

Further, the current value/voltage value acquisition unit 439 acquires, from the recording unit 12, information regarding the current value of the lead-acid battery B and information regarding a voltage value $V_{meas}$ input to the recording unit 12 via the measurement unit 11 from the start to the end of the processing in the state determination unit 13.

In addition, the charge determination unit 440 determines whether or not the lead-acid battery B is in the charge state based on the current value of the lead-acid battery B acquired by the current value/voltage value acquisition unit 439.

Here, in a case where the current value of the lead-acid battery B acquired by the current value/voltage value acquisition unit 439 is smaller than the second threshold (the current value ≤ the second threshold), the charge determination unit 440 determines that the lead-acid battery B is not in the charge state (the lead-acid battery B is in the discharge (n+1-th discharge Dn+1) state),

in a case where the current value = the second threshold, the charge determination unit 440 determines that the lead-acid battery B is not in the charge state (the stop state), and
in a case where the current value > the second threshold, the charge determination unit 440 determines that the lead-acid battery B is in the charge (n+1-th charge Cn+1) state.

The first threshold and the second threshold are the same values as those described above.

The upper limit voltage calculation unit 441 calculates the upper limit voltage which is the highest voltage when the lead-acid battery B is charged. More specifically, in a case where it is determined by the charge determination unit 440 that the determination result indicates the charge (n+1-th charge Cn+1) state, similarly to the upper limit voltage calculation unit 133 of the first embodiment, it is determined whether or not the voltage value ($V_{meas}$) acquired by the current value/voltage value acquisition unit 439 exceeds a voltage already set as the peak voltage $V_{pp}$ acquired from the recording unit 12. In a case where the voltage value ($V_{meas}$) exceeds the peak voltage $V_{pp}$, the voltage value ($V_{meas}$) is newly set as the peak voltage $V_{pp}$, and in a case where the voltage value ($V_{meas}$) does not exceed the peak voltage $V_{pp}$, the voltage value already set as the peak voltage $V_{pp}$ is set as the peak voltage $V_{pp}$. Then, this setting is repeated until it is determined that the current value acquired by the current value/voltage value acquisition unit 439 indicates that the lead-acid battery B is not in the charge state (the discharge (n+1-th discharge Dn+1) state or the stop state), and the finally set peak voltage $V_{pp}$ is calculated as the peak voltage $V_{pp}$. That is, as illustrated in FIG. 21, the upper limit voltage calculation unit 441 calculates the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation as the upper limit voltage.

Here, the reason why the peak voltage $V_{pp}$, is set as the upper limit voltage is that the peak voltage during the charge is set as the upper limit voltage because the voltage rapidly decreases when the charge current is not applied as illustrated in FIG. 6.

The upper limit SOC calculation unit 442 calculates the upper limit SOC, which is the SOC having the largest value when the lead-acid battery B is charged. More specifically, in a case where the determination result of the charge determination unit 440 indicates that the lead-acid battery B is not in the charge state (the discharge (n+1-th discharge Dn+1) state or the stop state), the upper limit SOC calculation unit 442 calculates $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC (see FIG. 20). Here, the upper limit SOC calculation unit 442 acquires, from the recording unit 12, the rated capacity, the total charge amount of the lead-acid battery B from completion of an equalization charge to an end time point of the (n+1)-th charge Cn+1 recorded in the recording unit 12 at the end of the (n+1)-th charge Cn+1, and the total discharge amount (negative value) of the lead-acid battery B from the completion of the equalization charge to the end time point of the (n+1)-th charge Cn+1 recorded in the recording unit 12 at the end of the (n+1)-th charge Cn+1, and calculates $SOC_{sta(n+1)}$ by the following Formula (6) .
[Mathematical Formula 6]

$$SOC_{sta(n+1)} = \frac{(\text{Rated capacity} + \text{Total charge amount} + \text{Total discharge amount})}{\text{Rated capacity}} \times 100$$

$$\cdots (6)$$

Next, after the upper limit SOC is calculated by the upper limit SOC calculation unit 442, the capacity turnover value calculation unit 443 calculates the capacity turnover value during operation (hereinafter, referred to as a CT value during operation).

An internal configuration of the capacity turnover value calculation unit 443 will be described in more detail below. FIG. 23 is a block diagram illustrating an internal configuration of the capacity turnover value calculation unit 443 included in the state determination unit 13 illustrated in FIG. 22.

The capacity turnover value calculation unit 443 includes a previous capacity turnover value acquisition unit 443a, an integrated discharge capacity acquisition unit 443b, a rated capacity acquisition unit 443c, an upper limit SOC acquisition unit 443d, an upper-limit-SOC-based correction coefficient calculation unit 443e, an upper limit voltage acquisition unit 443f, an upper-limit-voltage-based correction coefficient calculation unit 443g, and a capacity turnover value computation unit 443h.

The previous capacity turnover value acquisition unit 443a acquires, from the recording unit 12, a capacity turnover value before the start of the processing in the state determination unit 13 (before the time point a2 in FIG. 20) (hereinafter, referred to as a previous CT value). The previous CT value is a CT value during operation calculated by the capacity turnover value calculation unit 443 at the time of the previous processing in the state determination unit 13, and already input from the capacity turnover value calculation unit 443 to the recording unit 12.

The integrated discharge capacity acquisition unit 443b acquires the integrated discharge capacity value calculated again by the discharge current integration stop unit 436.

Further, the rated capacity acquisition unit 443c acquires information regarding the rated capacity (Ah) of the lead-acid battery B from the recording unit 12.

The upper limit SOC acquisition unit 443d acquires information regarding the upper limit SOC calculated by the upper limit SOC calculation unit 442.

The upper-limit-SOC-based correction coefficient calculation unit 443e calculates the upper-limit-SOC-based correction coefficient $K_{HSOC}$ by using the upper limit SOC acquired by the upper limit SOC acquisition unit 443d. The upper-limit-SOC-based correction coefficient $K_{HSOC}$ is calculated with reference to a graph illustrating a relationship between the upper limit SOC and the upper-limit-SOC-based correction coefficient $K_{HSOC}$ illustrated in FIG. 10. In FIG. 10, the upper-limit-SOC-based correction coefficient $K_{HSOC}$ between the respective numerical values is calculated by creating an approximation curve from values of two adjacent points.

The upper limit voltage acquisition unit 443f acquires information regarding the upper limit voltage calculated by the upper limit voltage calculation unit 441.

The upper-limit-voltage-based correction coefficient calculation unit 443g calculates the upper-limit-voltage-based correction coefficient $K_{HV}$ by using the upper limit voltage acquired by the upper limit voltage acquisition unit 443f. The upper-limit-voltage-based correction coefficient $K_{HV}$ is calculated with reference to a graph illustrating a relationship between the upper limit voltage and the upper-limit-voltage-based correction coefficient $K_{HV}$ illustrated in FIG. 11. Here, in FIG. 11, the upper-limit-voltage-based correction coefficient $K_{HV}$ between the respective numerical values is calculated by creating an approximation curve from values of two adjacent points. However, in a case where the upper limit voltage is 57 V or less, the upper-limit-voltage-based correction coefficient $K_{HV} = 1$, which is constant.

Further, the capacity turnover value computation unit 443h calculates the CT value during operation by Formula (3) described above using the previous CT value acquired by the previous capacity turnover value acquisition unit 443a, the integrated discharge capacity from the start of the discharge of the lead-acid battery B acquired by the integrated discharge capacity acquisition unit 443b, the rated capacity (Ah) of the lead-acid battery B acquired by the rated capacity acquisition unit 443c, the upper-limit-SOC-based correction coefficient $K_{HSOC}$ calculated by the upper-limit-SOC-based correction coefficient calculation unit 443e, and the upper-limit-voltage-based correction coefficient $K_{HV}$ calculated by the upper-limit-voltage-based correction coefficient calculation unit 443g.

Then, the life estimation unit 444 estimates the remaining life of the lead-acid battery B by comparing the CT value from the beginning to the end of life acquired from the recording unit 12 with the CT value during operation calculated by the capacity turnover value calculation unit 443. That is, the life estimation unit 444 estimates the remaining life of the lead-acid battery B from a CT value obtained by subtracting the CT value during operation from the CT value from the beginning to the end of life.

Then, the life estimation unit 444 records an estimation result of the life estimation unit 444 including the CT value during operation in the recording unit 12. The life estimation unit 444 sets the peak voltage $V_{pp}$ calculated by the upper limit voltage calculation unit 441 to 0 and records the peak voltage $V_{pp}$ in the recording unit 12.

As described above, in the lead-acid battery system S according to the fourth embodiment, the capacity turnover value calculation unit 443 calculates the CT value during operation by using both the upper-limit-SOC-based correction coefficient $K_{HSOC}$ calculated based on the upper limit SOC calculated by the upper limit SOC calculation unit 442 that calculates the upper limit SOC, which is the SOC having the largest value when the lead-acid battery B is charged, and the upper-limit-voltage-based correction coefficient $K_{HV}$ calculated based on the upper limit voltage calculated by the upper limit voltage calculation unit 441 that calculates the upper limit voltage, which is the highest voltage when the lead-acid battery B is charged. As a result, the CT value during operation can be calculated in consideration of both the upper limit SOC and the upper limit voltage, the progress of corrosion of a positive electrode and softening of an active material due to electrolyte loss can be considered, and the lead-acid battery system S capable of accurately estimating the remaining life of the lead-acid battery can be provided.

In the lead-acid battery system S according to the fourth embodiment, the upper limit SOC calculation unit 442 calculates $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC, and the capacity turnover value calculation unit 443 calculates the upper-limit-SOC-based correction coefficient $K_{HSOC}$ calculated by the upper limit SOC calculation unit 442. As a result, the upper limit SOC can be determined and calculated at the end of the next charge (n+1-th charge Cn+1) after the end of the discharge (n-th discharge Dn) of the lead-acid battery B to be subjected to calculation of the capacity turnover value during operation, and the upper-limit-SOC-based correction coefficient $K_{HSOC}$ can be appropriately calculated based on the calculated upper limit SOC.

In the lead-acid battery system S according to the fourth embodiment, the upper limit voltage calculation unit 441 calculates the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation as the upper limit voltage, and the capacity turnover value calculation unit 443 calculates the upper-limit-voltage-based correction coefficient $K_{HV}$ calculated by the upper limit voltage calculation unit 441. As a result, the upper limit voltage can be calculated by calculating the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation, and the upper-limit-voltage-based correction coefficient $K_{HV}$ can be appropriately calculated based on the calculated upper limit voltage.

In the lead-acid battery system S according to the fourth embodiment, in a case where the lead-acid battery B is a bipolar lead-acid battery, it is possible to provide the lead-acid battery system S capable of accurately estimating the remaining life of the bipolar lead-acid battery.

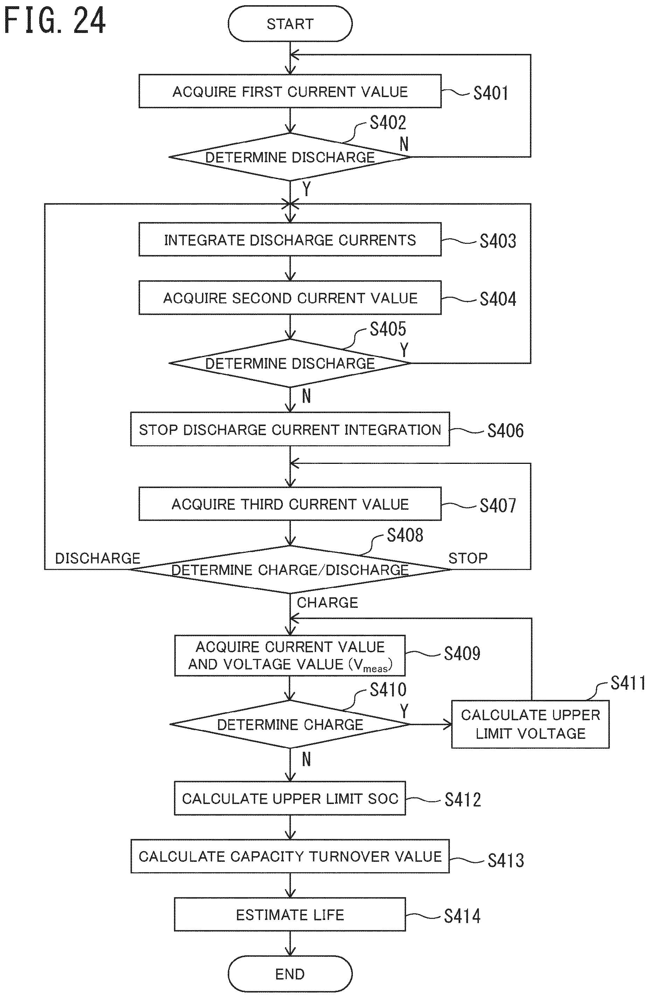

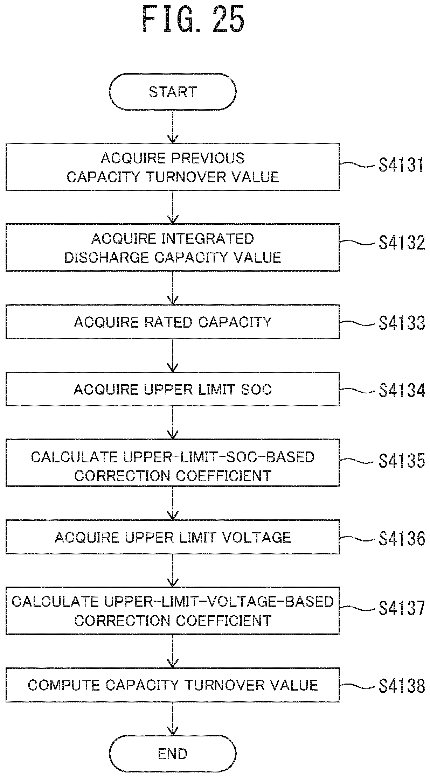

Next, a lead-acid battery life estimation method according to the fourth embodiment will be described with reference to a flowchart illustrating a flow of the processing in the state determination unit illustrated in FIG. 24 and a flowchart illustrating a flow of processing of step S413 (capacity turnover value calculation step) in the flowchart of FIG. 24 illustrated in FIG. 25.

The state determination unit 13 starts the processing from the time point a2 in FIGS. 20 and 21. First, as illustrated in FIG. 24, in step S401, the first current value acquisition unit 431 of the state determination unit 13 acquires, from the recording unit 12, information regarding the current value of the lead-acid battery B input to the recording unit 12 via the measurement unit 11 from the start to the end (b2 in FIGS. 20 and 21) of the processing in the state determination unit 13 (first current value acquisition step).

Next, in step S402, the discharge determination unit 432 determines whether or not the lead-acid battery B is in the discharge (n-th discharge Dn) state based on the current value of the lead-acid battery B acquired in step S401 (discharge determination step). Specifically, in a case where the current value of the lead-acid battery B acquired in step S401 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold is a value similar to that described above.

Then, in a case where the determination result in step S402 indicates the discharge (n-th discharge Dn) state, the processing proceeds to step S403, and in a case where the determination result in step S402 does not indicate the discharge (n-th discharge Dn) state (the stop state or the charge state), the processing returns to step S401.

In step S403, the discharge current integration unit 433 integrates the discharge current values from the start of the discharge of the lead-acid battery B, and calculates the integrated discharge capacity value from the start of the discharge of the lead-acid battery B (integrated discharge capacity value calculation step).

Next, in step S404, the second current value acquisition unit 434 acquires, from the recording unit 12, information regarding the current value of the lead-acid battery B input to the recording unit 12 via the measurement unit 11 from the start to the end of the processing in the state determination unit 13 (second current value acquisition step).

Next, in step S405, the discharge determination unit 435 determines whether or not the lead-acid battery B is in the discharge (n-th discharge Dn) state based on the current value of the lead-acid battery B acquired in step S404 (discharge determination step). Specifically, in a case where the current value of the lead-acid battery B acquired in step S404 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n+1-th charge Cn+1) state). The first threshold is a value similar to the first threshold described above.

Then, in a case where the determination result in step S405 indicates the discharge (n-th discharge Dn) state, the processing returns to step S403, and in a case where the determination result in step S405 does not indicate the discharge (n-th discharge Dn) state (the stop state or the charge (n+1-th charge Cn+1) state), the processing proceeds to step S406.

In step S406, the discharge current integration stop unit 436 stops the integration of the discharge current values integrated in step S403, and calculates the integrated discharge capacity value again (discharge current integration stop step).

Next, in step S407, the third current value acquisition unit 437 acquires, from the recording unit 12, information regarding the current value of the lead-acid battery B input to the recording unit 12 via the measurement unit 11 from the start to the end of the processing in the state determination unit 13 (third current value acquisition step).

Next, in step S408, the charge/discharge determination unit 438 determines whether the lead-acid battery B is in the discharge state, the stop state, or the charge state based on the current value of the lead-acid battery B acquired in step 407 (charge/discharge determination step).

Here, in a case where the current value of the lead-acid battery B acquired in step S407 is smaller than the first threshold (the current value < the first threshold), the charge/discharge determination unit 438 determines that the lead-acid battery B is in the discharge (n-th discharge Dn) state,

in a case where the first threshold $\leq$ the current value $\leq$ the second threshold, the charge/discharge determination unit 438 determines that the lead-acid battery B is in the stop state, and
in a case where the current value > the second threshold, the charge/discharge determination unit 438 determines that the lead-acid battery B is in the charge (n+1-th charge Cn+1) state.

The first threshold and the second threshold are values similar to those described above.

In a case where the determination result in step S408 indicates the discharge state, the processing returns to step S403. In a case where the determination result in step S408 indicates the stop state, the processing returns to step S407. In a case where the determination result in step S408 indicates the charge state, the processing proceeds to step S409.

In step S409, the current value/voltage value acquisition unit 439 acquires, from the recording unit 12, information regarding the current value and information regarding the voltage value $V_{meas}$ of the lead-acid battery B input to the recording unit 12 via the measurement unit 11 from the start to the end of the processing in the state determination unit 13 (current value/voltage value acquisition step).

Next, in step S410, the charge determination unit 440 determines whether or not the lead-acid battery B is in the charge state based on the current value of the lead-acid battery B acquired in step S409 (charge determination step).

Here, in a case where the current value of the lead-acid battery B acquired in step S409 is smaller than the second threshold (the current value < the second threshold), the charge determination unit 440 determines that the lead-acid battery B is not in the charge state (the lead-acid battery B is in the discharge (n+1-th discharge Dn+1) state),

in a case where the current value = the second threshold, the charge determination unit 440 determines that the lead-acid battery B is not in the charge state (the stop state), and
in a case where the current value > the second threshold, the charge determination unit 440 determines that the lead-acid battery B is in the charge (n+1-th charge Cn+1) state.

The first threshold and the second threshold are the same values as those described above.

In a case where the determination result in step S410 indicates the charge (n+1-th charge Cn+1) state, the processing proceeds to step S411, and in a case where the determination result in step S410 indicates the discharge (n+1-th discharge Dn+1) state or the stop state), the processing proceeds to step S412.

In step S411, the upper limit voltage calculation unit 441 calculates the upper limit voltage which is the highest voltage when the lead-acid battery B is charged (upper limit voltage calculation step). More specifically, similarly to step S3 (upper limit voltage calculation step) of the first embodiment, it is determined whether or not the voltage value ($V_{meas}$) acquired in step S409 exceeds the voltage already set as the peak voltage $V_{pp}$ acquired from the recording unit 12. In a case where the voltage value ($V_{meas}$) exceeds the peak voltage $V_{pp}$, the voltage value ($V_{meas}$) is newly set as the peak voltage $V_{pp}$. In a case where the voltage value ($V_{meas}$) does not exceed the peak voltage $V_{pp}$, the voltage value already set as the peak voltage $V_{pp}$ is set as the peak voltage $V_{pp}$. Then, this setting is repeated until it is determined that the current value acquired in step S409 indicates that the lead-acid battery B is not in the charge state (the discharge (n+1-th discharge Dn+1) state or the stop state), and the finally set peak voltage $V_{pp}$ is calculated as the peak voltage $V_{pp}$. That is, in step S411, as illustrated in FIG. 21, the upper limit voltage calculation unit 441 calculates the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation as the upper limit voltage.

In step S412, the upper limit SOC calculation unit 442 calculates the upper limit SOC which is the SOC having the largest value when the lead-acid battery B is charged (upper limit SOC calculation step). More specifically, the upper limit SOC calculation unit 442 calculates $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC (see FIG. 20). Here, the upper limit SOC calculation unit 442 acquires, from the recording unit 12, the rated capacity, the total charge amount of the lead-acid battery B from completion of an equalization charge to an end time point of the (n+1)-th charge Cn+1 recorded in the recording unit 12 at the end of the (n+1)-th charge Cn+1, and the total discharge amount (negative value) of the lead-acid battery B from the completion of the equalization charge to the end time point of the (n+1)-th charge Cn+1 recorded in the recording unit 12 at the end of the (n+1)-th charge Cn+1, and calculates $SOC_{sta(n+1)}$ by Formula (6) described above.

Next, in step S413, after calculating the upper limit SOC in step S412, the capacity turnover value calculation unit 443 calculates the capacity turnover value during operation (hereinafter, referred to as the CT value during operation) (capacity turnover value calculation step).

A detailed flow of processing in the capacity turnover value calculation unit 443 in step S413 will be described with reference to FIG. 25.

First, in step S4131, the previous capacity turnover value acquisition unit 443a acquires, from the recording unit 12, a capacity turnover value before the start of the processing in the state determination unit 13 (before the time point a2 in FIG. 20) (hereinafter, referred to as a previous CT value) (previous CT value acquisition step). The previous CT value is a CT value during operation calculated by the capacity turnover value calculation unit 443 at the time of the previous processing in the state determination unit 13, and already input from the capacity turnover value calculation unit 443 to the recording unit 12.

Next, in step S4132, the integrated discharge capacity acquisition unit 443b acquires the integrated discharge capacity value calculated again in step S406 (integrated discharge capacity value acquisition step).

Next, in step S4133, the rated capacity acquisition unit 443c acquires information regarding the rated capacity (Ah) of the lead-acid battery B from the recording unit 12 (rated capacity acquisition step).

In step S4134, the upper limit SOC acquisition unit 443d acquires information regarding the upper limit SOC calculated in step S412 (upper limit SOC acquisition step).

Next, in step S4135, the upper-limit-SOC-based correction coefficient calculation unit 443e calculates the upper-limit-SOC-based correction coefficient $K_{HSOC}$ by using the upper limit SOC acquired in step S4134 (upper-limit-SOC-based correction coefficient calculation step). The upper-limit-SOC-based correction coefficient $K_{HSOC}$ is calculated with reference to a graph illustrating a relationship between the upper limit SOC and the upper-limit-SOC-based correction coefficient $K_{HSOC}$ illustrated in FIG. 10. In FIG. 10, the upper-limit-SOC-based correction coefficient $K_{HSOC}$ between the respective numerical values is calculated by creating an approximation curve from values of two adjacent points.

Next, in step S4136, the upper limit voltage acquisition unit 443f acquires information regarding the upper limit voltage calculated in step S401 (upper limit voltage acquisition step).

Next, in step S4137, the upper-limit-voltage-based correction coefficient calculation unit 443g calculates the upper-limit-voltage-based correction coefficient $K_{HV}$ by using the upper limit voltage acquired in step S4136 (upper-limit-voltage-based correction coefficient calculation step). The upper-limit-voltage-based correction coefficient $K_{HV}$ is calculated with reference to a graph illustrating a relationship between the upper limit voltage and the upper-limit-voltage-based correction coefficient $K_{HV}$ illustrated in FIG. 11. Here, in FIG. 11, the upper-limit-voltage-based correction coefficient $K_{HV}$ between the respective numerical values is calculated by creating an approximation curve from values of two adjacent points. However, in a case where the upper limit voltage is 57 V or less, the upper-limit-voltage-based correction coefficient $K_{HV}$ = 1, which is constant.

Next, in step S4138, the capacity turnover value computation unit 443h calculates the CT value during operation by Formula (3) described above using the previous CT value acquired in step S4131, the integrated discharge capacity after the start of the discharge of the lead-acid battery B acquired in step S4132, the rated capacity (Ah) of the lead-acid battery B acquired in step S4133, the upper-limit-SOC-based correction coefficient $K_{HSOC}$ calculated in step S4135, and the upper-limit-voltage-based correction coefficient $_{HV}$ calculated in step S4137.

As a result, the processing in the capacity turnover value calculation unit 443 in step S413 ends.

In step S414, the life estimation unit 444 estimates the remaining life of the lead-acid battery B by comparing the CT value from the beginning to the end of life acquired from the recording unit 12 with the CT value during operation calculated in step S413. That is, the life estimation unit 444 estimates the remaining life of the lead-acid battery B from a CT value obtained by subtracting the CT value during operation from the CT value from the beginning to the end of life.

Then, the life estimation unit 444 records an estimation result of the life estimation unit 444 including the CT value during operation in the recording unit 12. The life estimation unit 444 sets the peak voltage $V_{pp}$ calculated by the upper limit voltage calculation unit 441 to 0 and records the peak voltage $V_{pp}$ in the recording unit 12.

Accordingly, the processing in the state determination unit 13 ends.

As described above, in the lead-acid battery life estimation method according to the fourth embodiment, in the capacity turnover value calculation step (step S413), the CT value during operation is calculated using both the upper-limit-SOC-based correction coefficient $K_{HSOC}$ calculated based on the upper limit SOC calculated in the upper limit SOC calculation step (step S412) of calculating the upper limit SOC, which is the SOC having the largest value when the lead-acid battery B is charged, and the upper-limit-voltage-based correction coefficient $K_{HV}$ calculated based on the upper limit voltage calculated in the upper limit voltage calculation step (step S411) of calculating the upper limit voltage, which is the highest voltage when the lead-acid battery B is charged. As a result, the CT value during operation can be calculated in consideration of both the upper limit SOC and the upper limit voltage, the progress of corrosion of a positive electrode and softening of an active material due to electrolyte loss can be considered, and the lead-acid battery life estimation method capable of accurately estimating the remaining life of the lead-acid battery can be provided.

In the lead-acid battery life estimation method according to the fourth embodiment, in the upper limit SOC calculation step (step S412), $SOC_{sta(n+1)}$ at the end of the next charge (n+1-th charge Cn+1) after the end of the discharge (n-th discharge Dn) of the lead-acid battery B to be subjected to calculation of the capacity turnover value during operation is calculated as the upper limit SOC, and in the capacity turnover value calculation step (step S413), the upper-limit-SOC-based correction coefficient $K_{HSOC}$ is calculated based on the upper limit SOC calculated in the upper limit SOC calculation step (step S412). As a result, the upper limit SOC can be determined and calculated at the end of the next charge (n+1-th charge Cn+1) after the end of the discharge (n-th discharge Dn) of the lead-acid battery B to be subjected to calculation of the capacity turnover value during operation, and the upper-limit-SOC-based correction coefficient $K_{HSOC}$ can be appropriately calculated based on the calculated upper limit SOC.

In the lead-acid battery life estimation method according to the fourth embodiment, in the upper limit voltage calculation step (step S411), the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation is calculated as the upper limit voltage, and in the capacity turnover value calculation step (step S413), the upper-limit-voltage-based correction coefficient $K_{HV}$ is calculated based on the upper limit voltage calculated in the upper limit voltage calculation step (step S411). As a result, the upper limit voltage can be calculated by calculating the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation, and the upper-limit-voltage-based correction coefficient $K_{HV}$ can be appropriately calculated based on the calculated upper limit voltage.

In the lead-acid battery life estimation method according to the fourth embodiment, in a case where the lead-acid battery B is a bipolar lead-acid battery, it is possible to provide a lead-acid battery life estimation method capable of accurately estimating the remaining life of the bipolar lead-acid battery.

(Fifth Embodiment)

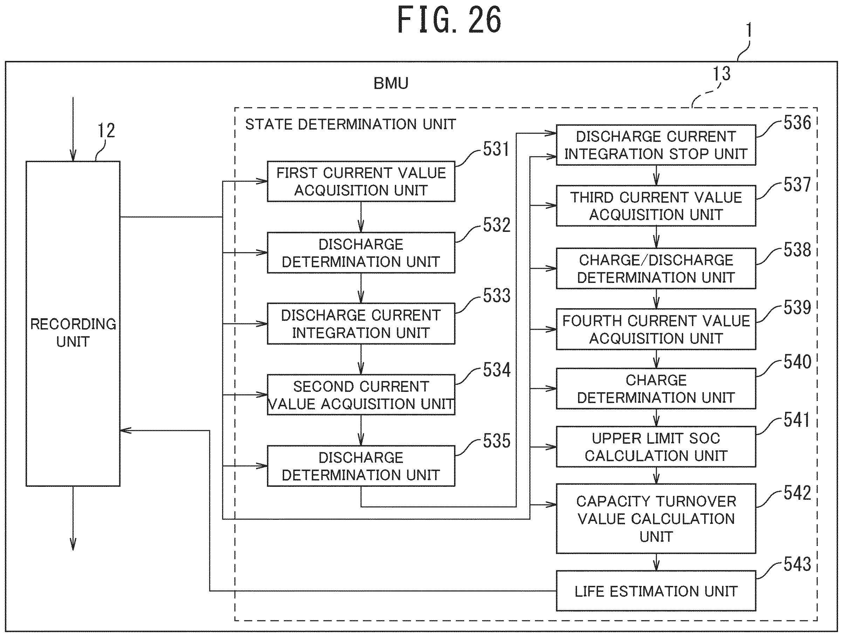

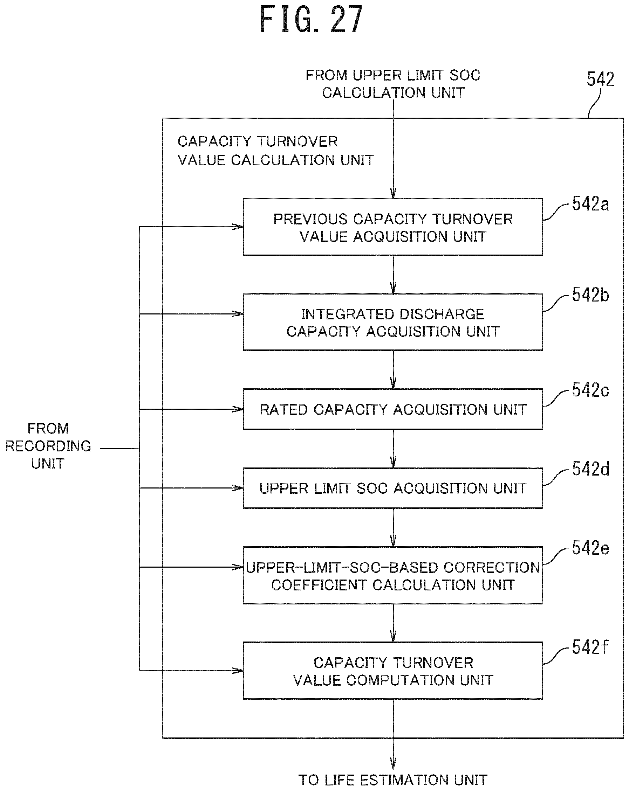

Next, the lead-acid battery system according to the fifth embodiment of the present invention will be described with reference to FIGS. 26 and 27. FIG. 26 is a block diagram illustrating internal configurations of a recording unit and a state determination unit included in the BMU illustrated in FIG. 2 in the lead-acid battery system according to the fifth embodiment of the present invention. FIG. 27 is a block diagram illustrating an internal configuration of a capacity turnover value calculation unit included in the state determination unit illustrated in FIG. 26.

The lead-acid battery system S according to the fifth embodiment has the same basic configuration as the lead-acid battery system S according to the fourth embodiment, and is different from the lead-acid battery system S in a configuration of a state determination unit 13.

The state determination unit 13 of the fourth embodiment calculates a capacity turnover value during operation by using both an upper-limit-SOC-based correction coefficient $K_{HSOC}$ calculated based on a calculated upper limit state of charge (SOC), which is an SOC having the largest value when a lead-acid battery B is charged, and an upper-limit-voltage-based correction coefficient $K_{HV}$ calculated based on a calculated upper limit voltage, which is the highest voltage when the lead-acid battery B is charged.

On the other hand, the state determination unit 13 of the fifth embodiment is different from the state determination unit 13 of the fourth embodiment in that the capacity turnover value during operation is calculated using only the upper-limit-SOC-based correction coefficient $K_{HSOC}$ out of the upper-limit-SOC-based correction coefficient $K_{HSOC}$ and the upper-limit-voltage-based correction coefficient $K_{HV}$.

Similarly to the state determination unit 13 of the fourth embodiment, as illustrated in FIG. 20, the state determination unit 13 of the fifth embodiment calculates $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC.

As illustrated in FIG. 20, the processing in the state determination unit 13 in the lead-acid battery system S according to the fifth embodiment is executed from a time point a2 at the time of the n-th charge Cn of the lead-acid battery B to a time point b2 after the end of the n+1-th charge Cn+1, and the processing is repeated at the time of charging and discharging.

Therefore, as illustrated in FIG. 26, the state determination unit 13 of the fifth embodiment includes a first current value acquisition unit 531, a discharge determination unit 532, a discharge current integration unit 533, a second current value acquisition unit 534, a discharge determination unit 535, a discharge current integration stop unit 536, a third current value acquisition unit 537, a charge/discharge determination unit 538, a fourth current value acquisition unit 539, a charge determination unit 540, an upper limit SOC calculation unit 541, a capacity turnover value calculation unit 542, and a life estimation unit 543 in order to estimate the remaining life of the lead-acid battery B.

The first current value acquisition unit 531 acquires, from a recording unit 12, information regarding a current value of the lead-acid battery B input to the recording unit 12 via a measurement unit 11 from the start to the end of the processing in the state determination unit 13.

In addition, the discharge determination unit 532 determines whether or not the lead-acid battery B is in a discharge (n-th discharge Dn) state based on the current value of the lead-acid battery B acquired by the first current value acquisition unit 531. Specifically, in a case where the current value of the lead-acid battery B acquired by the first current value acquisition unit 432 is smaller than a first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n-th charge Cn) state).

Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by a setting unit 14 and recorded in the recording unit 12, and the discharge determination unit 532 acquires information regarding the first threshold from the recording unit 12.

In a case where it is determined by the discharge determination unit 532 that the lead-acid battery B is in the discharge (n-th discharge Dn) state, the discharge current integration unit 533 integrates discharge current values from the start of the discharge of the lead-acid battery B, and calculates an integrated discharge capacity value from the start of the discharge of the lead-acid battery B.

The second current value acquisition unit 534 acquires, from the recording unit 12, information regarding the current value of the lead-acid battery B input to the recording unit 12 via the measurement unit 11 from the start to the end of the processing in the state determination unit 13.

In addition, the discharge determination unit 535 determines whether or not the lead-acid battery B is in a discharge (n-th discharge Dn) state based on the current value of the lead-acid battery B acquired by the second current value acquisition unit 534. Specifically, in a case where the current value of the lead-acid battery B acquired by the second current value acquisition unit 534 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n+1-th charge Cn+1) state). The first threshold is a value similar to the first threshold described above. The first threshold for the discharge determination is set by a setting unit 14 and recorded in the recording unit 12, and the discharge determination unit 535 acquires information regarding the first threshold from the recording unit 12.

In a case where it is determined by the discharge determination unit 535 that the lead-acid battery B is not in the discharge (n-th discharge Dn) state (the stop state or the charge (n+1-th charge Cn+1) state), the discharge current integration stop unit 536 stops integration of the discharge current values integrated by discharge current integration unit 533, and calculates the integrated discharge capacity value again.

The third current value acquisition unit 537 acquires, from the recording unit 12, information regarding the current value of the lead-acid battery B input to the recording unit 12 via the measurement unit 11 from the start to the end of the processing in the state determination unit 13.

In addition, the charge/discharge determination unit 538 determines whether the lead-acid battery B is in a discharge state, the stop state, or the charge state based on the current value of the lead-acid battery B acquired by the third current value acquisition unit 537.

Here, in a case where the current value of the lead-acid battery B acquired by the third current value acquisition unit 537 is smaller than the first threshold (the current value < the first threshold), the charge/discharge determination unit 538 determines that the lead-acid battery B is in the discharge (n-th discharge Dn) state,

in a case where the first threshold ≤ the current value ≤ a second threshold, the charge/discharge determination unit 538 determines that the lead-acid battery B is in the stop state, and
in a case where the current value > the second threshold, the charge/discharge determination unit 538 determines that the lead-acid battery B is in the charge (n+1-th charge Cn+1) state.

The first threshold is the same value as the above-described first threshold, and the second threshold is a positive current value near 0 amperes.

In addition, the fourth current value acquisition unit 539 acquires, from the recording unit 12, information regarding the current value information of the lead-acid battery B input to the recording unit 12 via the measurement unit 11 from the start to the end of the processing in the state determination unit 13.

In addition, the charge determination unit 540 determines whether or not the lead-acid battery B is in the charge state based on the current value of the lead-acid battery B acquired by the fourth current value acquisition unit 539.

Here, in a case where the current value of the lead-acid battery B acquired by the fourth current value acquisition unit 539 is smaller than the second threshold (the current value < the second threshold), the charge determination unit 540 determines that the lead-acid battery B is not in the charge state (the lead-acid battery B is in the discharge (n+1-th discharge Dn+1) state),

in a case where the current value = the second threshold, the charge determination unit 540 determines that the lead-acid battery B is not in the charge state (the stop state), and
in a case where the current value > the second threshold, the charge determination unit 540 determines that the lead-acid battery B is in the charge (n+1-th charge Cn+1) state.

The first threshold and the second threshold are the same values as those described above.

The upper limit SOC calculation unit 541 calculates the upper limit SOC, which is the SOC having the largest value when the lead-acid battery B is charged. More specifically, in a case where the determination result of the charge determination unit 440 indicates that the lead-acid battery B is not in the charge state (the discharge (n+1-th discharge Dn+1) state or the stop state), the upper limit SOC calculation unit 541 calculates $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC (see FIG. 20). Here, the upper limit SOC calculation unit 541 acquires, from the recording unit 12, the rated capacity of the lead-acid battery B, the total charge amount of the lead-acid battery B from completion of an equalization charge to an end time point of the (n+1)-th charge Cn+1 recorded in the recording unit 12 at the end of the (n+1)-th charge Cn+1, and the total discharge amount (negative value) of the lead-acid battery B from the completion of the equalization charge to the end time point of the (n+1)-th charge Cn+1 recorded in the recording unit 12 at the end of the (n+1)-th charge Cn+1, and calculates $SOC_{sta(n+1)}$ by Formula (6) described above.

Next, after the upper limit SOC is calculated by the upper limit SOC calculation unit 541, the capacity turnover value calculation unit 542 calculates the capacity turnover value during operation (hereinafter, referred to as a CT value during operation).

An internal configuration of the capacity turnover value calculation unit 542 will be described in more detail below. FIG. 27 is a block diagram illustrating an internal configuration of the capacity turnover value calculation unit 443 included in the state determination unit 13 illustrated in FIG. 26.

The capacity turnover value calculation unit 542 includes a previous capacity turnover value acquisition unit 542a, an integrated discharge capacity acquisition unit 542b, a rated capacity acquisition unit 542c, an upper limit SOC acquisition unit 542d, an upper-limit-SOC-based correction coefficient calculation unit 542e, and a capacity turnover value computation unit 542f.

The previous capacity turnover value acquisition unit 542a acquires, from the recording unit 12, a capacity turnover value before the start of the processing in the state determination unit 13 (before the time point a2 in FIG. 20) (hereinafter, referred to as a previous CT value). The previous CT value is a CT value during operation calculated by the capacity turnover value calculation unit 542 at the time of the previous processing in the state determination unit 13, and already input from the capacity turnover value calculation unit 542 to the recording unit 12.

The integrated discharge capacity acquisition unit 542b acquires the integrated discharge capacity value calculated again by the discharge current integration stop unit 536.

Further, the rated capacity acquisition unit 542c acquires information regarding the rated capacity (Ah) of the lead-acid battery B from the recording unit 12.

The upper limit SOC acquisition unit 542d acquires information regarding the upper limit SOC calculated by the upper limit SOC calculation unit 541.

The upper-limit-SOC-based correction coefficient calculation unit 542e calculates the upper-limit-SOC-based correction coefficient $K_{HSOC}$ by using the upper limit SOC acquired by the upper limit SOC acquisition unit 542d. The upper-limit-SOC-based correction coefficient $K_{HSOC}$ is calculated with reference to a graph illustrating a relationship between the upper limit SOC and the upper-limit-SOC-based correction coefficient $K_{HSOC}$ illustrated in FIG. 10. In FIG. 10, the upper-limit-SOC-based correction coefficient $K_{HSOC}$ between the respective numerical values is calculated by creating an approximation curve from values of two adjacent points.

Furthermore, the capacity turnover value computation unit 542f calculates the CT value during operation by Formula (4) described above using the previous CT value acquired by the previous capacity turnover value acquisition unit 542a, the integrated discharge capacity from the start of the discharge of the lead-acid battery B acquired by the integrated discharge capacity acquisition unit 542b, the rated capacity (Ah) of the lead-acid battery B acquired by the rated capacity acquisition unit 542c, and the upper-limit-SOC-based correction coefficient $K_{HSOC}$ calculated by the upper-limit-SOC-based correction coefficient calculation unit 542e.

Then, the life estimation unit 543 estimates the remaining life of the lead-acid battery B by comparing the CT value from the beginning to the end of life acquired from the recording unit 12 with the CT value during operation calculated by the capacity turnover value calculation unit 542. That is, the life estimation unit 543 estimates the remaining life of the lead-acid battery B from a CT value obtained by subtracting the CT value during operation from the CT value from the beginning to the end of life.

Then, the life estimation unit 543 records an estimation result of the life estimation unit 444 including the CT value during operation in the recording unit 12.

As described above, in the lead-acid battery system S according to the fifth embodiment, the capacity turnover value calculation unit 542 calculates the CT value during operation by using the upper-limit-SOC-based correction coefficient $K_{HSOC}$ calculated based on the upper limit SOC calculated by the upper limit SOC calculation unit 541 that calculates the upper limit SOC, which is the SOC having the largest value when the lead-acid battery B is charged. As a result, the CT value during operation can be calculated in consideration of the upper limit SOC, the progress of corrosion of a positive electrode and softening of an active material due to electrolyte loss can be considered, and the lead-acid battery system S capable of accurately estimating the remaining life of the lead-acid battery can be provided.

In the lead-acid battery system S according to the fifth embodiment, the upper limit SOC calculation unit 541 calculates $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC, and the capacity turnover value calculation unit 542 calculates the upper-limit-SOC-based correction coefficient $K_{HSOC}$ calculated by the upper limit SOC calculation unit 541. As a result, the upper limit SOC can be determined and calculated at the end of the next charge (n+1-th charge Cn+1) after the end of the discharge (n-th discharge Dn) of the lead-acid battery B to be subjected to calculation of the capacity turnover value during operation, and the upper-limit-SOC-based correction coefficient $K_{HSOC}$ can be appropriately calculated based on the calculated upper limit SOC.

In the lead-acid battery system S according to the fifth embodiment, in a case where the lead-acid battery B is a bipolar lead-acid battery, it is possible to provide the lead-acid battery system S capable of accurately estimating the remaining life of the bipolar lead-acid battery.

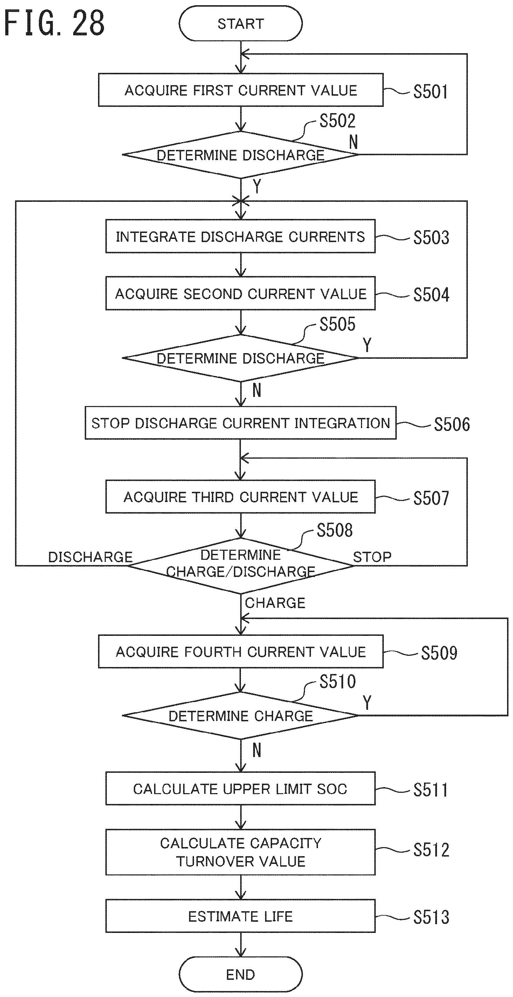

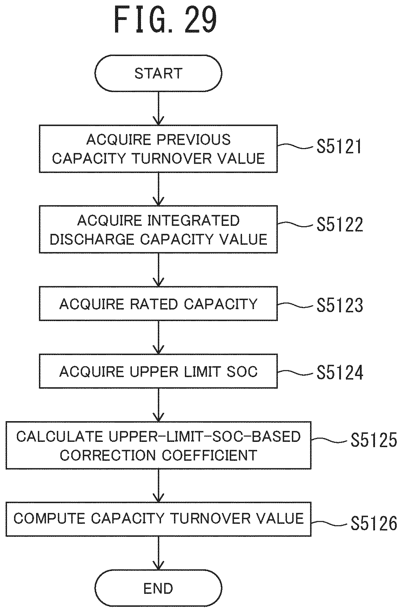

Next, a lead-acid battery life estimation method according to the fifth embodiment will be described with reference to a flowchart illustrating a flow of the processing in the state determination unit illustrated in FIG. 28 and a flowchart illustrating a flow of processing of step S511 (capacity turnover value calculation step) in the flowchart of FIG. 28 illustrated in FIG. 29.

The state determination unit 13 starts the processing from the time point a2 in FIG. 20. First, as illustrated in FIG. 28, in step S501, the first current value acquisition unit 531 of the state determination unit 13 acquires, from the recording unit 12, information regarding the current value of the lead-acid battery B input to the recording unit 12 via the measurement unit 11 from the start to the end (the time point a2 in FIG. 20) of the processing in the state determination unit 13 (first current value acquisition step).

Next, in step S502, the discharge determination unit 532 determines whether or not the lead-acid battery B is in the discharge (n-th discharge Dn) state based on the current value of the lead-acid battery B acquired in step S501 (discharge determination step). Specifically, in a case where the current value of the lead-acid battery B acquired in step S501 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold is a value similar to that described above.

Then, in a case where the determination result in step S502 indicates the discharge (n-th discharge Dn) state, the processing proceeds to step S503, and in a case where the determination result in step S502 does not indicate the discharge (n-th discharge Dn) state (the stop state or the charge (n-th charge Cn) state), the processing returns to step S501.

In step S503, the discharge current integration unit 533 integrates the discharge current values from the start of the discharge of the lead-acid battery B, and calculates the integrated discharge capacity value from the start of the discharge of the lead-acid battery B (integrated discharge capacity value calculation step).

Next, in step S504, the second current value acquisition unit 534 acquires, from the recording unit 12, information regarding the current value of the lead-acid battery B input to the recording unit 12 via the measurement unit 11 from the start to the end of the processing in the state determination unit 13 (second current value acquisition step).

Next, in step S505, the discharge determination unit 535 determines whether or not the lead-acid battery B is in the discharge (n-th discharge Dn) state based on the current value of the lead-acid battery B acquired in step S504 (discharge determination step). Specifically, in a case where the current value of the lead-acid battery B acquired in step S504 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n+1-th charge Cn) state). The first threshold is a value similar to the first threshold described above.

Then, in a case where the determination result in step S505 indicates the discharge (n-th discharge Dn) state, the processing returns to step S503, and in a case where the determination result in step S505 does not indicate the discharge (n-th discharge Dn) state (the stop state or the charge (n+1-th charge Cn) state), the processing proceeds to step S506.

In step S506, the discharge current integration stop unit 536 stops the integration of the discharge current values integrated in step S503, and calculates the integrated discharge capacity value again (discharge current integration stop step).

Next, in step S507, the third current value acquisition unit 537 acquires, from the recording unit 12, information regarding the current value of the lead-acid battery B input to the recording unit 12 via the measurement unit 11 from the start to the end of the processing in the state determination unit 13 (third current value acquisition step).

Next, in step S508, the charge/discharge determination unit 538 determines whether the lead-acid battery B is in the discharge state, the stop state, or the charge state based on the current value of the lead-acid battery B acquired in step 507 (charge/discharge determination step).

Here, in a case where the current value of the lead-acid battery B acquired in step S507 is smaller than the first threshold (the current value < the first threshold), the charge/discharge determination unit 538 determines that the lead-acid battery B is in the discharge (n-th discharge Dn) state,

in a case where the first threshold ≤ the current value ≤ the second threshold, the charge/discharge determination unit 538 determines that the lead-acid battery B is in the stop state, and
in a case where the current value > the second threshold, the charge/discharge determination unit 438 determines that the lead-acid battery B is in the charge (n+1-th charge Cn+1) state.

The first threshold and the second threshold are values similar to those described above.

In a case where the determination result in step S508 indicates the discharge state, the processing returns to step S503. In a case where the determination result in step S508 indicates the stop state, the processing returns to step S507. In a case where the determination result in step S508 indicates the charge state, the processing proceeds to step S509.

In step S509, the fourth current value acquisition unit 539 acquires, from the recording unit 12, information regarding the current value of the lead-acid battery B input to the recording unit 12 via the measurement unit 11 from the start to the end of the processing in the state determination unit 13 (fourth current value acquisition step).

Next, in step S510, the charge determination unit 540 determines whether or not the lead-acid battery B is in the charge state based on the current value of the lead-acid battery B acquired in step S509 (charge determination step).

Here, in a case where the current value of the lead-acid battery B acquired in step S509 is smaller than the second threshold (the current value < the second threshold), the charge determination unit 540 determines that the lead-acid battery B is not in the charge state (the lead-acid battery B is in the discharge (n+1-th discharge Dn+1) state),

in a case where the current value = the second threshold, the charge determination unit 540 determines that the lead-acid battery B is not in the charge state (the stop state), and
in a case where the current value > the second threshold, the charge determination unit 540 determines that the lead-acid battery B is in the charge (n+1-th charge Cn+1) state.

The first threshold and the second threshold are the same values as those described above.

In a case where the determination result in step S510 indicates the charge (n+1-th charge Cn+1) state, the processing returns to step S509, and in a case where the determination result in step S510 indicates the discharge (n+1-th discharge Dn+1) state or the stop state), the processing proceeds to step S511.

In step S511, the upper limit SOC calculation unit 541 calculates the upper limit SOC which is the SOC having the largest value when the lead-acid battery B is charged (upper limit SOC calculation step). More specifically, the upper limit SOC calculation unit 541 calculates $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC (see FIG. 20). Here, the upper limit SOC calculation unit 541 acquires, from the recording unit 12, the rated capacity of the lead-acid battery B, the total charge amount of the lead-acid battery B from completion of an equalization charge to an end time point of the (n+1)-th charge Cn+1 recorded in the recording unit 12 at the end of the (n+1)-th charge Cn+1, and the total discharge amount (negative value) of the lead-acid battery B from the completion of the equalization charge to the end time point of the (n+1)-th charge Cn+1 recorded in the recording unit 12 at the end of the (n+1)-th charge Cn+1, and calculates $SOC_{sta(n)}$ by Formula (6) described above.

Next, in step S512, after calculating the upper limit SOC in step S511, the capacity turnover value calculation unit 542 calculates the capacity turnover value during operation (hereinafter, referred to as the CT value during operation) (capacity turnover value calculation step).

A detailed flow of processing in the capacity turnover value calculation unit 542 in step S512 will be described with reference to FIG. 29.

First, in step S5121, the previous capacity turnover value acquisition unit 542a acquires, from the recording unit 12, a capacity turnover value before the start of the processing in the state determination unit 13 (before the time point a2 in FIG. 20) (hereinafter, referred to as a previous CT value) (previous CT value acquisition step). The previous CT value is a CT value during operation calculated by the capacity turnover value calculation unit 542 at the time of the previous processing in the state determination unit 13, and already input from the capacity turnover value calculation unit 542 to the recording unit 12.

Next, in step S5122, the integrated discharge capacity acquisition unit 542b acquires the integrated discharge capacity value calculated again in step S506 (integrated discharge capacity value acquisition step).

Next, in step S5123, the rated capacity acquisition unit 542c acquires information regarding the rated capacity (Ah) of the lead-acid battery B from the recording unit 12 (rated capacity acquisition step).

In step S5124, the upper limit SOC acquisition unit 542d acquires information regarding the upper limit SOC calculated in step S511 (upper limit SOC acquisition step).

Next, in step S5125, the upper-limit-SOC-based correction coefficient calculation unit 542e calculates the upper-limit-SOC-based correction coefficient $K_{HSOC}$ by using the upper limit SOC acquired in step S5124 (upper-limit-SOC-based correction coefficient calculation step). The upper-limit-SOC-based correction coefficient $K_{HSOC}$ is calculated with reference to a graph illustrating a relationship between the upper limit SOC and the upper-limit-SOC-based correction coefficient $K_{HSOC}$ illustrated in FIG. 10. In FIG. 10, the upper-limit-SOC-based correction coefficient $K_{HSOC}$ between the respective numerical values is calculated by creating an approximation curve from values of two adjacent points.

Next, in step S5126, the capacity turnover value computation unit 542f calculates the CT value during operation by Formula (4) described above using the previous CT value acquired in step S5121, the integrated discharge capacity from the start of the discharge of the lead-acid battery B acquired in step S5122, the rated capacity (Ah) of the lead-acid battery B acquired in step S5123, and the upper-limit-SOC-based correction coefficient $K_{HSOC}$ calculated in step S5125.

As a result, the processing in the capacity turnover value calculation unit 542 in step S512 ends.

In step S513, the life estimation unit 543 estimates the remaining life of the lead-acid battery B by comparing the CT value from the beginning to the end of life acquired from the recording unit 12 with the CT value during operation calculated in step S512. That is, the life estimation unit 543 estimates the remaining life of the lead-acid battery B from a CT value obtained by subtracting the CT value during operation from the CT value from the beginning to the end of life.

Then, the life estimation unit 543 records an estimation result of the life estimation unit 543 including the CT value during operation in the recording unit 12.

Accordingly, the processing in the state determination unit 13 ends.

As described above, in the lead-acid battery life estimation method according to the fifth embodiment, in the capacity turnover value calculation step (step S512), the CT value during operation is calculated using the upper-limit-SOC-based correction coefficient $K_{HSOC}$ calculated based on the upper limit SOC calculated in the upper limit SOC calculation step (step S511) of calculating the upper limit SOC, which is the SOC having the largest value when the lead-acid battery B is charged. As a result, the CT value during operation can be calculated in consideration of the upper limit SOC, the progress of corrosion of a positive electrode and softening of an active material due to electrolyte loss can be considered, and the lead-acid battery life estimation method capable of accurately estimating the remaining life of the lead-acid battery can be provided.

In the lead-acid battery life estimation method according to the fifth embodiment, in the upper limit SOC calculation step (step S511), $SOC_{sta(n+1)}$ at the end of the next charge (n+1-th charge Cn+1) after the end of the discharge (n-th discharge Dn) of the lead-acid battery B to be subjected to calculation of the capacity turnover value during operation is calculated as the upper limit SOC, and in the capacity turnover value calculation step (step S512), the upper-limit-SOC-based correction coefficient $K_{HSOC}$ is calculated based on the upper limit SOC calculated in the upper limit SOC calculation step (step S511). As a result, the upper limit SOC can be determined and calculated at the end of the next charge (n+1-th charge Cn+1) after the end of the discharge (n-th discharge Dn) of the lead-acid battery B to be subjected to calculation of the capacity turnover value during operation, and the upper-limit-SOC-based correction coefficient $K_{HSOC}$ can be appropriately calculated based on the calculated upper limit SOC.

In the lead-acid battery life estimation method according to the fifth embodiment, in a case where the lead-acid battery B is a bipolar lead-acid battery, it is possible to provide a lead-acid battery life estimation method capable of accurately estimating the remaining life of the bipolar lead-acid battery.

(Sixth Embodiment)

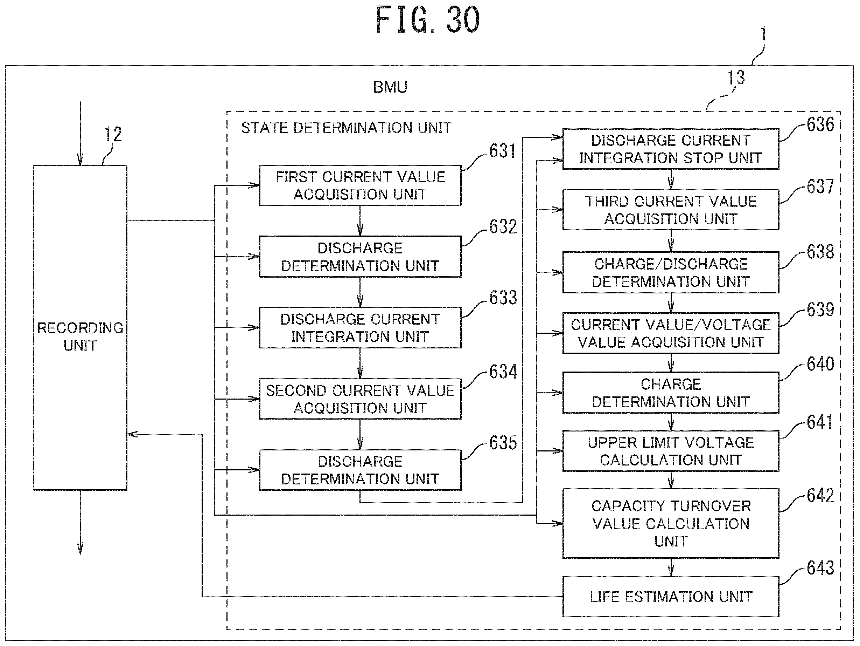

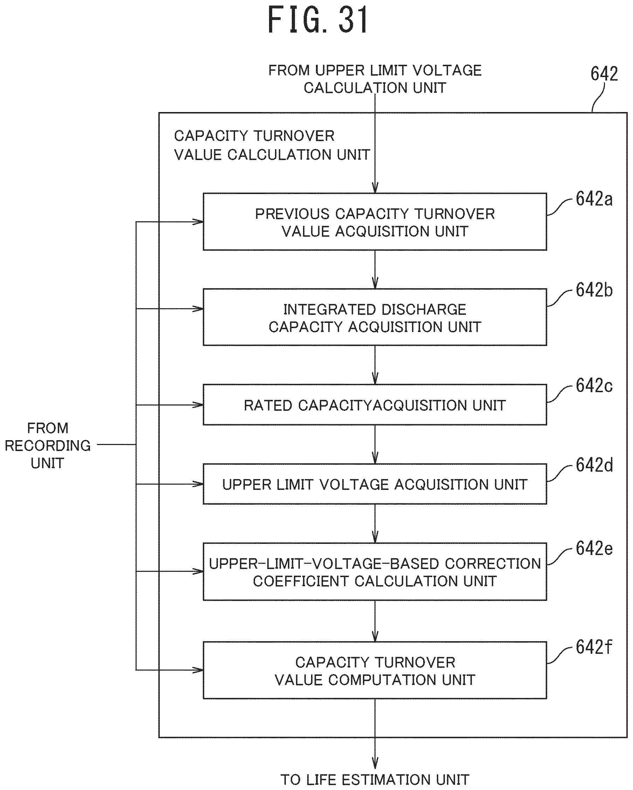

Next, the lead-acid battery system according to the sixth embodiment of the present invention will be described with reference to FIGS. 30 and 31. FIG. 30 is a block diagram illustrating internal configurations of a recording unit and a state determination unit included in the BMU illustrated in FIG. 2 in the lead-acid battery system according to the sixth embodiment of the present invention. FIG. 31 is a block diagram illustrating an internal configuration of a capacity turnover value calculation unit included in the state determination unit illustrated in FIG. 30.

The lead-acid battery system S according to the sixth embodiment has the same basic configuration as the lead-acid battery system S according to the fourth embodiment, and is different from the lead-acid battery system S in a configuration of a state determination unit 13.

The state determination unit 13 of the fourth embodiment calculates a capacity turnover value during operation by using both an upper-limit-SOC-based correction coefficient $K_{HSOC}$ calculated based on a calculated upper limit state of charge (SOC), which is an SOC having the largest value when a lead-acid battery B is charged, and an upper-limit-voltage-based correction coefficient $K_{HV}$ calculated based on a calculated upper limit voltage, which is the highest voltage when the lead-acid battery B is charged.

On the other hand, the state determination unit 13 of the sixth embodiment is different from the state determination unit 13 of the fourth embodiment in that the capacity turnover value during operation is calculated using only the upper-limit-voltage-based correction coefficient $K_{HV}$ out of the upper-limit-SOC-based correction coefficient $K_{HSOC}$ and the upper-limit-voltage-based correction coefficient $K_{HV}$.

Similarly to the state determination unit 13 of the fourth embodiment, as illustrated in FIG. 21, the state determination unit 13 of the sixth embodiment calculates a peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation as the upper limit voltage.

As illustrated in FIG. 21, the processing in the state determination unit 13 in the lead-acid battery system S according to the sixth embodiment is executed from a time point a2 at the time of the n-th charge Cn of the lead-acid battery B to a time point b2 after the end of the n+1-th charge Cn+1, and the processing is repeated at the time of charging and discharging.

Therefore, as illustrated in FIG. 22, the state determination unit 13 of the sixth embodiment includes a first current value acquisition unit 631, a discharge determination unit 632, a discharge current integration unit 633, a second current value acquisition unit 634, a discharge determination unit 635, a discharge current integration stop unit 636, a third current value acquisition unit 637, a charge/discharge determination unit 638, a current value/voltage value acquisition unit 639, a charge determination unit 640, an upper limit voltage calculation unit 641, a capacity turnover value calculation unit 642, and a life estimation unit 643 in order to estimate the remaining life of the lead-acid battery B.

The first current value acquisition unit 631 acquires, from a recording unit 12, information regarding a current value of the lead-acid battery B input to the recording unit 12 via a measurement unit 11 from the start to the end of the processing in the state determination unit 13.

In addition, the discharge determination unit 632 determines whether or not the lead-acid battery B is in a discharge (n-th discharge Dn) state based on the current value of the lead-acid battery B acquired by the first current value acquisition unit 631. Specifically, in a case where the current value of the lead-acid battery B acquired by the first current value acquisition unit 631 is smaller than a first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n-th charge Cn) state). Specifically, the first threshold is a negative current value near 0 amperes, and in a case where the current value is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold for the discharge determination is set by a setting unit 14 and recorded in the recording unit 12, and the discharge determination unit 632 acquires information regarding the first threshold from the recording unit 12.

In a case where it is determined by the discharge determination unit 632 that the lead-acid battery B is in the discharge (n-th discharge Dn) state, the discharge current integration unit 633 integrates discharge current values from the start of the discharge of the lead-acid battery B, and calculates an integrated discharge capacity value from the start of the discharge of the lead-acid battery B.

The second current value acquisition unit 634 acquires, from the recording unit 12, information regarding the current value of the lead-acid battery B input to the recording unit 12 via the measurement unit 11 from the start to the end of the processing in the state determination unit 13.

In addition, the discharge determination unit 635 determines whether or not the lead-acid battery B is in a discharge (n-th discharge Dn) state based on the current value of the lead-acid battery B acquired by the second current value acquisition unit 634. Specifically, in a case where the current value of the lead-acid battery B acquired by the second current value acquisition unit 634 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (a stop state or a charge (n+1-th charge Cn+1) state). The first threshold is a value similar to the first threshold described above. The first threshold for the discharge determination is set by a setting unit 14 and recorded in the recording unit 12, and the discharge determination unit 635 acquires information regarding the first threshold from the recording unit 12.

In a case where it is determined by the discharge determination unit 635 that the lead-acid battery B is not in the discharge (n-th discharge Dn) state (the stop state or the charge (n+1-th charge Cn+1) state), the discharge current integration stop unit 636 stops integration of the discharge current values integrated by discharge current integration unit 633, and calculates the integrated discharge capacity value again.

The third current value acquisition unit 637 acquires, from the recording unit 12, information regarding the current value of the lead-acid battery B input to the recording unit 12 via the measurement unit 11 from the start to the end of the processing in the state determination unit 13.

In addition, the charge/discharge determination unit 638 determines whether the lead-acid battery B is in a discharge state, the stop state, or the charge state based on the current value of the lead-acid battery B acquired by the third current value acquisition unit 637.

Here, in a case where the current value of the lead-acid battery B acquired by the third current value acquisition unit 637 is smaller than the first threshold (the current value < the first threshold), the charge/discharge determination unit 438 determines that the lead-acid battery B is in the discharge (n-th discharge Dn) state,

in a case where the first threshold $\leq$ the current value $\leq$ a second threshold, the charge/discharge determination unit 438 determines that the lead-acid battery B is in the stop state, and

in a case where the current value > the second threshold, the charge/discharge determination unit 438 determines that the lead-acid battery B is in the charge (n+1-th charge Cn+1) state.

The first threshold is the same value as the above-described first threshold, and the second threshold is a positive current value near 0 amperes.

Further, the current value/voltage value acquisition unit 639 acquires, from the recording unit 12, information regarding the current value of the lead-acid battery B and information regarding a voltage value $V_{meas}$ input to the recording unit 12 via the measurement unit 11 from the start to the end of the processing in the state determination unit 13.

In addition, the charge determination unit 640 determines whether or not the lead-acid battery B is in the charge state based on the current value of the lead-acid battery B acquired by the current value/voltage value acquisition unit 639.

Here, in a case where the current value of the lead-acid battery B acquired by the current value/voltage value acquisition unit 639 is smaller than the second threshold (the current value < the second threshold), the charge determination unit 640 determines that the lead-acid battery B is not in the charge state (the lead-acid battery B is in the discharge (n+1-th discharge Dn+1) state),

in a case where the current value = the second threshold, the charge determination unit 640 determines that the lead-acid battery B is not in the charge state (the stop state), and

in a case where the current value > the second threshold, the charge determination unit 640 determines that the lead-acid battery B is in the charge (n+1-th charge Cn+1) state.

The first threshold and the second threshold are the same values as those described above.

The upper limit voltage calculation unit 461 calculates the upper limit voltage which is the highest voltage when the lead-acid battery B is charged. More specifically, in a case where it is determined by the charge determination unit 640 that the determination result indicates the charge (n+1-th charge Cn+1) state, similarly to the upper limit voltage calculation unit 133 of the first embodiment, it is determined whether or not the voltage value ($V_{meas}$) acquired by the current value/voltage value acquisition unit 639 exceeds a voltage already set as the peak voltage $V_{pp}$ acquired from the recording unit 12. In a case where the voltage value ($V_{meas}$) exceeds the peak voltage $V_{pp}$, the voltage value ($V_{meas}$) is newly set as the peak voltage $V_{pp}$, and in a case where the voltage value ($V_{meas}$) does not exceed the peak voltage $V_{pp}$, the voltage value already set as the peak voltage $V_{pp}$ is set as the peak voltage $V_{pp}$. Then, this setting is repeated until it is determined that the current value acquired by the current value/voltage value acquisition unit 639 indicates that the lead-acid battery B is not in the charge state (the discharge (n+1-th discharge Dn+1) state or the stop state), and the finally set peak voltage $V_{pp}$ is calculated as the peak voltage $V_{pp}$. That is, as illustrated in FIG. 21, the upper limit voltage calculation unit 641 calculates the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation as the upper limit voltage.

Here, the reason why the peak voltage $V_{pp,\ end(n+1)}$ is set as the upper limit voltage is that the peak voltage during the charge is set as the upper limit voltage because the voltage rapidly decreases when the charge current is not applied as illustrated in FIG. 6.

Next, in a case where it is determined by the charge determination unit 640 that the lead-acid battery B is not in the charge state (the discharge (n+1-th discharge Dn+1) state), the capacity turnover value calculation unit 642 calculates the capacity turnover value during operation (hereinafter, referred to as the CT value during operation).

An internal configuration of the capacity turnover value calculation unit 642 will be described in more detail below. FIG. 31 is a block diagram illustrating an internal configuration of the capacity turnover value calculation unit 443 included in the state determination unit 13 illustrated in FIG. 30.

The capacity turnover value calculation unit 642 includes a previous capacity turnover value acquisition unit 642a, an integrated discharge capacity acquisition unit 642b, a rated capacity acquisition unit 642c, an upper limit voltage acquisition unit 642d, an upper-limit-voltage-based correction coefficient calculation unit 642e, and a capacity turnover value computation unit 642f.

The previous capacity turnover value acquisition unit 642a acquires, from the recording unit 12, a capacity turnover value before the start of the processing in the state determination unit 13 (before the time point a2 in FIG. 21) (hereinafter, referred to as a previous CT value). The previous CT value is a CT value during operation calculated by the capacity turnover value calculation unit 642 at the time of the previous processing in the state determination unit 13, and already input from the capacity turnover value calculation unit 642 to the recording unit 12.

The integrated discharge capacity acquisition unit 642b acquires the integrated discharge capacity value calculated again by the discharge current integration stop unit 636.

Further, the rated capacity acquisition unit 642c acquires information regarding the rated capacity (Ah) of the lead-acid battery B from the recording unit 12.

The upper limit voltage acquisition unit 642d acquires information regarding the upper limit voltage calculated by the upper limit voltage calculation unit 641.

The upper-limit-voltage-based correction coefficient calculation unit 642e calculates the upper-limit-voltage-based correction coefficient $K_{HV}$ by using the upper limit voltage acquired by the upper limit voltage acquisition unit 642d. The upper-limit-voltage-based correction coefficient $K_{HV}$ is calculated with reference to a graph illustrating a relationship between the upper limit voltage and the upper-limit-voltage-based correction coefficient $K_{HV}$ illustrated in FIG. 11. Here, in FIG. 11, the upper-limit-voltage-based correction coefficient $K_{HV}$ between the respective numerical values is calculated by creating an approximation curve from values of two adjacent points. However, in a case where the upper limit voltage is 57 V or less, the upper-limit-voltage-based correction coefficient $K_{HV} = 1$, which is constant.

Furthermore, the capacity turnover value computation unit 642f calculates the CT value during operation by Formula (5) described above using the previous CT value acquired by the previous capacity turnover value acquisition unit 642a, the integrated discharge capacity from the start of the discharge of the lead-acid battery B acquired by the integrated discharge capacity acquisition unit 642b, the rated capacity (Ah) of the lead-acid battery B acquired by the rated capacity acquisition unit 642c, and the upper-limit-voltage-based correction coefficient $K_{HV}$ calculated by the upper-limit-voltage-based correction coefficient calculation unit 642e.

Then, the life estimation unit 643 estimates the remaining life of the lead-acid battery B by comparing the CT value from the beginning to the end of life acquired from the recording unit 12 with the CT value during operation calculated by the capacity turnover value calculation unit 642. That is, the life estimation unit 643 estimates the remaining life of the lead-acid battery B from a CT value obtained by subtracting the CT value during operation from the CT value from the beginning to the end of life.

Then, the life estimation unit 643 records an estimation result of the life estimation unit 643 including the CT value during operation in the recording unit 12. The life estimation unit 643 sets the peak voltage $V_{pp}$ calculated by the upper limit voltage calculation unit 641 to 0 and records the peak voltage $V_{pp}$ in the recording unit 12.

As described above, in the lead-acid battery system S according to the sixth embodiment, the capacity turnover value calculation unit 642 calculates the CT value during operation by using the upper-limit-voltage-based correction coefficient $K_{HV}$ calculated based on the upper limit voltage calculated by the upper limit voltage calculation unit 641 that calculates the upper limit voltage which is the highest voltage when the lead-acid battery B is charged. As a result, the CT value during operation can be calculated in consideration of the upper limit voltage, the progress of corrosion of a positive electrode and softening of an active material due to electrolyte loss can be considered, and the lead-acid battery system S capable of accurately estimating the remaining life of the lead-acid battery can be provided.

In the lead-acid battery system S according to the sixth embodiment, the upper limit voltage calculation unit 641 calculates the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation as the upper limit voltage, and the capacity turnover value calculation unit 642 calculates the upper-limit-voltage-based correction coefficient $K_{HV}$ calculated by the upper limit voltage calculation unit 641. As a result, the upper limit voltage can be calculated by calculating the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation, and the upper-limit-voltage-based correction coefficient $K_{HV}$ can be appropriately calculated based on the calculated upper limit voltage.

In the lead-acid battery system S according to the sixth embodiment, in a case where the lead-acid battery B is a bipolar lead-acid battery, it is possible to provide the lead-acid battery system S capable of accurately estimating the remaining life of the bipolar lead-acid battery.

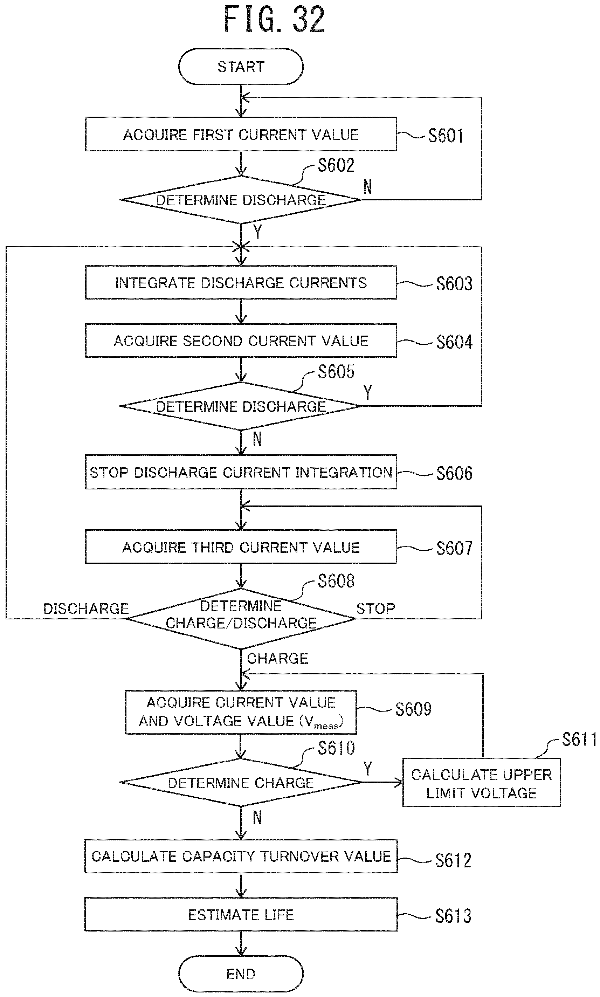

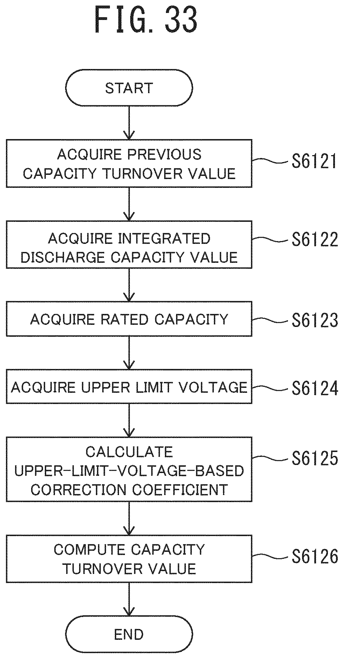

Next, a lead-acid battery life estimation method according to the sixth embodiment will be described with reference to a flowchart illustrating a flow of the processing in the state determination unit illustrated in FIG. 32 and a flowchart illustrating a flow of processing of step S612 (capacity turnover value calculation step) in the flowchart of FIG. 32 illustrated in FIG. 33.

The state determination unit 13 starts the processing from the time point a2 in FIG. 21. First, as illustrated in FIG. 32, in step S601, the first current value acquisition unit 631 of the state determination unit 13 acquires, from the recording unit 12, information regarding the current value of the lead-acid battery B input to the recording unit 12 via the measurement unit 11 from the start to the end (the time point b2 in FIG. 21) of the processing in the state determination unit 13 (first current value acquisition step).

Next, in step S602, the discharge determination unit 632 determines whether or not the lead-acid battery B is in the discharge (n-th discharge Dn) state based on the current value of the lead-acid battery B acquired in step S601 (discharge determination step). Specifically, in a case where the current value of the lead-acid battery B acquired in step S601 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n-th charge Cn) state). The first threshold is a value similar to that described above.

Then, in a case where the determination result in step S602 indicates the discharge (n-th discharge Dn) state, the processing proceeds to step S603, and in a case where the determination result in step S602 does not indicate the discharge (n-th discharge Dn) state (the stop state or the charge (n-th charge Cn) state), the processing returns to step S601.

In step S603, the discharge current integration unit 633 integrates the discharge current values from the start of the discharge of the lead-acid battery B, and calculates the integrated discharge capacity value from the start of the discharge of the lead-acid battery B (integrated discharge capacity value calculation step).

Next, in step S604, the second current value acquisition unit 634 acquires, from the recording unit 12, information regarding the current value of the lead-acid battery B input to the recording unit 12 via the measurement unit 11 from the start to the end of the processing in the state determination unit 13 (second current value acquisition step).

Next, in step S605, the discharge determination unit 635 determines whether or not the lead-acid battery B is in the discharge (n-th discharge Dn) state based on the current value of the lead-acid battery B acquired in step S604 (discharge determination step). Specifically, in a case where the current value of the lead-acid battery B acquired in step S604 is smaller than the first threshold, it is determined that the lead-acid battery B is in the discharge (n-th discharge Dn) state, and in a case where the current value is equal to or larger than the first threshold, it is determined that the lead-acid battery B is not in the discharge (n-th discharge Dn) state (the stop state or the charge (n+1-th charge Cn+1) state). The first threshold is a value similar to the first threshold described above.

Then, in a case where the determination result in step S605 indicates the discharge (n-th discharge Dn) state, the processing returns to step S603, and in a case where the determination result in step S605 does not indicate the discharge (n-th discharge Dn) state (the stop state or the charge (n+1-th charge Cn+1) state), the processing proceeds to step S606.

In step S606, the discharge current integration stop unit 636 stops the integration of the discharge current values integrated in step S603, and calculates the integrated discharge capacity value again (discharge current integration stop step).

Next, in step S607, the third current value acquisition unit 437 acquires, from the recording unit 12, information regarding the current value of the lead-acid battery B input to the recording unit 12 via the measurement unit 11 from the start to the end of the processing in the state determination unit 13 (third current value acquisition step).

Next, in step S608, the charge/discharge determination unit 638 determines whether the lead-acid battery B is in the discharge state, the stop state, or the charge state based on the current value of the lead-acid battery B acquired in step 607 (charge/discharge determination step).

Here, in a case where the current value of the lead-acid battery B acquired in step S607 is smaller than the first threshold (the current value < the first threshold), the charge/discharge determination unit 638 determines that the lead-acid battery B is in the discharge (n-th discharge Dn) state,

in a case where the first threshold ≤ the current value ≤ the second threshold, the charge/discharge determination unit 638 determines that the lead-acid battery B is in the stop state, and
in a case where the current value > the second threshold, the charge/discharge determination unit 638 determines that the lead-acid battery B is in the charge (n+1-th charge Cn+1) state.

The first threshold and the second threshold are values similar to those described above.

In a case where the determination result in step S608 indicates the discharge state, the processing returns to step S603. In a case where the determination result in step S608 indicates the stop state, the processing returns to step S607. In a case where the determination result in step S608 indicates the charge state, the processing proceeds to step S609.

In step S609, the current value/voltage value acquisition unit 639 acquires, from the recording unit 12, information regarding the current value and information regarding the voltage value $V_{meas}$ of the lead-acid battery B input to the recording unit 12 via the measurement unit 11 from the start to the end of the processing in the state determination unit 13 (current value/voltage value acquisition step).

Next, in step S610, the charge determination unit 640 determines whether or not the lead-acid battery B is in the charge state based on the current value of the lead-acid battery B acquired in step S609 (charge determination step).

Here, in a case where the current value of the lead-acid battery B acquired in step S609 is smaller than the second threshold (the current value < the second threshold), the charge determination unit 640 determines that the lead-acid battery B is not in the charge state (the lead-acid battery B is in the discharge (n+1-th discharge Dn+1) state),

in a case where the current value = the second threshold, the charge determination unit 640 determines that the lead-acid battery B is not in the charge state (the stop state), and
in a case where the current value > the second threshold, the charge determination unit 640 determines that the lead-acid battery B is in the charge (n+1-th charge Cn+1) state.

The first threshold and the second threshold are the same values as those described above.

In a case where the determination result in step S610 indicates the charge (n+1-th charge Cn+1) state, the processing proceeds to step S611, and in a case where the determination result in step S610 indicates the discharge (n+1-th discharge Dn+1) state or the stop state), the processing proceeds to step S612.

In step S611, the upper limit voltage calculation unit 641 calculates the upper limit voltage which is the highest voltage when the lead-acid battery B is charged (upper limit voltage calculation step). More specifically, similarly to step S3 (upper limit voltage calculation step) of the first embodiment, it is determined whether or not the voltage value ($V_{meas}$) acquired in step S609 exceeds the voltage already set as the peak voltage $V_{pp}$ acquired from the recording unit 12. In a case where the voltage value ($V_{meas}$) exceeds the peak voltage $V_{pp}$, the voltage value ($V_{meas}$) is newly set as the peak voltage $V_{pp}$. In a case where the voltage value ($V_{meas}$) does not exceed the peak voltage $V_{pp}$, the voltage value already set as the peak voltage $V_{pp}$ is set as the peak voltage $V_{pp}$. Then, this setting is repeated until it is determined that the current value acquired in step S609 indicates that the lead-acid battery B is not in the charge state (the discharge (n+1-th discharge Dn+1) state or the stop state), and the finally set peak voltage $V_{pp}$ is calculated as the peak voltage $V_{pp}$. That is, in step S611, as illustrated in FIG. 21, the upper limit voltage calculation unit 641 calculates the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation as the upper limit voltage.

Next, in step S612, the capacity turnover value calculation unit 642 calculates the capacity turnover value during operation (hereinafter, referred to as the CT value during operation) (capacity turnover value calculation step).

A detailed flow of processing in the capacity turnover value calculation unit 642 in step S612 will be described with reference to FIG. 33.

First, in step S6121, the previous capacity turnover value acquisition unit 642a acquires, from the recording unit 12, a capacity turnover value before the start of the processing in the state determination unit 13 (before the time point a2 in FIG. 21) (hereinafter, referred to as a previous CT value) (previous CT value acquisition step). The previous CT value is a CT value during operation calculated by the capacity turnover value calculation unit 642 at the time of the previous processing in the state determination unit 13, and already input from the capacity turnover value calculation unit 642 to the recording unit 12.

Next, in step S6122, the integrated discharge capacity acquisition unit 642b acquires the integrated discharge capacity value calculated again in step S606 (integrated discharge capacity value acquisition step).

Next, in step S6123, the rated capacity acquisition unit 642c acquires information regarding the rated capacity (Ah) of the lead-acid battery B from the recording unit 12 (rated capacity acquisition step).

Next, in step S6124, the upper limit voltage acquisition unit 642d acquires information regarding the upper limit voltage calculated in step S611 (upper limit voltage acquisition step).

Next, in step S6125, the upper-limit-voltage-based correction coefficient calculation unit 642e calculates the upper-limit-voltage-based correction coefficient $K_{HV}$ by using the upper limit voltage acquired in step S6124 (upper-limit-voltage-based correction coefficient calculation step). The upper-limit-voltage-based correction coefficient $K_{HV}$ is calculated with reference to a graph illustrating a relationship between the upper limit voltage and the upper-limit-voltage-based correction coefficient $K_{HV}$ illustrated in FIG. 11. Here, in FIG. 11, the upper-limit-voltage-based correction coefficient $K_{HV}$ between the respective numerical values is calculated by creating an approximation curve from values of two adjacent points. However, in a case where the upper limit voltage is 57 V or less, the upper-limit-voltage-based correction coefficient $K_{HV} = 1$, which is constant.

Next, in step S6126, the capacity turnover value computation unit 642f calculates the CT value during operation by Formula (5) described above using the previous CT value acquired in step S6121, the integrated discharge capacity from the start of the discharge of the lead-acid battery B acquired in step S6122, the rated capacity (Ah) of the lead-acid battery B acquired in step S6123, and the upper-limit-voltage-based correction coefficient $K_{HV}$ calculated in step S6125.

As a result, the processing in the capacity turnover value calculation unit 642 in step S612 ends.

In step S613, the life estimation unit 643 estimates the remaining life of the lead-acid battery B by comparing the CT value from the beginning to the end of life acquired from the recording unit 12 with the CT value during operation calculated in step S642. That is, the life estimation unit 643 estimates the remaining life of the lead-acid battery B from a CT value obtained by subtracting the CT value during operation from the CT value from the beginning to the end of life.

Then, the life estimation unit 643 records an estimation result of the life estimation unit 643 including the CT value during operation in the recording unit 12. The life estimation unit 643 sets the peak voltage $V_{pp}$ calculated by the upper limit voltage calculation unit 641 to 0 and records the peak voltage $V_{pp}$ in the recording unit 12.

Accordingly, the processing in the state determination unit 13 ends.

As described above, in the lead-acid battery life estimation method according to the sixth embodiment, in the capacity turnover value calculation step (step S612), the CT value during operation is calculated using the upper-limit-voltage-based correction coefficient $K_{HV}$ calculated based on the upper limit voltage calculated in the upper limit voltage calculation step (step S611) of calculating the upper limit voltage which is the highest voltage when the lead-acid battery B is charged. As a result, the CT value during operation can be calculated in consideration of the upper limit voltage, the progress of corrosion of a positive electrode and softening of an active material due to electrolyte loss can be considered, and the lead-acid battery life estimation method capable of accurately estimating the remaining life of the lead-acid battery can be provided.

In the lead-acid battery life estimation method according to the sixth embodiment, in the upper limit voltage calculation step (step S611), the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation is calculated as the upper limit voltage, and in the capacity turnover value calculation step (step S612), the upper-limit-voltage-based correction coefficient $K_{HV}$ is calculated based on the upper limit voltage calculated in the upper limit voltage calculation step (step S611). As a result, the upper limit voltage can be calculated by calculating the peak voltage $V_{pp,end(n+1)}$ at the end of the next charge (n+1-th charge Cn+1) after the end of the discharge (n-th discharge Dn) of the lead-acid battery B to be subjected to calculation of the capacity turnover value during operation, and the upper-limit-voltage-based correction coefficient $K_{HV}$ can be appropriately calculated based on the calculated upper limit voltage.

In the lead-acid battery life estimation method according to the sixth embodiment, in a case where the lead-acid battery B is a bipolar lead-acid battery, it is possible to provide a lead-acid battery life estimation method capable of accurately estimating the remaining life of the bipolar lead-acid battery.

Although the embodiments of the present invention have been described above, the present invention is not limited thereto, and various modifications and improvements can be made therein.

For example, in the lead-acid battery system S and the lead-acid battery life estimation method according to the first and second embodiments, the upper limit SOC calculation units 134 and 233 calculate $SOC_{sta(n)}$ at the start of the discharge (n-th discharge Dn) of the lead-acid battery B to be subjected to calculation of the CT value during operation as the upper limit SOC.

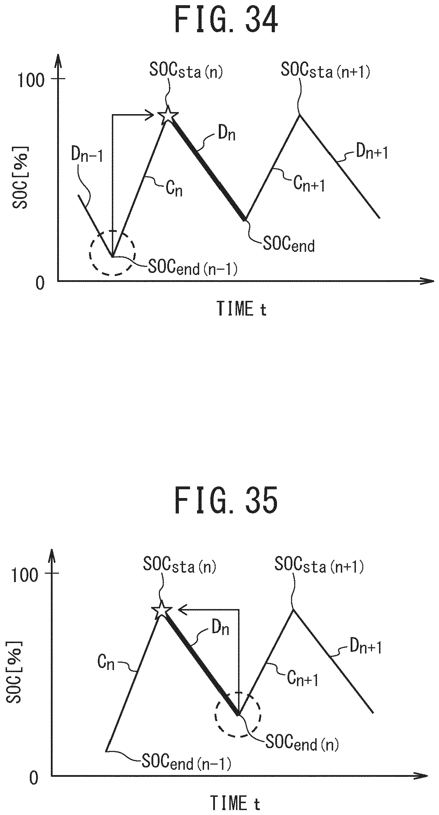

In this case, as illustrated in FIG. 34, $SOC_{end(n-1)}$ after the end of the discharge (n-1-th discharge Dn-1) before the discharge (n-th discharge Dn) of the lead-acid battery B to be subjected to calculation of the CT value during operation may be calculated, and the charge amount at the time of the charge (n-th charge Cn) may be added to calculate $SOC_{sta(n)}$ at the start of the discharge (n-th discharge Dn) as the upper limit SOC.

That is, the upper limit SOC calculation units 134 and 233 acquire, from the recording units 12, the rated capacity, the total charge amount of the lead-acid battery B from the completion of the equalization charge to the end time point of the n-1-th discharge Dn-1 recorded in the recording unit 12 at the end of the n-1-th discharge Dn-1, and the total discharge amount (negative value) of the lead-acid battery B from the completion of the equalization charge to the end time point of the n-1-th discharge Dn-1 recorded in the recording unit 12 at the end of the n-1-th discharge Dn-1, and calculate $SOC_{end(n-1)}$ by the following Formula (7) .
[Mathematical Formula 7]

$$SOC_{end(n-1)} = \frac{(\text{Rated capacity} + \text{Total charge amount} + \text{Total discharge amount})}{\text{Rated capacity}} \times 100 \qquad \cdots (7)$$

Next, the charge amount at the time of the charge (n-th charge Cn) is acquired from the recording unit 12, and $SOC_{sta(n)}$ at the start of the discharge (n-th discharge Dn) is calculated as the upper limit SOC by the following Formula (8) in addition to the total charge amount of Formula (7).
[Mathematical Formula 8]

$$SOC_{sta(n)} = \frac{(\text{Rated capacity} + \text{Total charge amount} + \text{Charge amount} + \text{Total discharge amount})}{\text{Rated capacity}} \times 100 \qquad \cdots (8)$$

In the lead-acid battery system S and the lead-acid battery life estimation method according to the first and second embodiments, when the upper limit SOC calculation units 134 and 233 calculate $SOC_{sta(n)}$ at the start of the discharge (n-th discharge Dn) of the lead-acid battery B to be subjected to calculation of the CT value during operation as the upper limit SOC, as illustrated in FIG. 35, $SOC_{end(n)}$ after the end of the discharge (n-th discharge Dn) of the lead-acid battery B to be subjected to calculation of the CT value during operation may be calculated, and then the discharge amount (negative value) at the time of the discharge (n-th discharge Dn) may be subtracted to calculate $SOC_{sta(n)}$ at the start of the discharge (n-th discharge Dn) as the upper limit SOC.

That is, the upper limit SOC calculation units 134 and 233 acquire the rated capacity, the total charge amount of the lead-acid battery B from the completion of the equalization charge to the end time point of the n-th discharge Dn recorded in the recording unit 12 at the end of the n-th discharge Dn, and the total discharge amount (negative value) of the lead-acid battery B from the completion of the equalization charge to the end time point of the n-th discharge Dn recorded in the recording unit 12 at the end of the n-th discharge Dn from the recording unit 12, and calculate $SOC_{end(n)}$ by the following Formula (9).

[Mathematical Formula 9]

$$SOC_{end(n)} = \frac{(\text{Rated capacity} + \text{Total charge amount} + \text{Total discharge amount})}{\text{Rated capacity}} \times 100 \quad \cdots (9)$$

Next, the discharge amount (negative value) at the time of the discharge (n-th discharge Dn) is acquired from the recording unit 12, and the discharge amount is subtracted from the total discharge amount in Formula (9) to calculate $SOC_{sta(n)}$ at the start of the discharge (n-th discharge Dn) as the upper limit SOC by the following Formula (10).

[Mathematical Formula 10]

$$SOC_{sta(n)} =$$
$$\frac{(\text{Rated capacity} + \text{Total charge amount} + \text{Total discharge amount} - \text{Discharge amount})}{\text{Rated capacity}} \times 100 \quad \cdots (10)$$

In the lead-acid battery systems S and the lead-acid battery life estimation method according to the fourth and fifth embodiments, the upper limit SOC calculation units 442 and 541 calculate $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC.

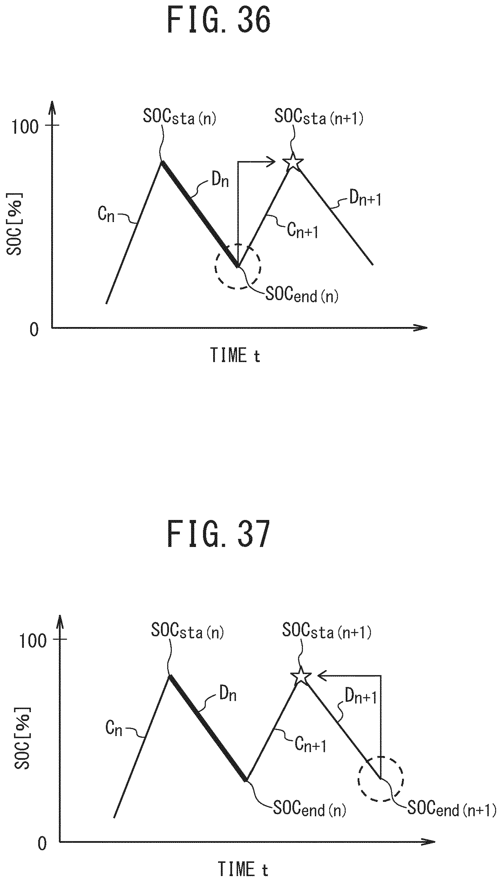

In this case, as illustrated in FIG. 36, $SOC_{end(n)}$ after the end of the discharge (n-th discharge Dn) of the lead-acid battery B to be subjected to calculation of the capacity turnover value during operation is calculated, and the charge amount at the time of the next charge (n+1-th charge Cn+1) may be added to calculate $SOC_{sta(n+1)}$ at the end of the charge (n+1-th charge Cn+1) as the upper limit SOC.

That is, the upper limit SOC calculation units 442 and 541 acquire the rated capacity, the total charge amount of the lead-acid battery B from the completion of the equalization charge to the end time point of the n-th discharge Dn recorded in the recording unit 12 at the end of the n-th discharge Dn, and the total discharge amount (negative value) of the lead-acid battery B from the completion of the equalization charge to the end time point of the n-th discharge Dn recorded in the recording unit 12 at the end of the n-th discharge Dn from the recording unit 12, and calculate $SOC_{end(n)}$ by the following Formula (11).

[Mathematical Formula 11]

$$SOC_{end(n)} = \frac{(\text{Rated capacity} + \text{Total charge amount} + \text{Total discharge amount})}{\text{Rated capacity}} \times 100 \quad \cdots (11)$$

Next, the charge amount at the time of the next charge (n+1-th charge Cn+1) is acquired from the recording unit 12, and $SOC_{sta(n+1)}$ at the end of the charge (n+1-th charge Cn+1) is calculated as the upper limit SOC by the following Formula (12) in addition to the total charge amount of Formula (11).

[Mathematical Formula 12]

$$SOC_{sta(n+1)} = \frac{(\text{Rated capacity} + \text{Total charge amount} + \text{Charge amount} + \text{Total discharge amount})}{\text{Rated capacity}} \times 100 \quad \cdots (12)$$

In the lead-acid battery systems S and the lead-acid battery life estimation method according to the fourth and fifth embodiments, when the upper limit SOC calculation units 442 and 541 calculate $SOC_{sta(n+1)}$ at the end of the next charge (n+1-th charge Cn+1) after the end of the discharge (n-th discharge Dn) of the lead-acid battery B to be subjected to calculation of the capacity turnover value during operation as the upper limit SOC, as illustrated in FIG. 37, $SOC_{end(n+1)}$ at the end of the next discharge (n+1-th discharge Dn+1) after the end of the discharge (n-th discharge Dn) of the lead-acid battery B to be subjected to calculation of the CT value during operation may be calculated, and the discharge amount (negative value) at the time of the discharge (n+1-th discharge Dn+1) may be subtracted to calculate $SOC_{sta(n+1)}$ at the end of the charge (n+1-th charge Cn+1) as the upper limit SOC.

That is, the upper limit SOC calculation units 134 and 233 acquire, from the recording units 12, the rated capacity, the total charge amount of the lead-acid battery B from the completion of the equalization charge to the end time point of the n+1-th discharge Dn+1 recorded in the recording unit 12 at the end of the n+1-th discharge Dn+1, and the total discharge amount (negative value) of the lead-acid battery B from the completion of the equalization charge to the end time point of the n+1-th discharge Dn+1 recorded in the recording unit 12 at the end of the n+1-th discharge Dn+1, and calculate $SOC_{end(n-1)}$ by the following Formula (13) .

[Mathematical Formula 13]

$$SOC_{end(n+1)} = \frac{(\text{Rated capacity} + \text{Total charge amount} + \text{Total discharge amount})}{\text{Rated capacity}} \times 100$$

$$\cdots (13)$$

Next, the discharge amount (negative value) at the time of the discharge (n+1-th discharge Dn+1) is acquired from the recording unit 12, and the discharge amount is subtracted from the total discharge amount in Formula (13) to calculate $SOC_{sta(n+1)}$ at the end of the charge (n+1-th charge Cn+1) as the upper limit SOC by the following Formula (14).

[Mathematical Formula 14]

$$SOC_{sta(n+1)} = $$
$$\frac{(\text{Rated capacity} + \text{Total charge amount} + \text{Total discharge amount} - \text{Discharge amount})}{\text{Rated capacity}} \times 100$$

$$\cdots (14)$$

In the lead-acid battery system S and the lead-acid battery life estimation method according to the first, second, fourth, and fifth embodiments, the upper-limit-SOC-based correction coefficient $K_{HSOC}$ is calculated with reference to the graph illustrating the relationship between the upper limit SOC and the upper-limit-SOC-based correction coefficient $K_{HSOC}$ illustrated in FIG. 10. However, in a case where the upper-limit-SOC-based correction coefficient $K_{HSOC}$ is calculated using the upper limit SOC, the upper-limit-SOC-based correction coefficient $K_{HSOC}$ does not necessarily need to be calculated with reference to the graph illustrated in FIG. 10.

In the lead-acid battery system S and the lead-acid battery life estimation method according to the first, third, fourth, and sixth embodiments, the upper-limit-voltage-based correction coefficient $K_{HV}$ is calculated with reference to the graph illustrating the relationship between the upper limit voltage and the upper-limit-voltage-based correction coefficient $K_{HV}$ illustrated in FIG. 11. However, in a case where the upper-limit-voltage-based correction coefficient $K_{HV}$ is calculated using the upper limit voltage, the upper-limit-voltage-based correction coefficient $K_{HV}$ does not necessarily need to be calculated with reference to the graph illustrated in FIG. 11.

Industrial Applicability

The lead-acid battery system and the lead-acid battery life estimation method according to the present invention can accurately estimate a remaining life of a lead-acid battery by calculating a capacity turnover value during operation in consideration of at least one of an upper limit SOC or an upper limit voltage, and thus can be extremely advantageously used in various industries.

Reference Signs List

1 BMU
2 EMS
3 PCS
11 Measurement unit
12 Recording unit
13 State determination unit
14 Setting unit

15 Communication unit
131 First current value/voltage value acquisition unit
132 Discharge determination unit
133 Upper limit voltage calculation unit
134 Upper limit SOC calculation unit
135 Discharge current integration unit
136 Second current value/voltage value acquisition unit
137 Charge/discharge determination unit
138 Capacity turnover value calculation unit
138a Previous capacity turnover value acquisition unit
138b Integrated discharge capacity acquisition unit
138c Rated capacity acquisition unit
138d Upper limit SOC acquisition unit
138e Upper-limit-SOC-based correction coefficient calculation unit
138f Upper limit voltage acquisition unit
138g Upper-limit-voltage-based correction coefficient calculation unit
138h Capacity turnover value computation unit
139 Life estimation unit
231 First current value acquisition unit
232 Discharge determination unit
233 Upper limit SOC calculation unit
234 Discharge current integration unit
235 Second current value acquisition unit
236 Charge/discharge determination unit
237 Capacity turnover value calculation unit
237a Previous capacity turnover value acquisition unit
237b Integrated discharge capacity acquisition unit
237c Rated capacity acquisition unit
237d Upper limit SOC acquisition unit
237e Upper-limit-SOC-based correction coefficient calculation unit
237f Capacity turnover value computation unit
238 Life estimation unit
331 First current value/voltage value acquisition unit
332 Discharge determination unit
333 Upper limit voltage calculation unit
334 Discharge current integration unit
335 Second current value/voltage value acquisition unit
336 Charge/discharge determination unit
337 Capacity turnover value calculation unit
337a Previous capacity turnover value acquisition unit
337b Integrated discharge capacity acquisition unit
337c Rated capacity acquisition unit
337d Upper limit voltage acquisition unit
337e Upper-limit-voltage-based correction coefficient calculation unit
337f Capacity turnover value computation unit
338 Life estimation unit
431 First current value acquisition unit
432 Discharge determination unit
433 Discharge current integration unit
434 Second current value acquisition unit
435 Discharge determination unit
436 Discharge current integration stop unit
437 Third current value acquisition unit
438 Charge/discharge determination unit
439 Current value/voltage value acquisition unit
440 Charge determination unit
441 Upper limit voltage calculation unit
442 Upper limit SOC calculation unit

443 Capacity turnover value calculation unit

443a Previous capacity turnover value acquisition unit

443b Integrated discharge capacity acquisition unit

443c Rated capacity acquisition unit

443d Upper limit SOC acquisition unit

443e Upper-limit-SOC-based correction coefficient calculation unit

443f Upper limit voltage acquisition unit

443g Upper-limit-voltage-based correction coefficient calculation unit

443h Capacity turnover value computation unit

444 Life estimation unit

531 First current value acquisition unit

532 Discharge determination unit

533 Discharge current integration unit

534 Second current value acquisition unit

535 Discharge determination unit

536 Discharge current integration stop unit

537 Third current value acquisition unit

538 Charge/discharge determination unit

539 Fourth current value acquisition unit

540 Charge determination unit

541 Upper limit SOC calculation unit

542 Capacity turnover value calculation unit

542a Previous capacity turnover value acquisition unit

542b Integrated discharge capacity acquisition unit

542c Rated capacity acquisition unit

542d Upper limit SOC acquisition unit

542e Upper-limit-SOC-based correction coefficient calculation unit

542f Capacity turnover value computation unit

543 Life estimation unit

631 First current value acquisition unit

632 Discharge determination unit

633 Discharge current integration unit

634 Second current value acquisition unit

635 Discharge determination unit

636 Discharge current integration stop unit

637 Third current value acquisition unit

638 Charge/discharge determination unit

639 Current value/voltage value acquisition unit

640 Charge determination unit

641 Upper limit voltage calculation unit

642 Capacity turnover value calculation unit

642a Previous capacity turnover value acquisition unit

642b Integrated discharge capacity acquisition unit

642c Rated capacity acquisition unit

642d Upper limit voltage acquisition unit

642e Upper-limit-voltage-based correction coefficient calculation unit

642f Capacity turnover value computation unit

643 Life estimation unit

B Lead-acid battery

S Lead-acid battery system

**Claims**

1. A lead-acid battery system configured to estimate a remaining life of a lead-acid battery by comparing a capacity turnover value from a beginning to an end of life with a capacity turnover value during operation, the lead-acid battery system comprising:

a capacity turnover value calculation unit configured to calculate the capacity turnover value during operation, wherein the capacity turnover value calculation unit calculates the capacity turnover value during operation by using at least one of an upper-limit-state-of-charge (SOC)-based correction coefficient calculated based on an upper limit SOC calculated by an upper limit SOC calculation unit configured to calculate the upper limit SOC which is an SOC having a largest value when the lead-acid battery is charged, or an upper-limit-voltage-based correction coefficient calculated based on an upper limit voltage calculated by an upper limit voltage calculation unit configured to calculate the upper limit voltage which is a highest voltage when the lead-acid battery is charged.

2. The lead-acid battery system according to claim 1, wherein the upper limit SOC calculation unit calculates, as the upper limit SOC, an SOC at a start of a discharge of the lead-acid battery to be subjected to calculation of the capacity turnover value during operation, and the capacity turnover value calculation unit calculates the upper-limit-SOC-based correction coefficient based on the upper limit SOC calculated by the upper limit SOC calculation unit.

3. The lead-acid battery system according to claim 1, wherein the upper limit SOC calculation unit calculates, as the upper limit SOC, an SOC at an end of a next charge after an end of a discharge of the lead-acid battery to be subjected to calculation of the capacity turnover value during operation, and the capacity turnover value calculation unit calculates the upper-limit-SOC-based correction coefficient based on the upper limit SOC calculated by the upper limit SOC calculation unit.

4. The lead-acid battery system according to claim 1, wherein the upper limit voltage calculation unit calculates, as the upper limit voltage, a peak voltage at an end of a charge immediately before a discharge of the lead-acid battery to be subjected to calculation of the capacity turnover value during operation, and the capacity turnover value calculation unit calculates the upper-limit-voltage-based correction coefficient based on the upper limit voltage calculated by the upper limit voltage calculation unit.

5. The lead-acid battery system according to claim 1, wherein the upper limit voltage calculation unit calculates, as the upper limit voltage, a peak voltage at an end of a next charge after an end of a discharge of the lead-acid battery to be subjected to calculation of the capacity turnover value during operation, and the capacity turnover value calculation unit calculates the upper-limit-voltage-based correction coefficient based on the upper limit voltage calculated by the upper limit voltage calculation unit.

6. The lead-acid battery system according to any one of claims 1 to 5, wherein the lead-acid battery is a bipolar lead-acid battery.

7. A lead-acid battery life estimation method in which a remaining life of a lead-acid battery is estimated by comparing a capacity turnover value from a beginning to an end of life with a capacity turnover value during operation, the lead-acid battery life estimation method comprising:

a capacity turnover value calculation step of calculating the capacity turnover value during operation, wherein in the capacity turnover value calculation step, the capacity turnover value during operation is calculated by using at least one of an upper-limit-state-of-charge (SOC)-based correction coefficient calculated based on an upper limit SOC calculated in an upper limit SOC calculation step of calculating the upper limit SOC which is an SOC having a largest value when the lead-acid battery is charged, or an upper-limit-voltage-based correction coefficient calculated based on an upper limit voltage calculated in an upper limit voltage calculation step of calculating the upper limit voltage which is a highest voltage when the lead-acid battery is charged.

8. The lead-acid battery life estimation method according to claim 7, wherein in the upper limit SOC calculation step, an SOC at a start of a discharge of the lead-acid battery to be subjected to calculation of the capacity turnover value during operation is calculated as the upper limit SOC, and in the capacity turnover value calculation step, the upper-limit-SOC-based correction coefficient is calculated based on the upper limit SOC calculated in the upper limit SOC calculation step.

9. The lead-acid battery life estimation method according to claim 7, wherein in the upper limit SOC calculation step, an SOC at an end of a next charge after an end of a discharge of the lead-acid battery to be subjected to calculation of the capacity turnover value during operation is calculated as the upper limit SOC, and in the capacity turnover value calculation step, the upper-limit-SOC-based correction coefficient is calculated based on the upper limit SOC calculated by the upper limit SOC calculation unit.

10. The lead-acid battery life estimation method according to claim 7, wherein in the upper limit voltage calculation step, a peak voltage at an end of a charge immediately before a discharge of the lead-acid battery to be subjected to calculation of the capacity turnover value during operation is calculated as the upper limit voltage, and in the capacity turnover value calculation step, the upper-limit-voltage-based correction coefficient is calculated based on the upper limit voltage calculated in the upper limit voltage calculation step.

11. The lead-acid battery life estimation method according to claim 7, wherein in the upper limit voltage calculation step, a peak voltage at an end of a next charge after an end of a discharge of the lead-acid battery to be subjected to calculation of the capacity turnover value during operation is calculated as the upper limit voltage, and in the capacity turnover value calculation step, the upper-limit-voltage-based correction coefficient is calculated based on the upper limit voltage calculated in the upper limit voltage calculation step.

12. The lead-acid battery life estimation method according to any one of claims 7 to 11, wherein the lead-acid battery is a bipolar lead-acid battery.

# FIG. 1

GRID CURRENT

LOAD —— PCS $\quad$ 3 $\quad$ ←—————— EMS $\quad$ 2

LEAD-ACID BATTERY $\quad$ B $\quad$ ←——————→ BMU $\quad$ 1

S

# FIG. 2

1

RECORDING UNIT $\quad$ 12 $\quad$ ←—— MEASUREMENT UNIT $\quad$ 11

COMMUNICATION UNIT $\quad$ 15

STATE DETERMINATION UNIT $\quad$ 13 $\qquad$ SETTING UNIT $\quad$ 14

# FIG. 3

# FIG. 4

# FIG. 5

BMU

13

STATE DETERMINATION UNIT

FIRST CURRENT VALUE/VOLTAGE VALUE ACQUISITION UNIT — 131

DISCHARGE DETERMINATION UNIT — 132

UPPER LIMIT VOLTAGE CALCULATION UNIT — 133

UPPER LIMIT SOC CALCULATION UNIT — 134

DISCHARGE CURRENT INTEGRATION UNIT — 135

SECOND CURRENT VALUE/VOLTAGE VALUE ACQUISITION UNIT — 136

CHARGE/DISCHARGE DETERMINATION UNIT — 137

CAPACITY TURNOVER VALUE CALCULATION UNIT — 138

LIFE ESTIMATION UNIT — 139

RECORDING UNIT — 12

1

# FIG. 6

# FIG. 7

FROM CHARGE/DISCHARGE
DETERMINATION UNIT

138

CAPACITY TURNOVER
VALUE CALCULATION UNIT

| PREVIOUS CAPACITY TURNOVER VALUE ACQUISITION UNIT | 138a |

| INTEGRATED DISCHARGE CAPACITY ACQUISITION UNIT | 138b |

| RATED CAPACITY ACQUISITION UNIT | 138c |

| UPPER LIMIT SOC ACQUISITION UNIT | 138d |

| UPPER–LIMIT–SOC–BASED CORRECTION COEFFICIENT CALCULATION UNIT | 138e |

| UPPER LIMIT VOLTAGE ACQUISITION UNIT | 138f |

| UPPER–LIMIT–VOLTAGE–BASED CORRECTION COEFFICIENT CALCULATION UNIT | 138g |

| CCAPACITY TURNOVER VALUE COMPUTATION UNIT | 138h |

FROM
RECORDING
UNIT

TO LIFE ESTIMATION UNIT

# FIG. 8

```
              ┌─────────────┐
              │    START    │
              └──────┬──────┘
                     │
                     ▼
    ┌─────────────────────────────────┐
    │  ACQUIRE FIRST CURRENT VALUE     │── S1
    │  AND VOLTAGE VALUE (V_meas)      │
    └────────────────┬────────────────┘
                     │  S2
                     ▼
           ◇ DETERMINE ◇      N
           ◇ DISCHARGE ◇ ──────────────────────┐
                     │                          │
                     │ Y                        │
                     ▼                          │
    ┌──────────────────────────────┐           │
    │  CALCULATE UPPER LIMIT SOC    │── S4      │
    └────────────────┬─────────────┘           │
```

$$V_{meas} > V_{pp}$$

$$V_{pp} = V_{pp}$$

$$V_{pp} = V_{meas}$$

S3

S31

S33   S32

CALCULATE UPPER
LIMIT VOLTAGE

INTEGRATE DISCHARGE CURRENTS — S5

ACQUIRE SECOND CURRENT VALUE AND VOLTAGE VALUE — S6

DETERMINE CHARGE/DISCHARGE — S7

STOP    DISCHARGE    CHARGE

S8

CURRENT VALUE = 0

CALCULATE CAPACITY TURNOVER VALUE — S9

ESTIMATE LIFE — S10

END

# FIG. 9

START

ACQUIRE PREVIOUS CAPACITY TURNOVER VALUE — S91

ACQUIRE INTEGRATED DISCHARGE CAPACITY VALUE — S92

ACQUIRE RATED CAPACITY — S93

ACQUIRE UPPER LIMIT SOC — S94

CALCULATE UPPER-LIMIT-SOC-BASED CORRECTION COEFFICIENT — S95

ACQUIRE UPPER LIMIT VOLTAGE — S96

ACQUIRE UPPER-LIMIT-VOLTAGE-BASED CORRECTION COEFFICIENT — S97

COMPUTE CAPACITY TURNOVER VALUE — S98

END

# FIG. 10

# FIG. 11

# FIG. 12

# FIG. 13

FROM CHARGE/DISCHARGE
DETERMINATION UNIT

237

CAPACITY TURNOVER
VALUE CALCULATION UNIT

PREVIOUS CAPACITY TURNOVER
VALUE ACQUISITION UNIT — 237a

INTEGRATED DISCHARGE
CAPACITY ACQUISITION UNIT — 237b

RATED CAPACITY ACQUISITION UNIT — 237c

UPPER LIMIT SOC ACQUISITION UNIT — 237d

UPPER-LIMIT-SOC-BASED CORRECTION
COEFFICIENT CALCULATION UNIT — 237e

CAPACITY TURNOVER
VALUE COMPUTATION UNIT — 237f

FROM
RECORDING
UNIT

TO LIFE ESTIMATION UNIT

# FIG. 14

```
                        START

                ACQUIRE FIRST CURRENT VALUE    ~S101

                           S102
                      DETERMINE        N
                      DISCHARGE
                         Y

                CALCULATE UPPER LIMIT SOC    ~S103

                INTEGRATE DISCHARGE     ~S104
                     CURRENTS

                 ACQUIRE SECOND        ~S105
                 CURRENT VALUE

   S107          STOP    S106
                      DETERMINE         DISCHARGE
                   CHARGE/DISCHARGE
  CURRENT VALUE =0          CHARGE

                CALCULATE CAPACITY      ~S108
                 TURNOVER VALUE

                  ESTIMATE LIFE         ~S109

                        END
```

# FIG. 15

```
        START

ACQUIRE PREVIOUS
CAPACITY TURNOVER VALUE          ~ S1081

ACQUIRE INTEGRATED
DISCHARGE CAPACITY VALUE         ~ S1082

ACQUIRE RATED CAPACITY           ~ S1083

ACQUIRE UPPER LIMIT SOC          ~ S1084

CALCULATE UPPER-LIMIT-SOC-BASED
CORRECTION COEFFICIENT           ~ S1085

COMPUTE CAPACITY TURNOVER VALUE  ~ S1086

        END
```

# FIG. 16

# FIG. 17

FROM CHARGE/DISCHARGE
DETERMINATION UNIT

337

CAPACITY TURNOVER
VALUE CALCULATION UNIT

PREVIOUS CAPACITY TURNOVER
VALUE ACQUISITION UNIT — 337a

INTEGRATED DISCHARGE
CAPACITY ACQUISITION UNIT — 337b

RATED CAPACITY ACQUISITION UNIT — 337c

FROM
RECORDING
UNIT

UPPER LIMIT VOLTAGE ACQUISITION UNIT — 337d

UPPER-LIMIT-VOLTAGE-BASED CORRECTION
COEFFICIENT CALCULATION UNIT — 337e

CAPACITY TURNOVER
VALUE COMPUTATION UNIT — 337f

TO LIFE ESTIMATION UNIT

# FIG. 18

START

ACQUIRE FIRST CURRENT VALUE AND VOLTAGE VALUE ($V_{meas}$) — S201

DETERMINE DISCHARGE — S202 — N → CALCULATE UPPER LIMIT VOLTAGE — S203

Y

INTEGRATE DISCHARGE CURRENTS — S204

ACQUIRE SECOND CURRENT VALUE AND VOLTAGE VALUE — S205

DETERMINE CHARGE/DISCHARGE — S206

STOP

CURRENT VALUE =0 — S207

DISCHARGE

CHARGE

CALCULATE CAPACITY TURNOVER VALUE — S208

ESTIMATE LIFE — S209

END

# FIG. 19

```
        ┌─────────┐
        │  START  │
        └─────────┘
             │
             ▼
┌──────────────────────────┐
│   ACQUIRE PREVIOUS       │──── S2081
│ CAPACITY TURNOVER VALUE  │
└──────────────────────────┘
             │
             ▼
┌──────────────────────────┐
│   ACQUIRE INTEGRATED     │──── S2082
│ DISCHARGE CAPACITY VALUE │
└──────────────────────────┘
             │
             ▼
┌──────────────────────────┐
│   ACQUIRE RATED CAPACITY │──── S2083
└──────────────────────────┘
             │
             ▼
┌──────────────────────────┐
│ ACQUIRE UPPER LIMIT VOLTAGE │── S2084
└──────────────────────────┘
             │
             ▼
┌──────────────────────────┐
│       CALCULATE          │
│ UPPER-LIMIT-VOLTAGE-BASED│──── S2085
│  CORRECTION COEFFICIENT  │
└──────────────────────────┘
             │
             ▼
┌──────────────────────────┐
│    COMPUTE CAPACITY      │──── S2086
│    TURNOVER VALUE        │
└──────────────────────────┘
             │
             ▼
        ┌─────────┐
        │   END   │
        └─────────┘
```

# FIG. 20

# FIG. 21

# FIG. 22

# FIG. 23

FROM UPPER LIMIT SOC
CALCULATION UNIT

443

CAPACITY TURNOVER
VALUE CALCULATION UNIT

PREVIOUS CAPACITY TURNOVER
VALUE ACQUISITION UNIT — 443a

INTEGRATED DISCHARGE
CAPACITY ACQUISITION UNIT — 443b

RATED CAPACITY ACQUISITION UNIT — 443c

UPPER LIMIT SOC ACQUISITION UNIT — 443d

UPPER-LIMIT-SOC-BASED
CORRECTION COEFFICIENT
CALCULATION UNIT — 443e

FROM
RECORDING
UNIT

UPPER LIMIT VOLTAGE
ACQUISITION UNIT — 443f

UPPER-LIMIT-VOLTAGE-BASED
CORRECTION COEFFICIENT
CALCULATION UNIT — 443g

CAPACITY TURNOVER
VALUE COMPUTATION UNIT — 443h

TO LIFE ESTIMATION UNIT

# FIG. 24

```
                    ( START )
                        │
    ┌──────────────────▼──────────────────┐
    │                  │                   │
    │   ┌──────────────────────────────┐   │
    │   │ ACQUIRE FIRST CURRENT VALUE  │───┼── S401
    │   └──────────────┬───────────────┘   │
    │                  │            S402    │
    │               ◇──▼──◇          N      │
    │         ◇ DETERMINE DISCHARGE ◇───────┘
    │               ◇─────◇
    │                  │ Y
    │                  │
    │   ┌──────────────▼───────────────┐
    │   │  INTEGRATE DISCHARGE CURRENTS │──── S403
    │   └──────────────┬───────────────┘
    │                  │
    │   ┌──────────────▼───────────────┐
    │   │  ACQUIRE SECOND CURRENT VALUE │──── S404
    │   └──────────────┬───────────────┘
    │                  │           S405
    │               ◇──▼──◇         Y
    │         ◇ DETERMINE DISCHARGE ◇───────┐
    │               ◇─────◇                 │
    │                  │ N                  │
    │   ┌──────────────▼────────────────────┐
    │   │ STOP DISCHARGE CURRENT INTEGRATION │── S406
    │   └──────────────┬────────────────────┘
    │                  │
    │   ┌──────────────▼───────────────┐
    │   │  ACQUIRE THIRD CURRENT VALUE  │──── S407
    │   └──────────────┬───────────────┘
    │                  │         S408
    │  DISCHARGE    ◇──▼──◇        STOP
    └─────◇ DETERMINE CHARGE/DISCHARGE ◇──────┘
                   ◇─────◇
                      │ CHARGE
    ┌─────────────────▼──────────────┐
    │  ACQUIRE CURRENT VALUE         │──── S409
    │  AND VOLTAGE VALUE (Vmeas)     │
    └─────────────────┬──────────────┘
                      │         S410                S411
                   ◇──▼──◇       Y      ┌──────────────────┐
             ◇ DETERMINE CHARGE ◇───────│ CALCULATE UPPER  │
                   ◇─────◇              │  LIMIT VOLTAGE   │
                      │ N               └──────────────────┘
    ┌─────────────────▼──────────────┐
    │  CALCULATE UPPER LIMIT SOC     │──── S412
    └─────────────────┬──────────────┘
    ┌─────────────────▼──────────────┐
    │ CALCULATE CAPACITY TURNOVER VALUE│── S413
    └─────────────────┬──────────────┘
    ┌─────────────────▼──────────────┐
    │       ESTIMATE LIFE            │──── S414
    └─────────────────┬──────────────┘
                      │
                  (  END  )
```

# FIG. 25

```
        START

ACQUIRE PREVIOUS
CAPACITY TURNOVER VALUE          S4131

ACQUIRE INTEGRATED
DISCHARGE CAPACITY VALUE         S4132

ACQUIRE RATED CAPACITY           S4133

ACQUIRE UPPER LIMIT SOC          S4134

CALCULATE UPPER-LIMIT-SOC-BASED
CORRECTION COEFFICIENT           S4135

ACQUIRE UPPER LIMIT VOLTAGE      S4136

CALCULATE UPPER-LIMIT-VOLTAGE-BASED
CORRECTION COEFFICIENT           S4137

COMPUTE CAPACITY TURNOVER VALUE  S4138

         END
```

# FIG. 26

**BMU**

1

13

**STATE DETERMINATION UNIT**

12

**RECORDING UNIT**

**FIRST CURRENT VALUE ACQUISITION UNIT** — 531

**DISCHARGE DETERMINATION UNIT** — 532

**DISCHARGE CURRENT INTEGRATION UNIT** — 533

**SECOND CURRENT VALUE ACQUISITION UNIT** — 534

**DISCHARGE DETERMINATION UNIT** — 535

**DISCHARGE CURRENT INTEGRATION STOP UNIT** — 536

**THIRD CURRENT VALUE ACQUISITION UNIT** — 537

**CHARGE/DISCHARGE DETERMINATION UNIT** — 538

**FOURTH CURRENT VALUE ACQUISITION UNIT** — 539

**CHARGE DETERMINATION UNIT** — 540

**UPPER LIMIT SOC CALCULATION UNIT** — 541

**CAPACITY TURNOVER VALUE CALCULATION UNIT** — 542

**LIFE ESTIMATION UNIT** — 543

EP 4 474 841 A1

# FIG. 27

FROM UPPER LIMIT SOC
CALCULATION UNIT

542

CAPACITY TURNOVER
VALUE CALCULATION UNIT

| PREVIOUS CAPACITY TURNOVER VALUE ACQUISITION UNIT | 542a |

| INTEGRATED DISCHARGE CAPACITY ACQUISITION UNIT | 542b |

| RATED CAPACITY ACQUISITION UNIT | 542c |

| UPPER LIMIT SOC ACQUISITION UNIT | 542d |

| UPPER–LIMIT–SOC–BASED CORRECTION COEFFICIENT CALCULATION UNIT | 542e |

| CAPACITY TURNOVER VALUE COMPUTATION UNIT | 542f |

FROM
RECORDING
UNIT

TO LIFE ESTIMATION UNIT

FIG. 28

START

↓

ACQUIRE FIRST CURRENT VALUE — S501

↓

S502
DETERMINE DISCHARGE — N

↓ Y

INTEGRATE DISCHARGE CURRENTS — S503

↓

ACQUIRE SECOND CURRENT VALUE — S504

↓

S505
DETERMINE DISCHARGE — Y

↓ N

STOP DISCHARGE CURRENT INTEGRATION — S506

↓

ACQUIRE THIRD CURRENT VALUE — S507

↓

S508
DISCHARGE — DETERMINE CHARGE/DISCHARGE — STOP

↓ CHARGE

ACQUIRE FOURTH CURRENT VALUE — S509

↓

S510
DETERMINE CHARGE — Y

↓ N

CALCULATE UPPER LIMIT SOC — S511

↓

CALCULATE CAPACITY TURNOVER VALUE — S512

↓

ESTIMATE LIFE — S513

↓

END

# FIG. 29

START

ACQUIRE PREVIOUS
CAPACITY TURNOVER VALUE ── S5121

ACQUIRE INTEGRATED
DISCHARGE CAPACITY VALUE ── S5122

ACQUIRE RATED CAPACITY ── S5123

ACQUIRE UPPER LIMIT SOC ── S5124

CALCULATE UPPER–LIMIT–SOC–BASED
CORRECTION COEFFICIENT ── S5125

COMPUTE CAPACITY TURNOVER VALUE ── S5126

END

# FIG. 30

# FIG. 31

FROM UPPER LIMIT VOLTAGE
CALCULATION UNIT

642

CAPACITY TURNOVER
VALUE CALCULATION UNIT

PREVIOUS CAPACITY TURNOVER
VALUE ACQUISITION UNIT — 642a

INTEGRATED DISCHARGE
CAPACITY ACQUISITION UNIT — 642b

RATED CAPACITY ACQUISITION UNIT — 642c

UPPER LIMIT VOLTAGE ACQUISITION UNIT — 642d

UPPER-LIMIT-VOLTAGE-BASED CORRECTION
COEFFICIENT CALCULATION UNIT — 642e

CAPACITY TURNOVER
VALUE COMPUTATION UNIT — 642f

FROM
RECORDING
UNIT

TO LIFE ESTIMATION UNIT

# FIG. 32

START

ACQUIRE FIRST CURRENT VALUE — S601

S602
DETERMINE DISCHARGE — N

Y

INTEGRATE DISCHARGE CURRENTS — S603

ACQUIRE SECOND CURRENT VALUE — S604

S605
DETERMINE DISCHARGE — Y

N

STOP DISCHARGE CURRENT INTEGRATION — S606

ACQUIRE THIRD CURRENT VALUE — S607

S608
DISCHARGE — DETERMINE CHARGE/DISCHARGE — STOP

CHARGE

ACQUIRE CURRENT VALUE AND VOLTAGE VALUE ($V_{meas}$) — S609

S610
DETERMINE CHARGE — Y — CALCULATE UPPER LIMIT VOLTAGE — S611

N

CALCULATE CAPACITY TURNOVER VALUE — S612

ESTIMATE LIFE — S613

END

# FIG. 33

START

ACQUIRE PREVIOUS
CAPACITY TURNOVER VALUE — S6121

ACQUIRE INTEGRATED
DISCHARGE CAPACITY VALUE — S6122

ACQUIRE RATED CAPACITY — S6123

ACQUIRE UPPER LIMIT VOLTAGE — S6124

CALCULATE
UPPER-LIMIT-VOLTAGE-BASED
CORRECTION COEFFICIENT — S6125

COMPUTE CAPACITY
TURNOVER VALUE — S6126

END

## FIG. 34

## FIG. 35

# FIG. 36

# FIG. 37

# FIG. 38

# FIG. 39

# FIG. 40

## INTERNATIONAL SEARCH REPORT

| International application No. |
| --- |
| **PCT/JP2023/002259** |

### A. CLASSIFICATION OF SUBJECT MATTER

*G01R 31/392*(2019.01)i; *G01R 31/379*(2019.01)i; *H01M 10/48*(2006.01)i; *H02J 7/00*(2006.01)i
FI: G01R31/392; G01R31/379; H01M10/48 P; H02J7/00 Y

According to International Patent Classification (IPC) or to both national classification and IPC

### B. FIELDS SEARCHED

Minimum documentation searched (classification system followed by classification symbols)

G01R31/36-31/396; H01M10/42-10/48; H02J7/00; B60R16/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2003-161768 A (NTT POWER & BUILDING FACILITIES INC) 06 June 2003 (2003-06-06)<br>    paragraphs [0035]-[0049], fig. 2-5 | 1-12 |
| A | JP 2008-74257 A (MAZDA MOTOR CORP.) 03 April 2008 (2008-04-03)<br>    entire text | 1-12 |
| A | JP 6430054 B1 (THE FURUKAWA BATTERY CO., LTD.) 28 November 2018 (2018-11-28)<br>    entire text | 1-12 |
| A | CN 103529399 A (HUNAN UNIVERSITY) 22 January 2014 (2014-01-22)<br>    paragraphs [0079]-[0090] | 1-12 |
| A | CN 112290637 A (ELECTRIC POWER RESEARCH INSTITUTE OF STATE GRID LIAONING ELECTRIC POWER SUPPLY CO., LTD.) 29 January 2021 (2021-01-29)<br>    entire text | 1-12 |

☑ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **08 March 2023** | **20 March 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2023/002259**

## C.　DOCUMENTS CONSIDERED TO BE RELEVANT

| Category* | Citation of document, with indication, where appropriate, of the relevant passages | Relevant to claim No. |
|---|---|---|
| A | 中島秀仁,本間徳則,緑川淳,赤阪有一,柴田智史,吉田英明,橋本健介,荻野由涼,手塚渉,三浦優,古川淳,LAM, L.T.,菅田純雄. ウルトラバッテリーの開発. 古河電工時報. February 2013, no. 131, pp. 21-27, ISSN: 1348-1789, Internet: <URL: https://www.furukawa.co.jp/jiho/fj131/fj131_04.pdf>, (NAKAJIMA, Hidehito, HONMA, Tokunori, MIDORIKAWA, Kiyoshi, AKASAKA, Yuichi, SHIBATA, Satoshi, YOSHIDA, Hideaki, HASHIMOTO, Kensuke, OGINO, Yusuke, TEZUKA, Wataru, MIURA, Masaru, FURUKAWA, Jun, LAM, L.T., SUGATA, Sumio. Development of UltraBattery. Furukawa Review.) "2.2.2. Experimental Results", fig. 4 | 1-12 |
| A | 野口博正,萬ケ原徹. 長寿命サイクルユース用制御弁式鉛蓄電池の開発. 第45回電池討論会講演要旨集. 27 November 2004, pp. 502, 503, (NOGUCHI, Hiromasa, MANGAHARA, Tohru. Development of Long-life VRLA Battery for Deep Cycle Use. Proceedings of the 45th Battery Symposium in Japan.) "1. Introduction" | 1-12 |
| P, A | WO 2022/030415 A1 (THE FURUKAWA ELECTRIC CO., LTD.) 10 February 2022 (2022-02-10) paragraph [0043] | 6, 12 |

Form PCT/ISA/210 (second sheet) (January 2015)

INTERNATIONAL SEARCH REPORT
Information on patent family members

International application No.

**PCT/JP2023/002259**

| Patent document cited in search report | | | Publication date (day/month/year) | Patent family member(s) | | | Publication date (day/month/year) |
|---|---|---|---|---|---|---|---|
| JP | 2003-161768 | A | 06 June 2003 | (Family: none) | | | |
| JP | 2008-74257 | A | 03 April 2008 | (Family: none) | | | |
| JP | 6430054 | B1 | 28 November 2018 | WO | 2019/225032 | A1 | |
| CN | 103529399 | A | 22 January 2014 | (Family: none) | | | |
| CN | 112290637 | A | 29 January 2021 | (Family: none) | | | |
| WO | 2022/030415 | A1 | 10 February 2022 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H2288074 A